(19) Europäisches Patentamt
European Patent Office
Office européen des brevets

(11) EP 3 346 504 B1

(12) **EUROPEAN PATENT SPECIFICATION**

(45) Date of publication and mention of the grant of the patent:
**26.07.2023 Bulletin 2023/30**

(21) Application number: **16841977.8**

(22) Date of filing: **01.09.2016**

(51) International Patent Classification (IPC):
***H10K 10/46*** *(2023.01)* ***H10K 85/10*** *(2023.01)*

(52) Cooperative Patent Classification (CPC):
**H10K 71/12; H01L 29/786; H10K 85/113; H10K 85/151;** H10K 10/471; H10K 10/484

(86) International application number:
**PCT/JP2016/075714**

(87) International publication number:
**WO 2017/038948 (09.03.2017 Gazette 2017/10)**

(54) **ORGANIC THIN-FILM TRANSISTOR MANUFACTURING METHOD, ORGANIC SEMICONDUCTOR COMPOSITION, ORGANIC SEMICONDUCTOR FILM, AND ORGANIC SEMICONDUCTOR FILM MANUFACTURING METHOD**

VERFAHREN ZUR HERSTELLUNG EINES ORGANISCHEN DÜNNSCHICHTTRANSISTORS, ORGANISCHE HALBLEITERZUSAMMENSETZUNG, ORGANISCHER HALBLEITERFILM UND VERFAHREN ZUR HERSTELLUNG EINES ORGANISCHEN HALBLEITERFILMS

PROCÉDÉ DE FABRICATION DE TRANSISTOR À FILM MINCE ORGANIQUE, COMPOSITION DE SEMI-CONDUCTEUR ORGANIQUE, FILM SEMI-CONDUCTEUR ORGANIQUE, ET PROCÉDÉ DE FABRICATION DE FILM SEMI-CONDUCTEUR ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **02.09.2015 JP 2015173266**
**16.03.2016 JP 2016052165**

(43) Date of publication of application:
**11.07.2018 Bulletin 2018/28**

(73) Proprietor: **FUJIFILM Corporation**
**Tokyo 106-8620 (JP)**

(72) Inventors:
- **YAMAMOTO, Yosuke**
  **Ashigara-kami-gun**
  **Kanagawa 258-8577 (JP)**
- **TAKIZAWA, Hiroo**
  **Ashigara-kami-gun**
  **Kanagawa 258-8577 (JP)**
- **SHIGENOI, Yuta**
  **Ashigara-kami-gun**
  **Kanagawa 258-8577 (JP)**
- **TAMAKUNI, Fumiko**
  **Ashigara-kami-gun**
  **Kanagawa 258-8577 (JP)**
- **GOTO, Takashi**
  **Ashigara-kami-gun**
  **Kanagawa 258-8577 (JP)**
- **WATANABE, Tetsuya**
  **Ashigara-kami-gun**
  **Kanagawa 258-8577 (JP)**

(74) Representative: **Hoffmann Eitle**
**Patent- und Rechtsanwälte PartmbB**
**Arabellastraße 30**
**81925 München (DE)**

(56) References cited:
**EP-A2- 2 034 537**
**WO-A1-2014/189114**
**WO-A1-2016/148169**
**JP-A- 2004 115 805**
**JP-A- 2007 335 840**
**JP-A- 2009 177 136**
**JP-A- 2012 164 806**
**JP-A- 2012 510 149**
**JP-A- 2013 199 590**
**JP-A- 2015 050 231**
**JP-A- 2015 167 164**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 346 504 B1

• BEN B. Y. HSU ET AL: "Split-Gate Organic Field Effect Transistors: Control Over Charge Injection and Transport", ADVANCED MATERIALS, vol. 22, no. 41, 2 November 2010 (2010-11-02), pages 4649-4653, XP055492895, DE ISSN: 0935-9648, DOI: 10.1002/adma.201001509

## Description

## BACKGROUND OF THE INVENTION

1. Field of the Invention

The present invention relates to a method of manufacturing an organic thin film transistor, an organic semiconductor composition, and a method of manufacturing an organic semiconductor film.

2. Description of the Related Art

Since light weight, low cost, and flexibility can be obtained, an organic thin film transistor (organic TFT) having an organic semiconductor film (organic semiconductor layer) is used in a device using a logic circuit such as a field effect transistor (FET), a radio frequency identifier (RFID: RF tag), and a memory used in a liquid crystal displays or an organic electro luminescence (EL) display.

As a compound for forming such an organic semiconductor film, it is known that a polymer (so-called a "D-A-type polymer") obtained by combining an electron donating (donor) unit and an electron accepting (acceptor) unit is useful.

As specific examples of the D-A-type polymer, JP-A-2014-237733 discloses a compound obtained by introducing an aryl group to a side chain of a repeating unit (see Example 14 of JP-A-2014-237733).

JP2012164806 discloses an organic TFT comprising a D-A-type semiconducting polymer and a gate insulating layer comprising a copolymer.

Ben B.Y. Hsu et al., Adv. Mater. 2010, 22, 4649, also discloses an organic TFT comprising a D-A-type semiconducting compound and a polypropylene-co-1-butene polymer dielectric.

## SUMMARY OF THE INVENTION

Recently, in view of improving the performance of the organic thin film transistor, further improvement of the carrier mobility and further reduction of threshold voltage of the organic thin film transistor are required.

In a case where the organic thin film transistor is manufactured, an organic semiconductor layer included in an organic thin film transistor is disposed at a high temperature, and thus it is required that the heat resistance of the organic thin film transistor is excellent. Here, the expression "the heat resistance of the organic thin film transistor is excellent" means that changes of the carrier mobility and the threshold voltage of the organic thin film transistor are small before and after the heating of the organic thin film transistor.

An object of the present invention is to provide a method of manufacturing an organic thin film transistor exhibiting high carrier mobility and a low threshold voltage and having excellent heat resistance, an organic semiconductor composition, an organic semiconductor film, and a method of manufacturing an organic semiconductor film.

As a result of intensive studies on the above problems, the present inventors have found that a desired effect can be obtained by using an organic thin film transistor having an organic semiconductor layer including an organic semiconductor compound of Formula (1) and a layer containing a resin (C) or an organic thin film transistor having an organic semiconductor layer including an organic semiconductor compound of Formula (1) and a resin (C), so as to conceive the present invention.

That is, the present invention provides a method of manufacturing an organic thin film transistor comprising, on a substrate:

1) a gate electrode;
2) an organic semiconductor layer containing an organic semiconductor compound which has a molecular weight of $\geq$ 2,000 and has a repeating unit of the formula -(D-A)- (1), wherein

    A is an electron acceptor unit including a partial structure having at least one of a sp2 nitrogen atom, a carbonyl group, or a thiocarbonyl group in a ring structure, and
    D is an electron donor unit including a divalent aromatic heterocyclic group having at least one of a N atom, an O atom, a S atom, or a Se atom in a ring structure or a divalent aromatic hydrocarbon group consisting of a fused ring structure having two or more rings, as a partial structure,

3) a gate insulating layer provided between the gate electrode and the organic semiconductor layer; and
4) a source electrode and a drain electrode which are provided to be in contact with the organic semiconductor layer and are linked to each other via the organic semiconductor layer,

wherein the organic semiconductor layer is in contact with a layer containing a resin (C) or further contains the resin (C), the resin (C) has at least one repeating unit of any of formulae (C-Ia) to (C-Id):

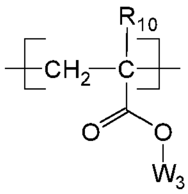
(C-Ia)

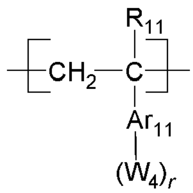
(C-Ib)

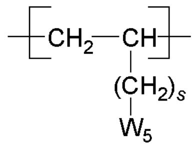
(C-Ic)

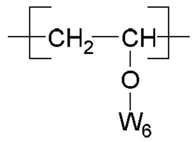
(C-Id)

wherein

| | |
|---|---|
| $R_{10}$, $R_{11}$ | each are H, F or alkyl, |
| $W_3$ | is an organic group having one or more selected from F, a Si-containing group, $C_{\geq 2}$-alkyl, cycloalkyl, aryl and aralkyl, |
| $W_4$ | is an organic group having one or more selected from F, a F-containing group, a Si-containing group, alkyl and cycloalkyl, |
| $W_5$, $W_6$ | each are an organic group having one or more selected from a F-containing group, a Si-containing group, alkyl, cycloalkyl, aryl and aralkyl, |
| $Ar_{11}$ | is a (r+1)-valent aromatic ring group, |
| r | is an integer of 1-10, and |
| s | is 0 or 1; |

the method comprises a step of applying a mixed solution containing the organic semiconductor compound and the resin (C).

Also, the present invention provides an organic semiconductor composition, comprising an organic semiconductor compound and a resin (C) as defined above.

Yet further, the present invention provides a method of manufacturing an organic semiconductor film of the above organic semiconductor composition, comprising a step of applying a mixture containing the organic semiconductor compound and the resin (C) on a gate insulating layer having a surface energy of 50-75 $mNm^{-1}$.

Preferred embodiments of the invention are as defined in the appended dependent claims and/or in the following detailed description.

As described above, according to the present invention, it is possible to provide an organic thin film transistor exhibiting high carrier mobility and a low threshold voltage and having excellent heat resistance, a method of manufacturing an organic thin film transistor, an organic semiconductor composition, an organic semiconductor film, and a method of manufacturing an organic semiconductor film.

## BRIEF DESCRIPTION OF THE DRAWINGS

Fig. 1A is a diagram schematically illustrating a bottom gate-bottom contact-type organic thin film transistor.

Fig. 1B is a diagram schematically illustrating a bottom gate-top contact-type organic thin film transistor.

Fig. 1C is a diagram schematically illustrating a top gate-bottom contact-type organic thin film transistor.

Fig. 1D is a diagram schematically illustrating a top gate-top contact-type organic thin film transistor.

Fig. 2E is a diagram schematically illustrating an example of a case where an organic semiconductor layer in an organic thin film transistor contains a specific organic

semiconductor compound and a resin (C).

Fig. 2F is a diagram schematically illustrating an example of a case where an organic semiconductor layer in an organic thin film transistor contains the specific organic semiconductor compound and the resin (C).

## DESCRIPTION OF THE PREFERRED EMBODIMENTS

Hereinafter, the present invention is described below. In the present specification, the following definitions apply.

The definition of the compound is used in the meaning of including salts thereof and ions thereof, in addition to the compound itself.

In a case where a plurality of e.g. substituents or linking groups (hereinafter, referred to as "substituents") represented by a specific reference numeral exist, or in a case where a plurality of substituents are defined at the same time, the respective substituents may be identical to or different from each other. The same is also applied to the definition of the number of substituents.

Unless described otherwise, in a case where a plurality of substituents are close to each other (particularly, adjacent to each other), this means that the substituents are linked to each other or fused to each other to form a ring.

In the present specification, substituents in which substitution and unsubstitution are not defined mean the substituents may further have a substituent without deteriorating the desired effect. The same is applied to a compound in which substitution and unsubstitution are not defined.

In the present specification, the numerical range expressed by using "to" means a range including numerical values described before and after "to" as a lower limit value and an upper limit value.

[Organic thin film transistor and manufacturing method thereof]

The organic thin film transistor is an organic thin film transistor having a gate electrode, an organic semiconductor layer containing an organic semiconductor compound, a gate insulating layer provided between the gate electrode and the organic semiconductor layer, and a source electrode and a drain electrode which are provided to be in contact with the organic semiconductor layer and are linked to each other via an organic semiconductor layer, on a substrate. The organic semiconductor layer is in contact with a layer containing a resin (C) or further contains the resin (C). The resin (C) has at least one repeating unit of any one of Formulae (C-Ia) to (C-Id), and the organic semiconductor compound has a molecular weight of ≥ 2,000 and a repeating unit of Formula (1).

The organic semiconductor layer including the organic semiconductor compound (hereinafter, simply referred to as a "specific organic semiconductor compound") which has a molecular weight of ≥ 2,000 and a repeating unit of Formula (1) is in contact with a layer containing the resin (C) or contains the resin (C), and thus it is possible to obtain an organic thin film transistor exhibiting high carrier mobility and a low threshold voltage and having excellent heat resistance.

Details of the reason have not been still clarified; the following reasons are assumed.

The specific organic semiconductor compound has a main chain skeleton formed of an electron donor unit and an electron acceptor unit, a so-called D-A-type polymer. The D-A-type polymer exhibits excellent alignment properties in a case of being crystallized, and thus the organic thin film transistor including the organic semiconductor layer formed by using this has a tendency of exhibiting high carrier mobility and low threshold voltage.

In a case where the D-A-type polymer is used, even in a case where there is a defect in the organic semiconductor layer obtained by heating this, the organic semiconductor layer is hardly influenced by the defect, compared with a low-molecule type organic semiconductor compound. The organic thin film transistor having an organic semiconductor layer including a D-A-type polymer can suppress decrease of the carrier mobility and a change of the threshold voltage before and after heating, and there is a tendency of exhibiting satisfactory heat resistance.

The present inventors have diligently conducted research so as to improve the performance of the organic thin film transistor and have found that, in a case where the resin (C) is used, the carrier mobility and the threshold voltage of the organic thin film transistor having an organic semiconductor layer including a specific organic semiconductor compound became more excellent. The present inventors have also found that, even after the heating test, the decrease of the carrier mobility and the change of the threshold voltage of the organic thin film transistor are further suppressed.

It is assumed that, this is because the resin (C) further improves alignment properties of the specific organic semiconductor compound.

Hereinafter, the organic thin film transistor (hereinafter, simply referred to as the "OTFT") is described.

The OTFT has a gate electrode, an organic semiconductor layer, a gate insulating layer provided between the gate electrode and the organic semiconductor layer, and a source electrode and a drain electrode which are provided to be in contact with the organic semiconductor layer and are linked to each other via an organic semiconductor layer, on a substrate. In a case where the voltage is applied to the gate electrode, a current flow path (channel) is formed at the interface between the organic semiconductor layer between the source electrode and the drain electrode and an adjacent layer. The current flowing between the source electrode and the drain electrode is controlled according to the input voltage applied to the gate electrode.

A preferable structure of the OTFT is described based on the drawings. The OTFT illustrated in the respective drawings are schematic views for easier understanding of the present invention, and sizes or relative size relationships

of respective members may be changed for the convenience of the descriptions, and drawings do not illustrate the actual relationships. Other than matters defined in the present invention, the present invention is not limited to appearances or shape illustrated in these drawings. For example, in Figs. 1A and 1B, the gate electrode does not have to cover the entire substrate, and a form in which the gate electrode covers a central portion of the substrate is also preferable as a form of the OTFT.

Each of Figs. 1A to 1D is a longitudinal sectional view schematically illustrating a representative preferable structure of the OTFT. In Figs. 1A to 1D, 1 denotes an organic semiconductor layer, 2 denotes a gate insulating layer, 3 denotes a source electrode, 4 denotes a drain electrode, 5 denotes a gate electrode, and 6 denotes a substrate.

Fig. 1A illustrates a bottom gate-bottom contact-type OTFT, Fig. 1B illustrates a bottom gate-top contact-type OTFT, Fig. 1C illustrates a top gate-bottom contact-type OTFT, and Fig. 1D illustrates a top gate-top contact-type OTFT.

The OTFT of the present invention includes all of the above four forms. Though not illustrated in the drawings, an overcoat layer may be formed on the uppermost portion of each drawing of the OTFT (on an opposite side to the substrate 6).

In the bottom gate structure, the gate electrode 5, the gate insulating layer 2 and the organic semiconductor layer 1 are arranged on the substrate 6, in this order. Meanwhile, in the top gate structure, the organic semiconductor layer 1, the gate insulating layer 2 and the gate electrode 5 are arranged on the substrate 6, in this order.

In the bottom contact structure, the source electrode 3 and the drain electrode 4 are arranged on the substrate 6 side (that is, the lower sides in Figs. 1A-1D) to the organic semiconductor layer 1. In the top contact structure, the source electrode 3 and the drain electrode 4 are arranged on the opposite side of the substrate 6 with respect to the organic semiconductor layer 1.

In the OTFT of the present invention, the organic semiconductor layer 1 is provided to be in contact with a layer (hereinafter, simply referred to as a "resin (C) layer") including the resin (C) (not illustrated) or further contains the resin (C).

In a case where the organic semiconductor layer 1 contains a specific organic semiconductor compound and the resin (C).

Figs. 2E and 2F are schematic views illustrating structures of the OTFT in a case where the organic semiconductor layer contains a specific organic semiconductor compound and the resin (C). In Figs. 2E and 2F, in the bottom gate-bottom contact-type OTFT which is the same as in Fig. 1A, the specific organic semiconductor compound and the resin (C) are included in the organic semiconductor layer 1.

In the examples of Figs. 2E and 2F, a case where the OTFT is a bottom gate-bottom contact type is illustrated, but the present invention is not limited thereto, and the OTFT may have any forms of a bottom gate-top contact type, a top gate-bottom contact type, and a top gate-top contact type.

In a case where the organic semiconductor layer contains a specific organic semiconductor compound and the resin (C), it is preferable that the specific organic semiconductor compound and the resin (C) are unevenly distributed to each other in the thickness direction of the organic semiconductor layer. As an example of this uneven distribution state, schematic enlarged views in circles of Figs. 2E and 2F can be referred to. Specifically, in the circles of Figs. 2E and 2F, schematic enlarged views of the organic semiconductor layer 1 schematically illustrating an unevenly distributed state of the specific organic semiconductor compound and the resin (C) are illustrated. In this case, the organic semiconductor layer 1 has an area 1A having a large content of the resin (C) and an area 1B having a high content of the specific organic semiconductor compound. Each of the area 1A and the area 1B may exist near the surface of at least of the organic semiconductor layer 1, and do not have to exist over the entire organic semiconductor layer 1. As illustrated with broken lines of Figs. 2E and 2F, an interface between the area 1A and the area 1B may not be clearly determined.

The OTFT of Fig. 2E and the OTFT of Fig. 2F have the same structure except that the lamination layer relationship of the area 1A and the area 1B is reversed.

Here, the expression "uneven distribution" refers to a state having a phase in which a component of any one of the specific organic semiconductor compound and the resin (C) is greater than an overall mass ratio, but the other component also exists.

In order to unevenly distribute the specific organic semiconductor compound and the resin (C), for example, a method to be performed by using a mixed solution (described below) containing a specific organic semiconductor compound and the resin (C) is used.

Subsequently, a case where the organic semiconductor layer 1 is provided to be in contact with the resin (C) layer including the resin (C) (not illustrated) is described.

In a case where the organic semiconductor layer 1 is provided to be in contact with the resin (C) layer, a state in which the specific organic semiconductor compound and the resin (C) are phase-separated is also included.

The expression "phase separation" means a state of having a phase in which any one of the specific organic semiconductor compound and the resin (C) singly exists.

Here, the uneven distribution and the phase separation have a different degree of the mass ratios of the components, and in a case where the degree of the uneven distribution becomes higher, the state becomes phase separation. A boundary thereof is not particularly clearly defined academically, but in a case where a phase in which

any one of the specific organic semiconductor compound and the resin (C) exist in a mass ratio of ≥ 99% is formed, it is determined that the case is determined as a "phase separation" state according to the present invention.

In order to cause the organic semiconductor layer and the resin (C) layer to be in a phase separated state, examples thereof include a method of separately forming respective layers, and a method of using a mixed solution containing the specific organic semiconductor compound and the resin (C), in the same manner as the uneven distribution.

In the organic semiconductor layer, whether the resin (C) is unevenly distributed or phase-separated can be checked by subjecting the organic semiconductor layer to element mapping measurement by time-of-flight secondary ion analysis (TOF-SIMS) together with the use of an etching ion beam.

The following surface energy is measured, whether the surface energy is closer to which one of the values of the specific organic semiconductor compound and the resin (C) is checked, so as to infer which one exists more on the surface of the organic semiconductor layer.

Since the resin (C) has a group ($W_3$ to $W_6$ in Formulae (C-Ia) to (C-Id)) having high hydrophobicity, it is considered that the surface energy decreases, as a result, compatibility with the specific organic semiconductor compound decreases, and the resin (C) is unevenly distributed or phase-separated from the specific organic semiconductor compound.

At this point, the resin (C) having a small surface energy is unevenly distributed or phase-separated in a coating layer, in a thickness direction, generally, on the surface (air) side, with respect to the specific organic semiconductor compound.

The surface energy can be obtained by a well-known method, by measuring a contact angle of a film consisting of the resin (C) in both water and an organic solvent (glycerin and diiodomethane are mainly used) and substituting the contact angle to the Owens's equation (the following refers to a case where glycerin (gly) is used in an organic solvent).

Owens's equation

$$1+\cos\theta_{H2O}=2(\gamma_S{}^d)^{1/2}(\gamma_{H2O}{}^d)^{1/2}/\gamma_{H2O,V}+2(\gamma_S{}^h)^{1/2}(\gamma_{H2O}{}^h)^{1/2}/\gamma_{H2O,V}$$

$$1+\cos\theta_{gly}=2(\gamma_S{}^d)^{1/2}(\gamma_{gly}{}^d)^{1/2}/\gamma_{gly,V}+2(\gamma_S{}^h)^{1/2}(\gamma_{gly}{}^h)^{1/2}/\gamma_{gly,V}$$

Here, in a case where the document measurement values of $\gamma_{H2O}{}^d$=21.8, $\gamma_{gly}{}^d$=37.0, $\gamma_{H2O}{}^h$=51.0, $\gamma_{gly}{}^h$=26.4, $\gamma_{H2O,V}$=72.8, and $\gamma_{gly,V}$=63.4 are substituted, and a measured value of the contact angle of water at $\theta_{H2O}$, a measured value of the contact angle of glycerin at $\theta_{gly}$ are substituted, a dispersion force component $\gamma_S{}^d$ and a polar component $\gamma_S{}^h$ of a surface energy are respectively obtained, and thus the sum thereof $\gamma_S{}^{Vh}=\gamma_S{}^d+\gamma_S{}^h$ can be obtained as a surface energy ($mNm^{-1}$).

Since it is easy to cause the resin (C) and the specific organic semiconductor compound to be unevenly distributed or to be phase-separated, the surface energy of the resin (C) is preferably ≤ 30 $mNm^{-1}$, more preferably 1-30 $mNm^{-1}$, even more preferably 5-27 $mNm^{-1}$, and particularly preferably 10-25 $mNm^{-1}$.

As the surface energy of the resin (C) is smaller, the uneven distribution or the phase separation with the specific organic semiconductor compound is quickly performed. Meanwhile, since the coatability of the coating liquid (mixed solution) for forming the organic semiconductor layer and the film properties of the formed organic semiconductor layer are excellent, the lower limit of the surface energy of the resin (C) is preferably the following value.

Since it is easy that the resin (C) is unevenly distributed or phase-separated from the specific organic semiconductor compound, or the carrier mobility of OTFT is improved, it is preferable to have at least one of a group having a fluorine atom or a group having a silicon atom. In the repeating unit of Formula (C-Ia) to (C-Id) included in the resin (C), at least one of $W_3$ to $W_6$ is preferably at least one of a group having a fluorine atom or a group having a silicon atom and more preferably a group having a fluorine atom.

In the organic semiconductor layer, a form in which the specific organic semiconductor compound and the resin (C) are unevenly distributed is not particularly limited, as long as the specific organic semiconductor compound and the resin (C) are unevenly distributed in a thickness direction of the organic semiconductor layer. Any one of the organic semiconductor compound or the resin (C) may be unevenly distributed in the thickness direction (depth direction, direction of the substrate 6) of the organic semiconductor layer.

As illustrated in Figs. 2E and 2F, it is preferable that, in the organic semiconductor layer, the specific organic semiconductor compound is unevenly distributed on the gate insulating layer side, and the resin (C) is unevenly distributed on an opposite side of the gate insulating layer. It is possible to secure a sufficient charge transfer channel on the interface between the gate insulating layer and the organic semiconductor layer, and high carrier mobility is exhibited.

In this case, it is more preferable that the specific organic semiconductor compound is unevenly distributed in a thickness direction of the organic semiconductor layer, and the resin (C) is unevenly distributed on a surface side.

At this point, the OTFT becomes a bottom gate structure in which an organic semiconductor layer is provided on the gate insulating layer.

In a case where the organic semiconductor layer and the resin (C) layer are manufactured by using the mixed solution containing the specific organic semiconductor compound and the resin (C), in a case where the specific organic semiconductor compound and the resin (C) are phase-separated, it is preferable that the organic semiconductor layer exists on the gate insulating layer side, and the resin (C) layer exists on an opposite side of the gate insulating layer, for the same reason.

In a case where the organic semiconductor layer and the resin (C) layer are manufactured by using a coating solution including a specific organic semiconductor compound and a coating solution including the resin (C), a form in which the resin (C) layer exist on the gate insulating layer side, and the organic semiconductor layer exists on an opposite side of the gate insulating layer is preferable.

The OTFT preferably has a bottom contact structure in which the source electrode and the drain electrode are provided to be in contact with the lower surface of the organic semiconductor layer. Accordingly, carriers are easily injected from the source electrode to the organic semiconductor layer, and the injected carriers easily flow to the drain electrode, so as to decrease the threshold voltage.

Particularly, in a case where the OTFT has a bottom gate-bottom contact structure (Figs. 1A, 2E, and 2F), a charge transfer channel is secured in the organic semiconductor layer, in a case where a surface of an area 1B in which the specific organic semiconductor compound is unevenly distributed can be protected by an area 1A in which the resin (C) is unevenly distributed, or a surface of the organic semiconductor layer is protected by the resin (C) layer, an effect of improving carrier mobility and a maintenance rate (durability) of the carrier mobility can be further increased. The effect of decreasing the threshold voltage is more excellent.

<Resin (C)>

The resin (C) has at least one repeating unit of any one of Formulae (C-Ia) to (C-Id). That is, the resin (C) may have only one kind of repeating unit of any one of Formulae (C-Ia) to (C-Id), and may have two or more kinds thereof.

In the present specification, the repeating units of Formulae (C-Ia) to (C-Id) are collectively referred to as a "repeating unit ($\alpha$)" in some cases.

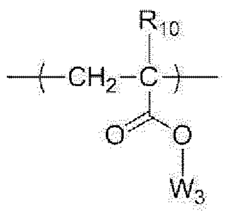
(C-Ia)

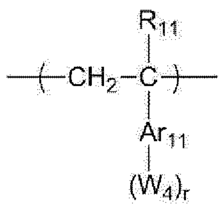
(C-Ib)

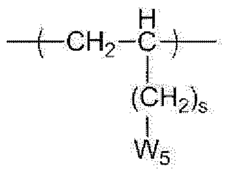
(C-Ic)

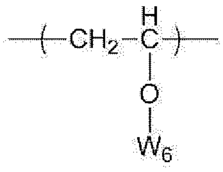
(C-Id)

In the formula, $R_{10}$ and $R_{11}$ each are H, F or alkyl.

The alkyl group is preferably linear or branched $C_{1-4}$-alkyl and may have a substituent. The alkyl group having a substituent is particularly fluorinated alkyl, preferably perfluoroalkyl. $R_{10}$ and $R_{11}$ are preferably H or methyl.

$W_3$ an organic group having one or more selected from F, a Si-containing group, $C_{\geq 2}$-alkyl, cycloalkyl, aryl and aralkyl.

$W_4$ is an organic group having one or more selected from F, a F-containing group, a Si-containing group, alkyl and cycloalkyl.

$W_5$ and $W_6$ each are an organic group having one or more selected from a F-containing group, a Si-containing group, alkyl, cycloalkyl, aryl and aralkyl.

$W_3$ to $W_6$ each may have a group -COO-. However, in this case, it is preferable that the number of groups is 1, in maximum.

$Ar_{11}$ is a (r+1)-valent aromatic ring group.

With respect to the (r+1)-valent aromatic ring group $Ar_{11}$, the divalent aromatic ring group in a case where r is 1 may have a substituent, and examples thereof include an $C_{6-18}$-arylene such as phenylene, tolylene, naphthylene, and anthracenylene.

Specific examples of the (r+1)-valent aromatic ring group in a case where r is an integer of $\geq 2$ suitably include groups obtained by removing (r-1) items of arbitrary hydrogen atoms from the above specific examples of the divalent aromatic ring group.

r is an integer of 1-10. s is 0 or 1.

The groups having fluorine atoms in $W_3$ to $W_6$ are not particularly limited, and examples thereof include alkyl, cycloalkyl and aryl, each having a fluorine atom. These groups may have a substituent in addition to the fluorine atom.

Examples of alkyl having a fluorine atom include linear or branched alkyl in which at least one H is substituted with F, and examples include an $C_{1-10}$-alkyl, preferably $C_{1-4}$-alkyl, having a fluorine atom.

Examples of cycloalkyl having a fluorine atom include monocyclic or polycyclic cycloalkyl in which at least one H is substituted with F.

Examples of aryl having a fluorine atom include aryl in which at least one H of an aryl group such as phenyl and naphthyl is substituted with F.

Examples of alkyl, cycloalkyl and aryl having a fluorine atom preferably include a group of Formulae (CF2) to (CF4), but the present invention is not limited thereto.

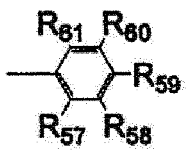
(CF2)

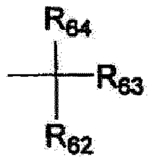
(CF3)

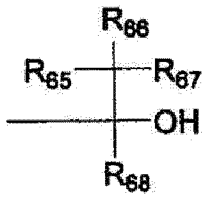
(CF4)

In Formulae (CF2) to (CF4), $R_{57}$ and $R_{68}$ each are H, F or alkyl (linear or branched). Here, at least one of $R_{57}$ to $R_{61}$, at least one of $R_{62}$ to $R_{64}$, and at least one of $R_{65}$ to $R_{68}$ is an alkyl (preferably having 1-4 carbon atoms) in which at least one H is substituted with F.

All of $R_{57}$ to $R_{61}$ and $R_{65}$ to $R_{67}$ are preferably F. $R_{62}$, $R_{63}$, $R_{64}$, and $R_{68}$ each are preferably F or alkyl (preferably having 1-4 carbon atoms) in which at least one H is substituted with F are more preferably F or $C_{1-4}$-perfluoroalkyl. $R_{62}$ and $R_{63}$ may be linked to each other to form a ring.

Specific examples of the group of Formula (CF2) include p-fluorophenyl, pentafluorophenyl, and 3,5-di(trifluoromethyl) phenyl.

Specific examples of the group of Formula (CF3) include trifluoromethyl, 1,1,1-trifluoroethyl, nonafluorobutyl ethyl, pentafluoropropyl, pentafluoroethyl, heptafluorobutyl, hexafluoroisopropyl, heptafluoroisopropyl, hexafluoro (2-methyl) isopropyl, nonafluorobutyl, octafluoroisobutyl, nonafluorohexyl, nonafluoro-t-butyl, perfluoroisopentyl, perfluorooctyl, perfluoro (trimethyl) hexyl, 2,2,3,3-tetrafluorocyclobutyl, and perfluorocyclohexyl. 1,1,1-trifluoroethyl, nonafluorobutyl ethyl, hexafluoroisopropyl, heptafluoroisopropyl, hexafluoro (2-methyl) isopropyl, octafluoroisobutyl, nonafluoro-t-butyl, and perfluoroisopentyl are preferable.

Specific examples of the group of Formula ($CF_4$) include $-C(CF_3)_2OH$, $-C(C_2F_5)_2OH$, $-C(CF_3)(CH_3)OH$, and $-CH(CF_3)OH$, and $-C(CF_3)_2OH$ is preferable.

Among Formulae (CF2), (CF3), and (CF4), Formulae (CF2) and (CF3) are preferable.

The group having a fluorine atom in $W_3$ to $W_6$ may be bonded to a repeating unit of Formulae (C-Ia) to (C-Id) via -COO-, $Ar_{11}$, $-CH_2-$, or -O-, and a group selected from alkylene, phenylene, ether, thioether, carbonyl, ester, amide, urethane and ureylene, or a group obtained by combining two or more kinds of these.

Examples of the group having a silicon atom in $W_3$ to $W_6$ include a group having at least one of an alkylsilyl structure (preferably a trialkylsilyl group) or a cyclic siloxane structure.

Examples of the group having at least one of an alkylsilyl structure or a cyclic siloxane structure preferably include a group of Formulae (CS-1) to (CS-3).

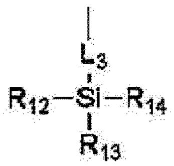

(CS-1)

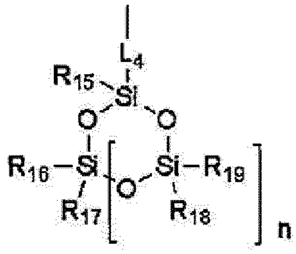

(CS-2)

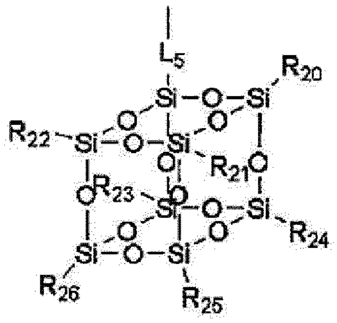

(CS-3)

In Formulae (CS-1) to (CS-3), $R_{12}$ to $R_{26}$ each are linear or branched alkyl (preferably having 1-20 carbon atoms) or cycloalkyl (preferably having 3-20 carbon atoms).

$L_3$ to $L_5$ are a single bond or a divalent linking group. Examples of the divalent linking group include a group or a bond including a single substance or a combination (a total number of carbon atoms preferably is ≤ 12) of two or more selected from alkylene, phenylene, ether, thioether, carbonyl, ester, amide, urethane and urea.

n is an integer of 1-5. n is preferably an integer of 2-4.

In view of improvement of the hydrophobicity of the resin (C), examples of the alkyl group having 2 or more carbon atoms in $W_3$ include linear or branched alkyl preferably having ≥ 6 carbon atoms, more preferably having 6-20 carbon atoms, and even more preferably having 6-15 carbon atoms, and may further have a substituent (here, not corresponding to a group having a fluorine atom and a group having a silicon atom).

In the same manner, in view of improvement of the hydrophobicity of the resin (C), examples of the alkyl group in $W_5$ and $W_6$ include linear or branched alkyl preferably having ≥ 6 carbon atoms, more preferably having 6-20 carbon atoms, and even more preferably having 6-15 carbon atoms, and may further have a substituent (here, not corresponding to a group having a fluorine atom and a group having a silicon atom).

Examples of the cycloalkyl group in $W_3$, $W_5$, and $W_6$ include cycloalkyl preferably having ≥ 5 carbon atoms, more preferably having 6-20 carbon atoms, and even more preferably having 6-15 carbon atoms, and may further have a substituent (here, not corresponding to a group having a fluorine atom and a group having a silicon atom).

The number of carbon atoms in an aryl group in $W_3$, $W_5$, and $W_6$ is preferably ≥ 6. In view of the improvement of the hydrophobicity of the resin (C), the number thereof is more preferably 9-20 and even more preferably 9-15. The aryl group is preferably the same as the aryl group exemplified as the aryl group having a fluorine atom. This aryloxycarbonyl group may further have a substituent (here, not corresponding to a group having a fluorine atom and a group having a silicon atom).

Examples of the aralkyl group in $W_3$, $W_5$, and $W_6$ include an aralkyl group preferably having ≥ 7 carbon atoms, more preferably having 7-20 carbon atoms, and even more preferably having 10-20 carbon atoms. The aralkyl group may further have a substituent (here, not corresponding to a group having a fluorine atom and a group having a silicon atom).

In view of further improving the hydrophobicity of the resin (C), the alkyl group in $W_4$ is a linear or branched alkyl group preferably having 3 or more carbon atoms, more preferably 3 to 15 carbon atoms, and even more preferably 3 to 10 carbon atoms.

The cycloalkyl group in $W_4$ is a linear or branched alkyl group preferably having ≥ 5 carbon atoms, more preferably 5-20 carbon atoms, and even more preferably 5-15 carbon atoms.

$W_3$, $W_5$ and $W_6$ are preferably an organic group having a fluorine atom, an organic group having a silicon atom, $C_{\geq 6}$-alkyl, $C_{\geq 5}$-cycloalkyl, $C_{\geq 6}$-aryl and $C_{\geq 7}$-aralkyl, more preferably an organic group having a fluorine atom, an organic group having a silicon atom, $C_{\geq 6}$-alkyl, $C_{\geq 6}$-cycloalkyl, an $C_{\geq 9}$-aryl or $C_{\geq 10}$-aralkyl, and even more preferably an organic group having a fluorine atom or an organic group having a silicon atom.

$W_4$ is preferably a fluorine atom, an organic group having a fluorine atom, an organic group having a silicon atom, $C_{\geq 3}$-alkyl or $C_{\geq 5}$-cycloalkyl, more preferably F, an organic group having a fluorine atom, an organic group having a silicon atom, $C_{\geq 3}$-alkyl or $C_{\geq 5}$-cycloalkyl, and even more preferably F, an organic group having a fluorine atom, or an organic group having a silicon atom.

Hereinafter, specific examples of the preferable repeating unit of any one of Formulae (C-Ia) to (C-Id) are provided.

In the specific examples, $X_1$ is H, $-CH_3$, -F, or $-CF_3$.

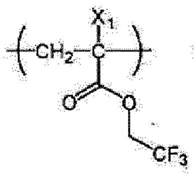 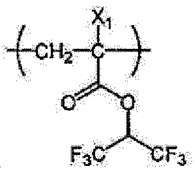 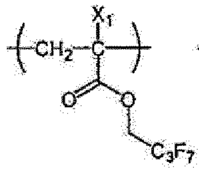 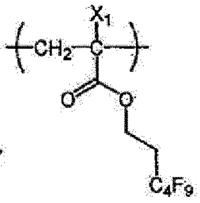 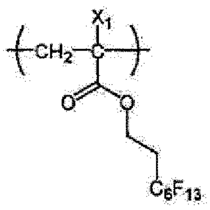

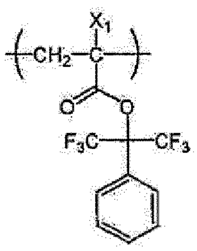 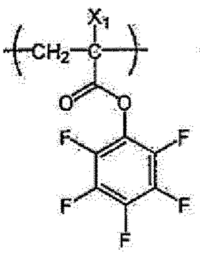 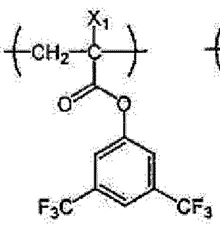 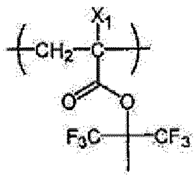 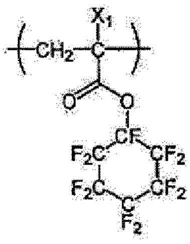

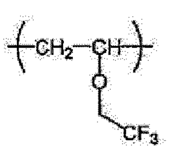 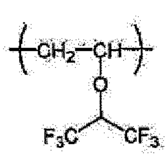 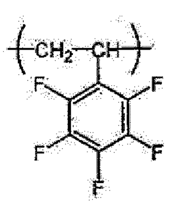 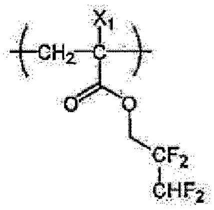

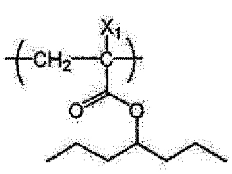 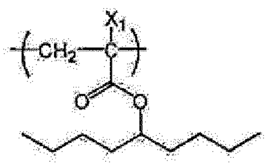 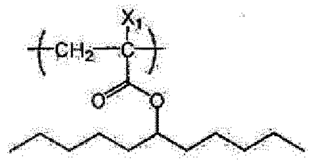

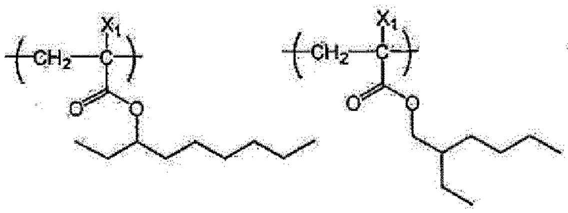 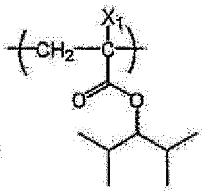 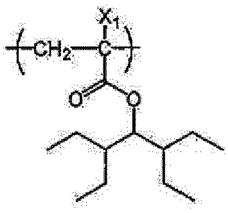

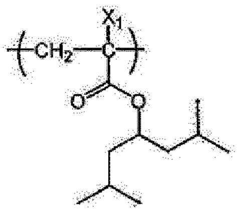 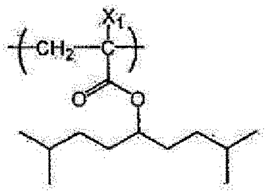 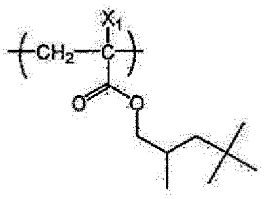

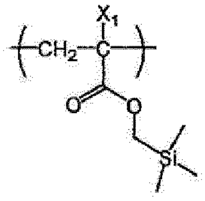 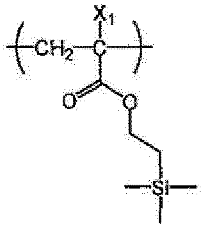 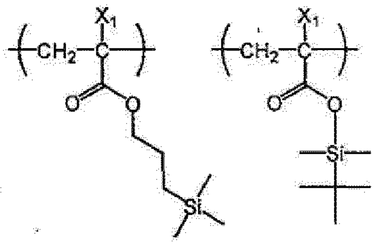 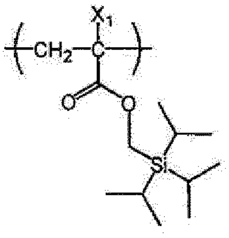

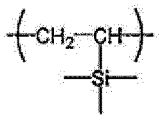 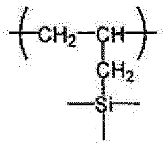 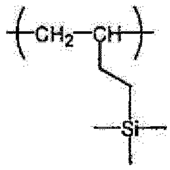 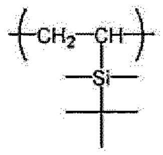 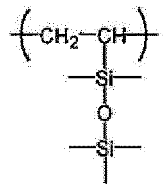

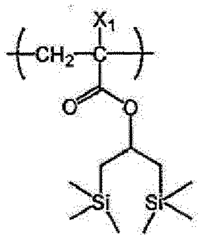 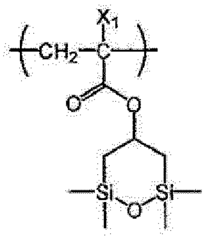 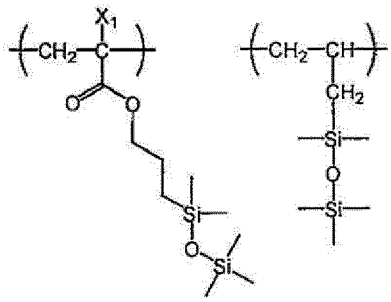 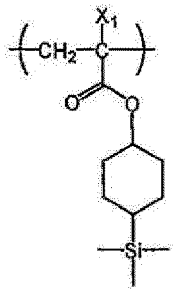

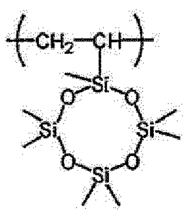 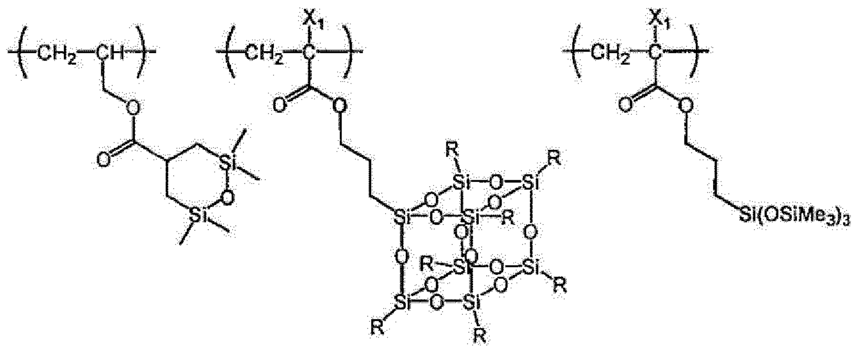

R=$CH_3$, $C_2H_5$, $C_3H_7$, $C_4H_9$

The content of the repeating unit (α) is preferably 5-100 mol%, more preferably 10-90 mol%, and even more preferably 10-80 mol%, with respect to the total repeating units of the resin (C).

The resin (C) preferably has an aromatic ring group and more preferably has a repeating unit having an aromatic ring group.

In this case, the repeating unit (α) may have an aromatic ring group, or the resin (C) further has a repeating unit in addition to the repeating unit (α) and this repeating unit has an aromatic ring group.

The repeating unit (α) in a case where the repeating unit (α) has an aromatic ring group preferably is a repeating unit of Formula (C-II).

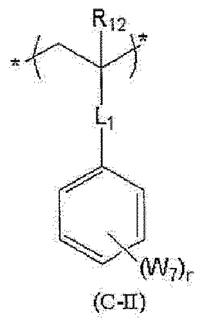

(C-II)

In the formula, $R_{12}$ is H, methyl, trifluoromethyl or F. $W_7$ represents an organic group having one or more selected from the group consisting of a group having a fluorine atom, a group having a silicon atom, an alkyl group, and a cycloalkyl group.

$L_1$ is a single bond or a $-COOL_2-$ group. $L_2$ is a single bond or alkylene.

r is an integer of 1-5.

The group having a fluorine atom and the group having a silicon atom in $W_7$ are respectively the same as those exemplified as the above group having a fluorine atom and the above group having a silicon atom.

The alkyl group and the cycloalkyl group in $W_7$ respectively are the same as those described with respect to the alkyl group and the cycloalkyl group in $W_4$.

$W_7$ are preferably trialkylsilyl, trialkoxysilyl, alkyl having a trialkylsilyl group, alkyl having a trialkoxysilyl group, $C_{\geq 3}$-alkyl and $C_{\geq 5}$-cycloalkyl.

In the trialkylsilyl, trialkoxysilyl, alkyl having a trialkylsilyl group, and alkyl having a trialkoxysilyl group, as $W_7$, the number of carbon atoms of an alkyl group bonded to a silicon atom or an alkoxy group is preferably 1-5 and more preferably 1-3.

In the alkyl having a trialkylsilyl group and the alkyl having a trialkoxysilyl group, as $W_7$, the number of carbon atoms of the alkyl group bonded to the trialkylsilyl group and the trialkoxysilyl group is preferably 1-5 and more preferably 1-3.

$R_{12}$ is preferably H or methyl.

The alkylene group as $L_2$ is preferably $C_{1-5}$-alkylene and is more preferably $C_{1-3}$-alkylene. $L_2$ is preferably a single bond.

$W_7$ is preferably an organic group having a fluorine atom, an organic group having a silicon atom, $C_{\geq 3}$-alkyl, or $C_{\geq 5}$-cycloalkyl, more preferably $C_{\geq 3}$-alkyl, and even more preferably t-butyl.

In addition to the above, specific examples of the repeating unit of Formula (C-II) described below are provided.

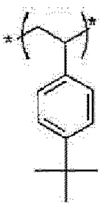
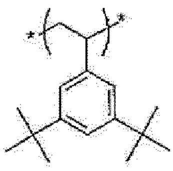
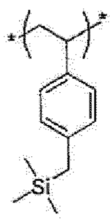
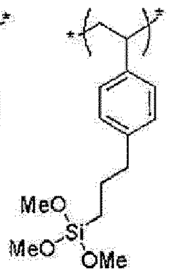
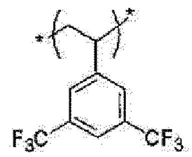

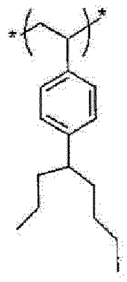
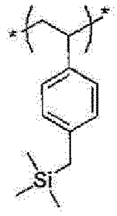
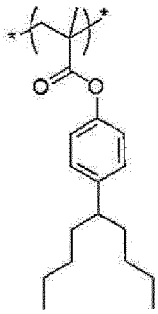
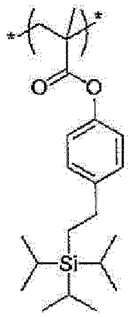
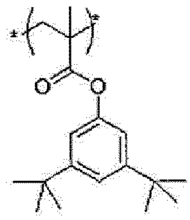
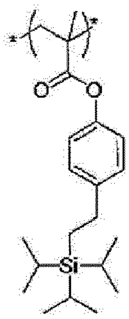

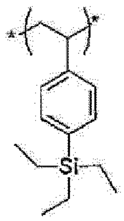
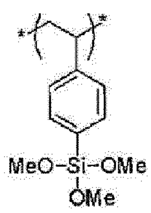
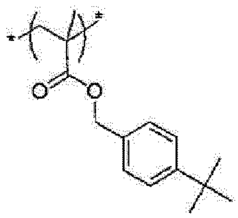
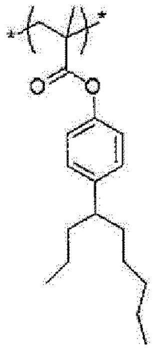
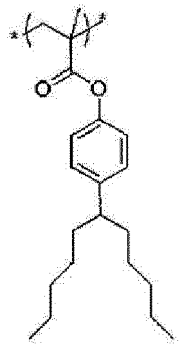

In a case where the resin (C) has a repeating unit of Formula (C-II), the content is preferably 1-100 mol%, more preferably 3-80 mol%, and even more preferably 5-75 mol%, with respect to the total repeating units of the resin (C) of the repeating unit of Formula (C-II).

In addition to the above, as the repeating unit having an aromatic ring group, the repeating unit of Formula (II) is preferable.

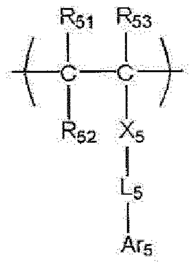
(II)

In the formula, $R_{51}$, $R_{52}$, and $R_{53}$ are H, alkyl, cycloalkyl, halogen, cyano or alkoxycarbonyl. Here, $R_{52}$ may be bonded to $Ar_5$, to form a ring. In this case, $R_{52}$ is a single bond or an alkylene group.

$X_5$ is a single bond, -COO-, or -CONR$_{64}$-, and $R_{64}$ is H or alkyl.

$L_5$ is a single bond or alkylene.

$Ar_5$ is a monovalent aromatic ring group, and in a case where $Ar_5$ is bonded to $R_{52}$ to form a ring, $Ar_5$ is a divalent aromatic ring group.

The alkyl group included in the alkyl and the alkoxycarbonyl of $R_{51}$, $R_{52}$, and $R_{53}$ is preferably methyl, ethyl, propyl, isopropyl, n-butyl, sec-butyl, hexyl, 2-ethylhexyl, octyl or dodecyl which may have a substituent and $C_{\leq 20}$-alkyl, more preferably $C_{\leq 80}$-alkyl, and even more preferably $C_{\leq 3}$-alkyl.

The cycloalkyl group of $R_{51}$, $R_{52}$, and $R_{53}$ may have a monocyclic shape or a polycyclic shape. Preferable examples thereof include monocyclic $C_{3-10}$-cycloalkyl such as cyclopropyl, cyclopentyl, and cyclohexyl which may have a substituent.

Examples of the halogen atom of $R_{51}$, $R_{52}$, and $R_{53}$ include F, Cl, Br and I, and F is preferable.

The monovalent aromatic ring group $Ar_5$ may have a substituent, and preferable examples thereof include $C_{6-18}$-arylene such as phenyl, tolyl, naphthyl, and anthracenyl, or an aromatic ring group containing a hetero ring such as thiophene, furan, pyrrole, benzothiophene, benzofuran, benzopyrrole, triazine, imidazole, benzimidazole, triazole, thiadiazole, and thiazole. Among these, phenyl, naphthyl, and biphenyl are particularly preferable. Specific examples of the divalent aromatic ring group suitably include groups obtained by removing one item of arbitrary hydrogen atoms from the above specific examples of the monovalent aromatic ring group.

Examples of the substituent included in the alkyl, cycloalkyl, alkoxycarbonyl, alkylene and the monovalent aromatic ring group include alkyl, alkoxy such as methoxy, ethoxy, hydroxyethoxy, propoxy, hydroxypropoxy, and butoxy, and aryl such as phenyl, exemplified as $R_{51}$.

Examples of the alkyl group of $R_{64}$ in -CONR$_{64}$- ($R_{64}$ H or alkyl) exemplified as $X_5$ include those which are the same as the alkyl group of $R_{51}$ to $R_{53}$. $X_5$ is preferably a single bond, -COO-, and -CONH- and more preferably a single bond and -COO-.

The alkylene group in $L_5$ is preferably Ci-s-alkylene such as methylene, ethylene, propylene, butylene, hexylene, and octylene, which may have a substituent.

Hereinafter, specific examples of the preferable repeating unit of Formula (II) are provided.

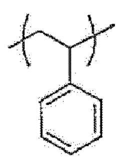
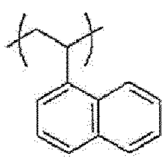
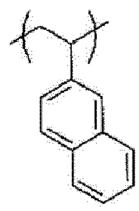

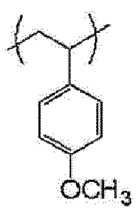
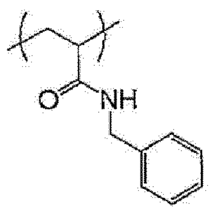
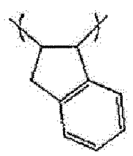
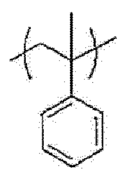

The resin (C) may or may not contain the repeating unit of Formula (II). In a case where the resin (C) has a repeating unit of Formula (II), the content is preferably 1-80 mol%, more preferably 1-70 mol%, and even more preferably 1-50 mol%, with respect to the total repeating units of the resin (C) of the repeating unit of Formula (II).

(Repeating unit (β) or (γ))

The resin (C) may contain at least one of a repeating component (hereinafter, referred to as a "repeating unit (β)") including a group including at least one of F or Si and at least one lactone ring and at least one repeating unit (hereinafter, referred to as a "repeating unit (γ)") derived from a monomer of Formula (aa1-1).

(Repeating unit (β))

The lactone ring structure included in the repeating unit (β) is more preferably a group having a lactone structure of any one of Formulae (LC1-1) to (LC1-17). A group having a lactone structure may be directed bonded to a main chain. The preferable lactone structure is (LC1-1), (LC1-4), (LC1-5), (LC1-6), (LC1-13), (LC1-14), and (LC1-17).

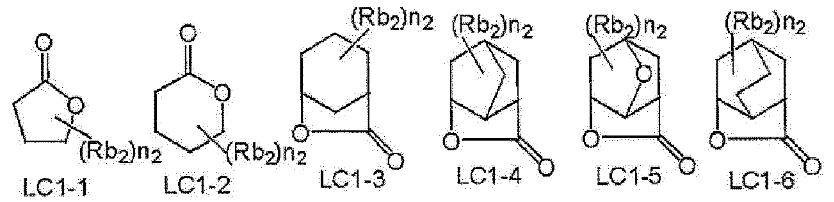

LC1-1 LC1-2 LC1-3 LC1-4 LC1-5 LC1-6

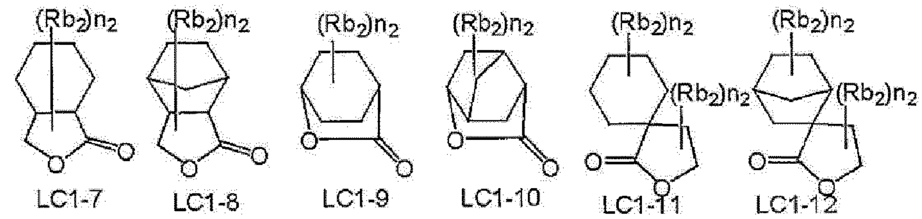

LC1-7 LC1-8 LC1-9 LC1-10 LC1-11 LC1-12

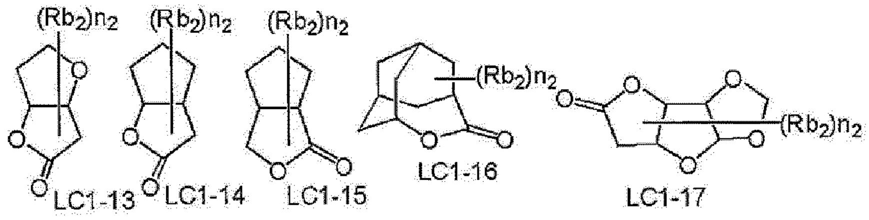

LC1-13 LC1-14 LC1-15 LC1-16 LC1-17

A lactone structure portion may have or may not have a substituent $Rb_2$. Preferable examples of the substituent $Rb_2$ include $C_{1-8}$-alkyl, monovalent $C_{4-7}$-cycloalkyl, $C_{1-8}$-alkoxy, $C_{2-8}$-alkoxycarbonyl, $C_{6-13}$-aryloxycarbonyl, carboxyl, halogen, hydroxyl and cyano. The substituent $Rb_2$ is more preferably $C_{1-4}$-alkyl, cyano, $C_{2-8}$-alkoxycarbonyl or $C_{7-13}$-aryloxycarbonyl, even more preferably cyano, $C_{1-4}$-alkyl in which at least one H is substituted with F or Si, $C_{2-8}$-alkoxycarbonyl or $C_{7-13}$-aryloxycarbonyl, and particularly preferably cyano, $C_{1-4}$-alkyl in which at least H is substituted with F, $C_{2-8}$-alkoxycarbonyl or $C_{7-13}$-aryloxycarbonyl.

$n_2$ represents an integer of 0-4. In a case where $n_2$ is ≥ 2, the plurality of substituents ($Rb_2$) may be identical to or different from each other, or the plurality of substituents ($Rb_2$) are bonded to each other to form a ring.

In the repeating unit having a lactone group, an optical isomer generally exists, but any optical isomers may be used. Even in a case where one kind of optical isomer is used singly, a plurality of optical isomers may be mixed with each other. In a case where one kind of optical isomer is mainly used, this optical purity (ee) is preferably ≥ 90% and more preferably ≥ 95%.

The repeating unit (β) is not particularly limited, as long as it is polymerized by e.g. addition polymerization, condensation polymerization or addition condensation. However, it is preferable that the repeating unit (β) has a carbon-carbon double bond and is polymerized by addition polymerization. Examples thereof include an acrylate-based repeating unit (including those having a substituent at an α position or a β position), a styrene-based repeating unit (including

those having a substituent at an α position or β position), a vinyl ether-based repeating unit, a norbornene-based repeating unit, and a repeating unit of a maleic acid derivative (a maleic anhydride or a maleimide derivative thereof). The repeating unit (β) is preferably an acrylate-based repeating unit, a styrene-based repeating unit, a vinyl ether-based repeating unit, and a norbornene-based repeating unit, preferably an acrylate-based repeating unit, a vinyl ether-based repeating unit, and a norbornene-based repeating unit, and particularly preferably an acrylate-based repeating unit.

Hereinafter, specific examples of the repeating unit (β) are provided below.. Ra is H, F, methyl or trifluoromethyl.

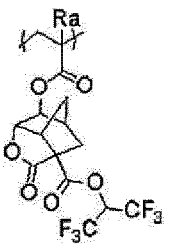
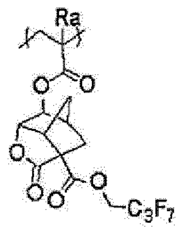
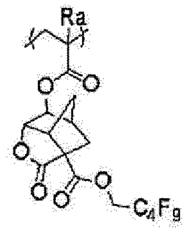
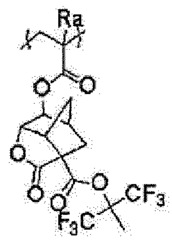
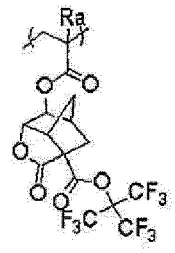

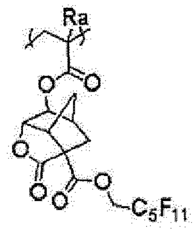
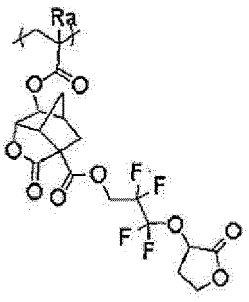
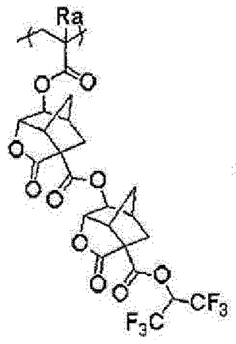
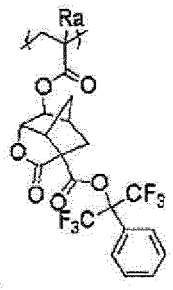
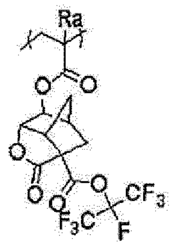

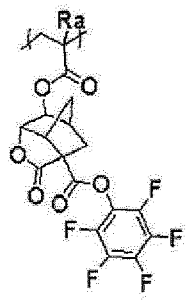
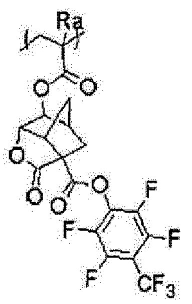
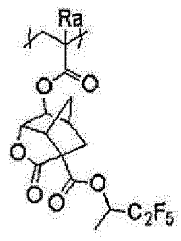
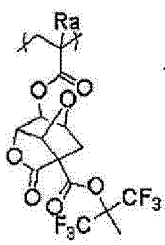
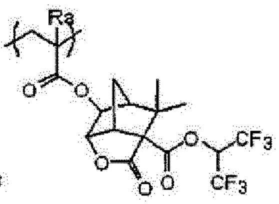

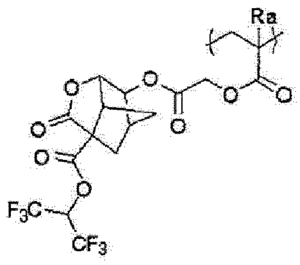
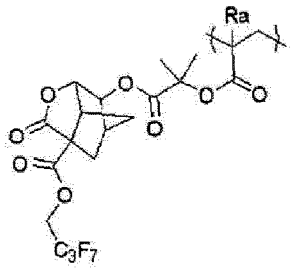

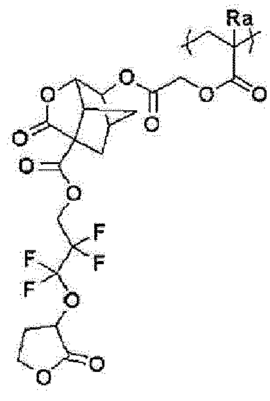

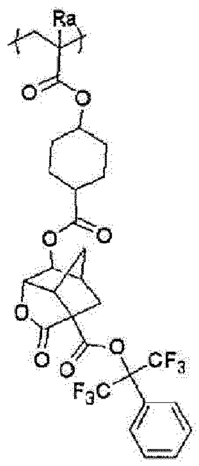

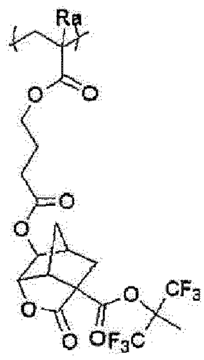

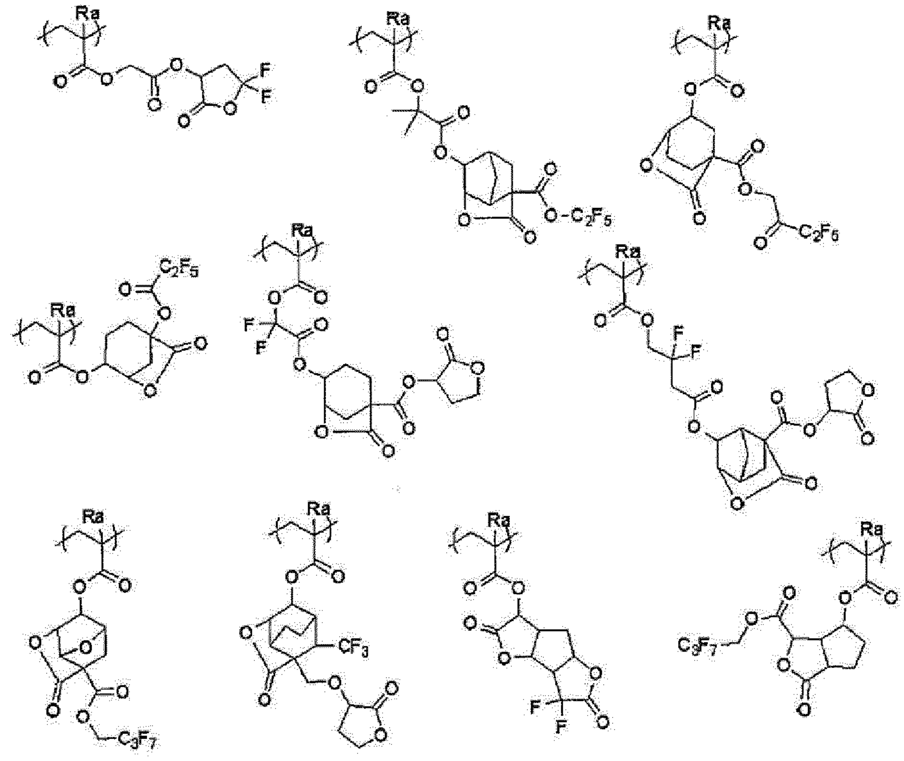

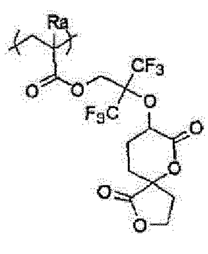

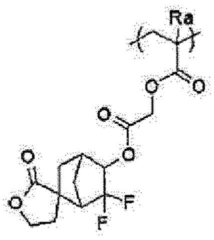

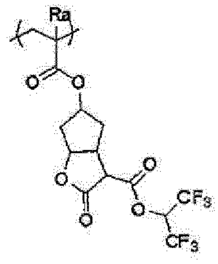

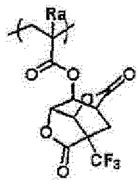 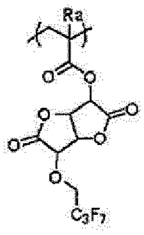 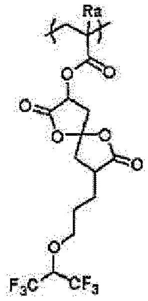

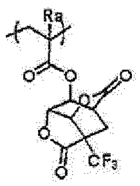 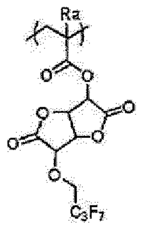 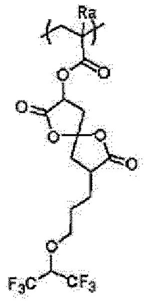

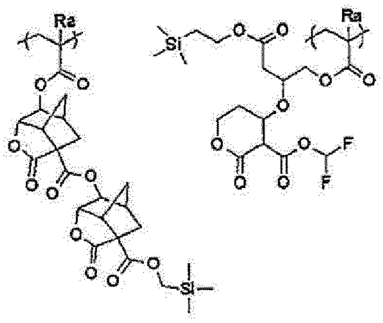 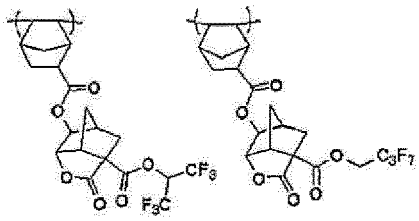

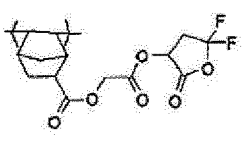 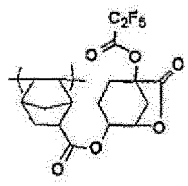

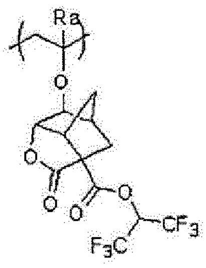 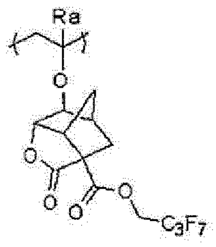 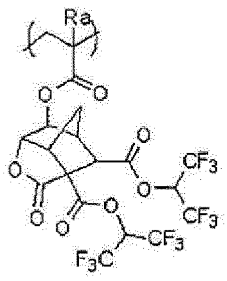 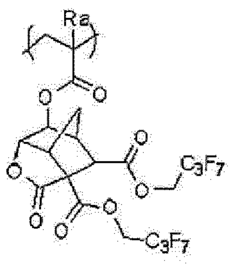

In a case where the resin (C) contains the repeating unit (β), the content of the repeating unit (β) is preferably 10-90 mol% and more preferably 20-85 mol% with respect to total repeating units of the resin (C).

(Repeating unit (γ))

Subsequently, the repeating unit (γ) derived from a monomer of Formula (aa1-1) is described.

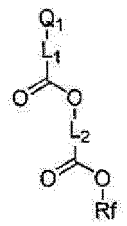

(aa1-1)

In the formula, an organic group including a polymerizable group $Q_1$ is not particularly limited, as long as the organic group is a group including a polymerizable group. Examples of the polymerizable group include an acrylic group, a methacrylic group, a styryl group, a norbornenyl group, a maleimide group, and a vinyl ether group, and an acrylic group, a methacrylic group, and a styryl group are preferable.

Examples of the divalent linking group $L_1$ and $L_2$ include arylene, alkylene and cycloalkylene, each optionally substituted, and an ether bond (-O-), carbonyl (-CO-), and a divalent linking group combining a plurality of these groups.

As the arylene group, for example, $C_{6-14}$-arylene is preferable. Specific examples thereof include phenylene, naphthylene, anthrylene, phenanthrylene, biphenylene, and terphenylene.

As alkylene and cycloalkylene grou, for example, $C_{1-15}$-alkylene group and $C_{1-15}$-cycloalkylene are preferable. Specific examples thereof include those obtained by removing one H from the following linear, branched, or cyclic alkyl group. Examples of the alkyl group before one H is removed include methyl, ethyl, n-propyl, isopropyl, n-butyl, sec-butyl, tert-butyl, tert-amyl, n-pentyl, n-hexyl, n-heptyl, n-octyl, n-nonyl, and n-decyl. Examples of the cycloalkylene group before one hydrogen atom is removed include cyclopentyl, cyclohexyl, cyclopentylmethyl, cyclopentylethyl, cyclopentyl butyl, cyclohexylmethyl, cyclohexylethyl, cyclohexylbutyl, and adamantyl.

Examples of the substituent that may be included in the arylene, alkylene and cycloalkylene group include alkyl, aralkyl, alkoxy and F.

In one form of the present invention, $L_1$ is preferably a single bond, phenylene, ether, carbonyl and carbonyloxy, and $L_2$ is more preferably alkylene, ether, carbonyl and carbonyloxy.

The organic group in an organic group having a fluorine atom as Rf is preferably a group including at least one carbon atom, and is an organic group including a carbon-hydrogen bonding portion. For example, Rf is alkyl substituted with F and cycloalkyl substituted with F. These alkyl groups and cycloalkyl groups are the same as the alkyl groups and the cycloalkyl groups before one H is removed, described as $L_1$ and $L_2$.

In one form, the repeating unit (γ) is preferably a repeating unit of Formula (aa1-2-1) or (aa1-3-1).

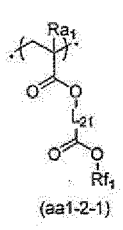

(aa1-2-1)

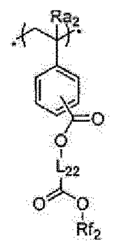

(aa1-3-1)

In Formulae (aal-2-1) and (aal-3-1), Rai and $Ra_2$ is H or alkyl. Rai and $Ra_2$ are preferably H or methyl.

$L_{21}$ and $L_{22}$ each represent a single bond or a divalent linking group, and are the same as $L_2$ in Formula (aa1-1).

$Rf_1$ and $Rf_2$ each represent an organic group having a fluorine atom, and are the same as Rf in Formula (aa1-1).

In one form, the repeating unit (γ) is preferably a repeating unit of Formula (aa1-2-2) or (aa1-3-2).

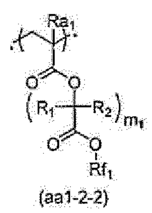

(aa1-2-2)

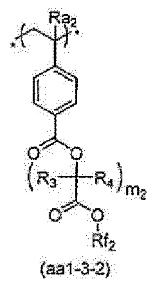

(aa1-3-2)

In Formulae (aal-2-2) and (aal-3-2), Rai and $Ra_2$ are H or alkyl.

$R_1$, $R_2$, $R_3$, and $R_4$ each are H or alkyl.
$m_1$ and $m_2$ each are an integer of 0- 5.
$Rf_1$ and $Rf_2$ each are an organic group having a fluorine atom.

Rai and $Ra_2$ are preferably H or methyl.
As the alkyl group $R_1$, $R_2$, $R_3$, and $R_4$, for example, linear or branched chain $C_{1-10}$-alkyl is preferable. This alkyl group may have a substituent, and examples of the substituent include alkoxy, aryl and halogen.
$m_1$ and $m_2$ each are preferably an integer of 0-3, more preferably 0 or 1, and particularly preferably 1.
The organic group having a fluorine atom as $Rf_1$ and $Rf_2$ is the same as Rf in Formula (aa1-1).
In one form, the repeating unit (γ) is preferably a repeating unit of Formula (aa1-2-3) or (aa1-3-3).

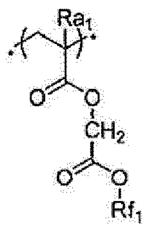
(aa1-2-3)

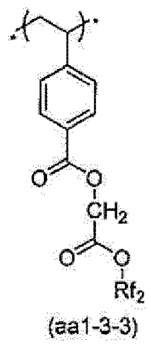
(aa1-3-3)

In Formulae (aal-2-3) and (aal-3-3), Rai is H or methyl.
$Rf_1$ and $Rf_2$ each represent an organic group having a fluorine atom, and are the same as Rf in Formula (aa1-1).
Hereinafter, specific examples of the repeating unit (γ) are provided below.

Ra' = H, $CH_3$

Rf' = $CH_2CF_3$, $CH_2C_2F_5$, $CH_2C_3F_7$, $CH_2C_4F_9$, $CH(CF_3)_2$, $CH_2CF_2CHF_2$, $CH_2(CF_2)_3CHF_2$,

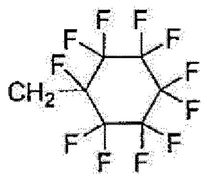 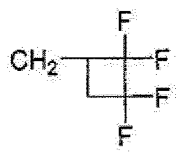

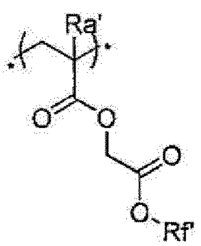 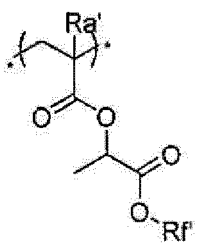 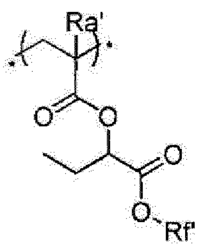 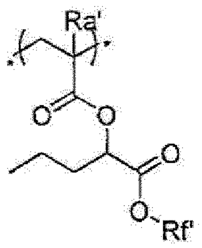

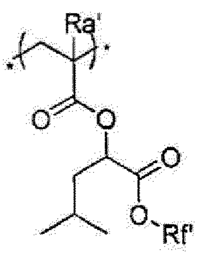 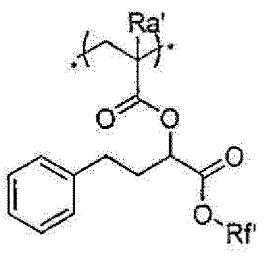 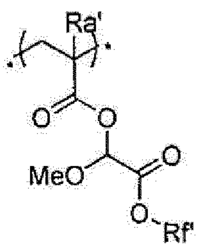 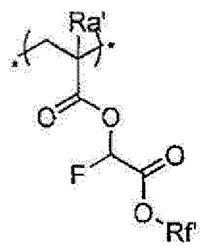

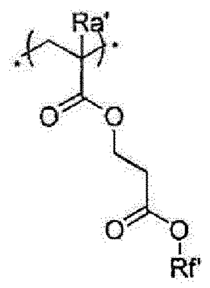
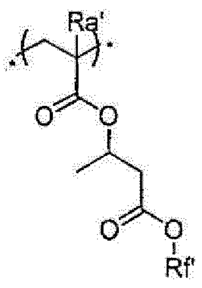
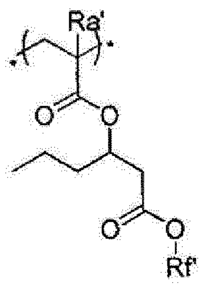
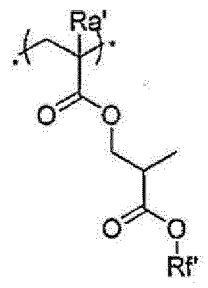

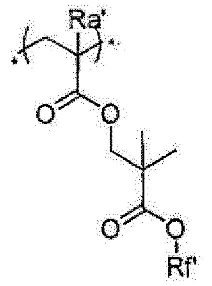
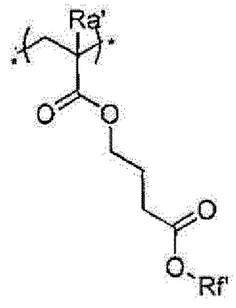
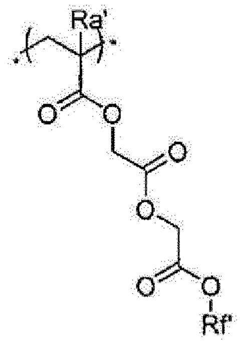
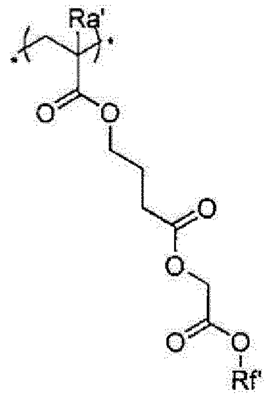

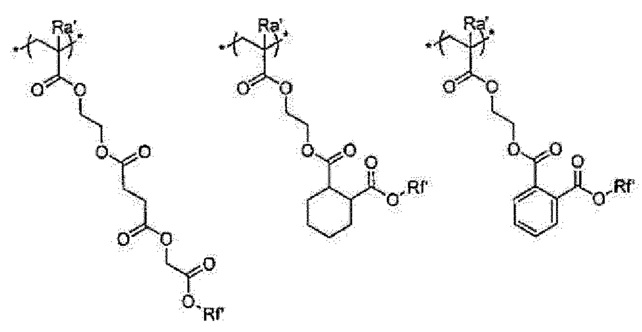

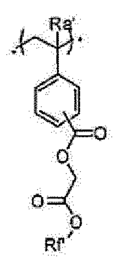
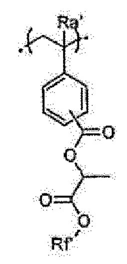
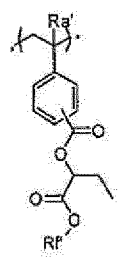
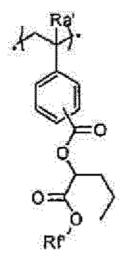
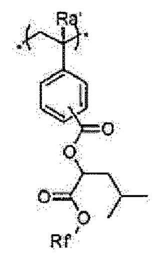

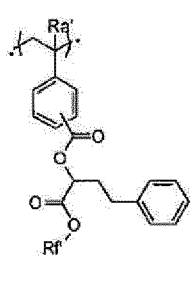
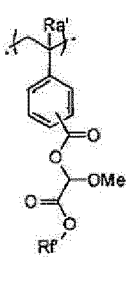
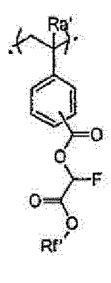
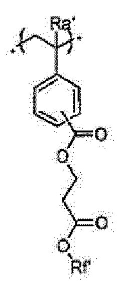
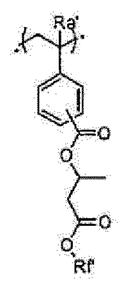

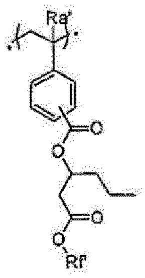 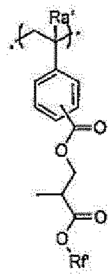 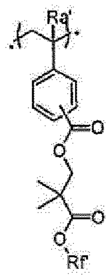 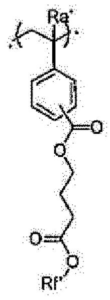 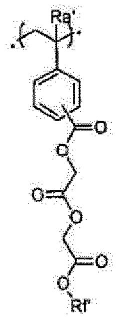 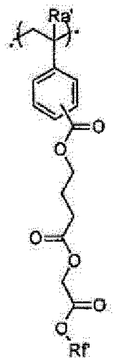

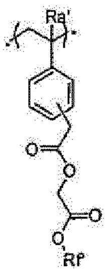 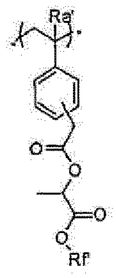 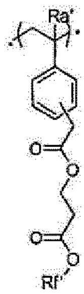 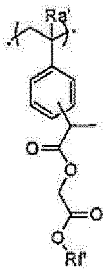 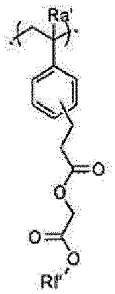 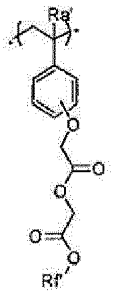

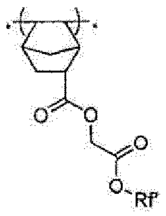 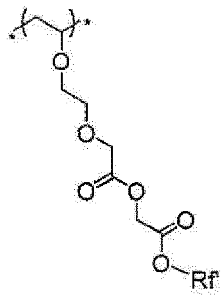 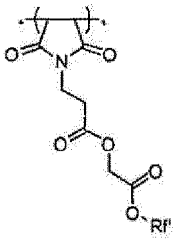

In a case where the resin (C) contains the repeating unit (γ), the content of the repeating unit (γ) is preferably 10-90 mol% and more preferably 20-85 mol% with respect to total repeating units of the resin (C).

The weight-average molecular weight (Mw) of the resin (C) is preferably 1,000-1,000,000, more preferably 10,000-700,000, and even more preferably 20,000-500,000.

The weight-average molecular weight (Mw) and number-average molecular weight (Mn) of the resin (C) can be measured in terms of standard polystyrene, by using gel permeation chromatography (GPC, manufactured by Tosoh Corporation; HLC-8120; Tskgel Multipore HXL-M) and using tetrahydrofuran (THF) as a solvent.

A dispersion degree (Pd: weight-average molecular weight (Mw)/number-average molecular weight (Mn)) of the resin (C) used in the present invention is not particularly limited, but is preferably 1.0-3.0, more preferably 1.0-2.5, even more preferably 1.1-2.3, and particularly preferably > 1.2 to 2.0.

In a case where the resin (C) includes a group having a fluorine atom, a content of the repeating unit including a group having a fluorine atom is preferably 5-100 mol% and preferably 10-100 mol% with respect to the total repeating units of the resin (C). In a case where the resin (C) has a repeating unit having an aromatic ring group, a content of the repeating unit having an aromatic ring group is preferably 3-100 mol% and more preferably 5-100 mol% with respect to the total repeating units of the resin (C).

In a case where the resin (C) is a copolymer, the resin (C) may be e.g. a random copolymer or a block copolymer, but is preferably a random copolymer. The resin (C) may be any one of a linear chain polymer, a branched polymer, a comb polymer, and a star polymer.

As the resin (C), various commercially available products may be used, and the resin (C) may be synthesized in conformity with a well-known method (for example, radical polymerization).

The resin (C) can be synthesized by radical, cation, or anion polymerization of an unsaturated monomer corresponding to each structure. Otherwise, a desired resin can be obtained by performing polymerization by using an unsaturated monomer corresponding to a precursor of each structure and performing polymer reaction.

Examples of the well-known method include a batch polymerization method in which polymerization is performed by dissolving an unsaturated monomer species and an initiator in a solvent and heating and a dropwise addition polymerization method in which a solution of an initiator and a monomer species is added dropwise to a heating solvent over 1-10 h, and a dropwise addition polymerization method is preferable.

As the reaction solvent, the polymerization initiator, the reaction conditions (such as temperature and concentration), and the purification method after the reaction, disclosures of paragraphs [0173]-[0183] of JP-A-2012-208447 can be referred to.

In the synthesization of the resin (C), the concentration of the reaction is preferably 30-50 mass%.

The resin (C) may be used singly or a plurality thereof may be used in combination.

Hereinafter, specific examples of the resin (C) are provided. In the table below, a molar ratio (corresponding to an order of respective repeating units from the left), a weight-average molecular weight (Mw), and a dispersion degree (Mw/Mn) of a repeating unit in each resin are provided.

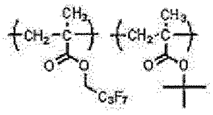
(HR-1)
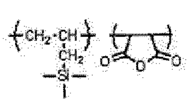
(HR-2)
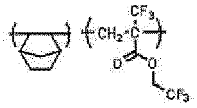
(HR-3)
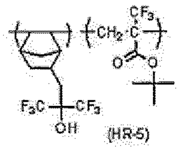
(HR-5)
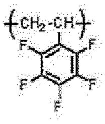
(HR-6)
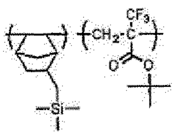
(HR-7)
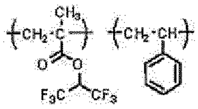
(HR-8)
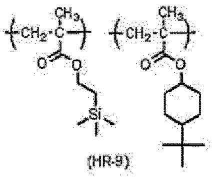
(HR-9)
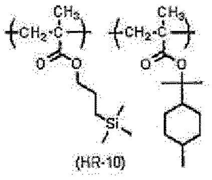
(HR-10)
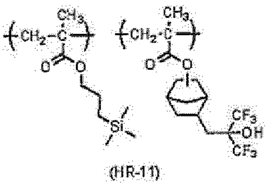
(HR-11)
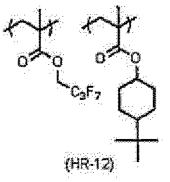
(HR-12)
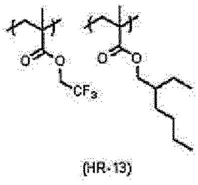
(HR-13)
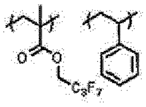
(HR-14)
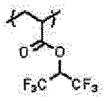
(HR-15)
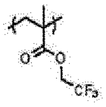
(HR-16)
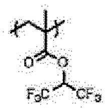
(HR-17)
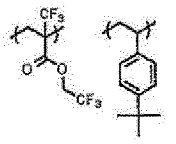
(HR-18)
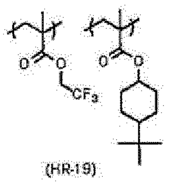
(HR-19)
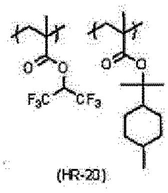
(HR-20)
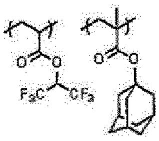
(HR-21)
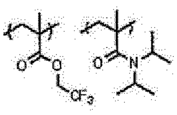
(HR-22)
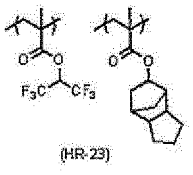
(HR-23)
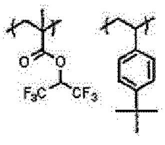
(HR-24)
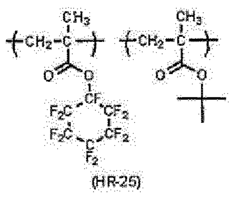
(HR-25)
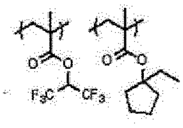
(HR-26)
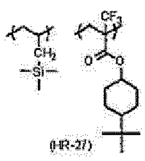
(HR-27)
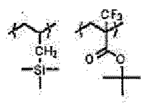
(HR-28)
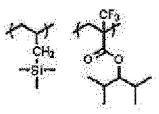
(HR-29)
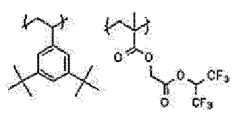
(HR-30)

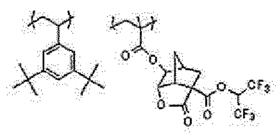
(HR-31)

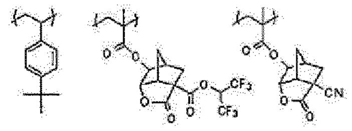
(HR-32)

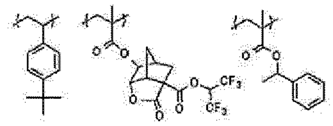
(HR-33)

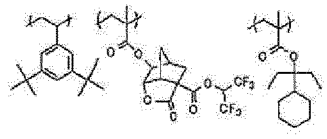
(HR-34)

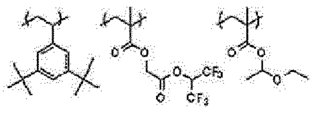
(HR-35)

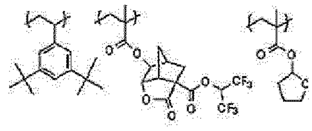
(HR-36)

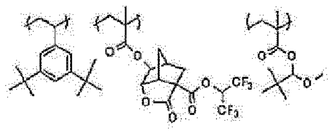
(HR-37)

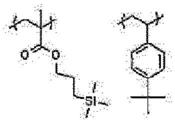
(HR-38)

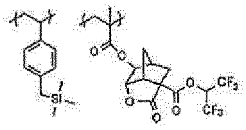
(HR-39)

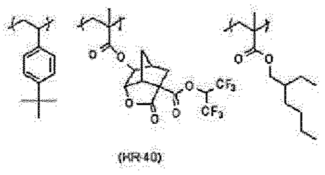
(HR-40)

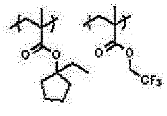
(HR-41)

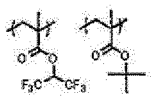
(HR-42)

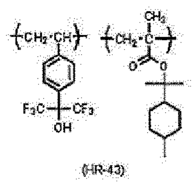
(HR-43)

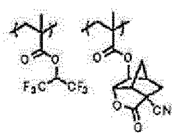
(HR-44)

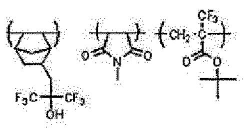
(HR-45)

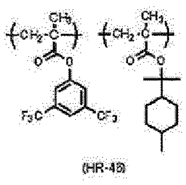
(HR-46)

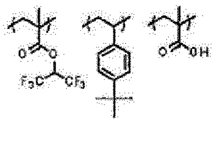
(HR-47)

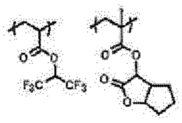
(HR-48)

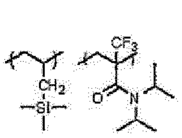
(HR-49)

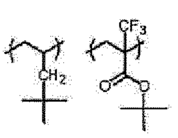
(HR-50)

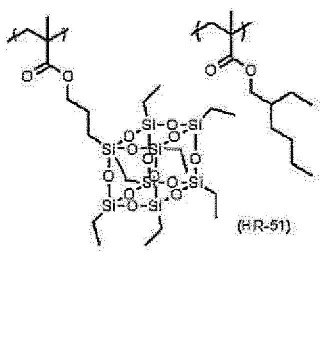
(HR-51)

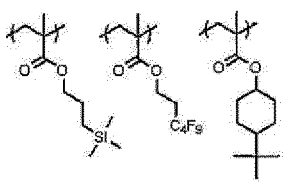
(HR-52)

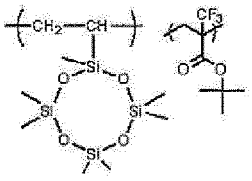

(HR-53)

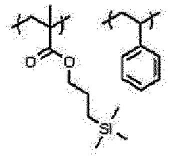

(HR-54)

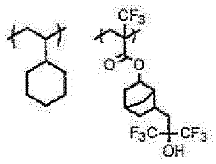

(HR-55)

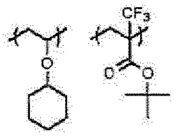

(HR-56)

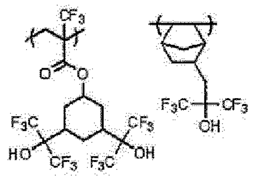

(HR-57)

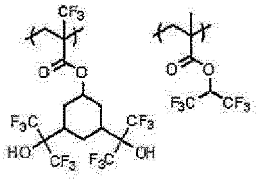

(HR-58)

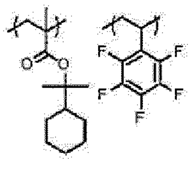

(HR-59)

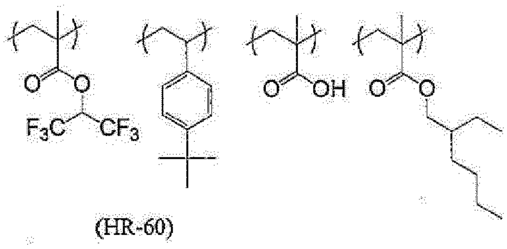

(HR-60)

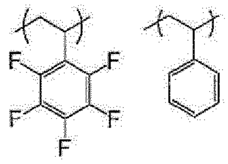

(HR-61)

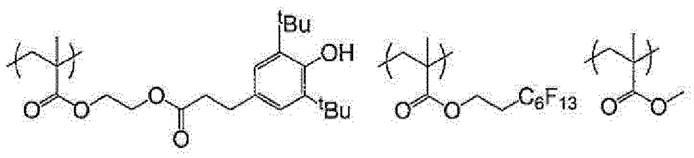

(HR-62)

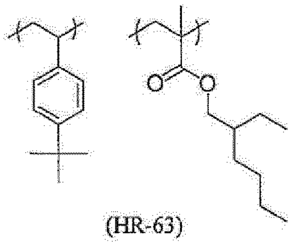

(HR-63)

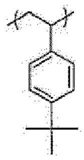

HR-64

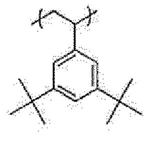

HR-65

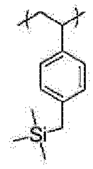

HR-66

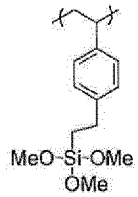

HR-67

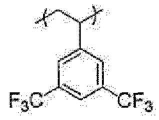

HR-68

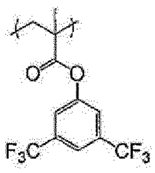

HR-69

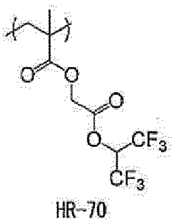

HR-70

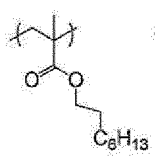

HR-71

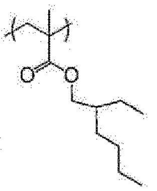

HR-72

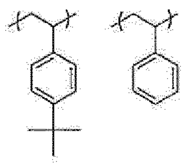

HR-73

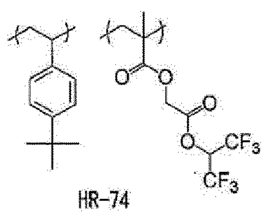

HR-74

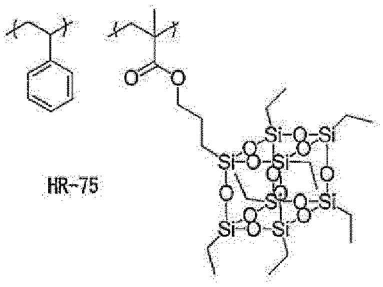

HR-75

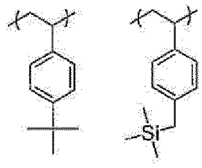

HR-76

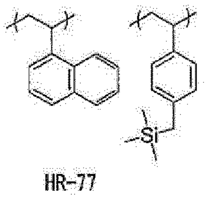

HR-77

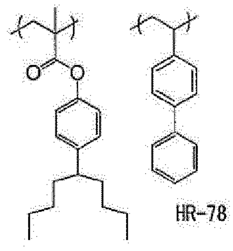

HR-78

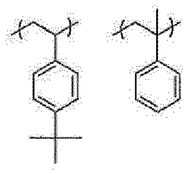

HR-79

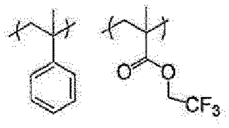

HR-80

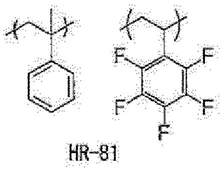

HR-81

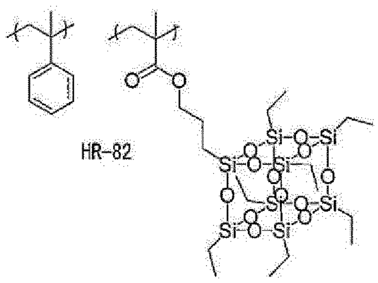

HR-82

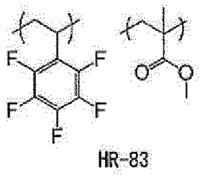

HR-83

[Table 1]

| Resin | Composition | Mw | Mw/Mn | Resin | Composition | Mw | Mw/Mn |
|---|---|---|---|---|---|---|---|
| HR-1 | 90/10 | 18000 | 1.55 | HR-43 | 50/50 | 6000 | 1.42 |
| HR-2 | 50/50 | 15100 | 1.62 | HR-44 | 70/30 | 25500 | 1.61 |
| HR-3 | 50/50 | 4800 | 1.50 | HR-45 | 50/20/30 | 14200 | 1.40 |
| HR-5 | 50/50 | 14500 | 1.47 | HR-46 | 30/70 | 27500 | 1.68 |
| HR-6 | 100 | 25500 | 1.61 | HR-47 | 40/58/2 | 24300 | 1.49 |
| HR-7 | 50/50 | 15800 | 1.92 | HR-48 | 50/50 | 26800 | 1.67 |
| HR-8 | 50/50 | 44200 | 1.34 | HR-49 | 50/50 | 6500 | 1.50 |
| HR-9 | 50/50 | 35900 | 1.80 | HR-50 | 50/50 | 4500 | 1.40 |
| HR-10 | 50/50 | 37500 | 1.62 | HR-51 | 30/70 | 150000 | 2.56 |
| HR-11 | 70/30 | 26600 | 1.81 | HR-52 | 30/30/40 | 16500 | 1.80 |
| HR-12 | 40/60 | 33900 | 1.33 | HR-53 | 50/50 | 4000 | 1.32 |
| HR-13 | 50/50 | 49500 | 1.81 | HR-54 | 50/50 | 26500 | 1.70 |
| HR-14 | 50/50 | 25300 | 1.68 | HR-55 | 50/50 | 16000 | 1.58 |
| HR-15 | 100 | 26200 | 1.27 | HR-56 | 50/50 | 15000 | 1.62 |
| HR-16 | 100 | 25600 | 1.64 | HR-57 | 50/50 | 14000 | 1.42 |

(continued)

| Resin | Composition | Mw | Mw/Mn | Resin | Composition | Mw | Mw/Mn |
|---|---|---|---|---|---|---|---|
| HR-17 | 100 | 24400 | 1.31 | HR-58 | 20/80 | 26000 | 1.44 |
| HR-18 | 50/50 | 14300 | 1.38 | HR-59 | 50/50 | 27000 | 1.45 |
| HR-19 | 50/50 | 26500 | 1.60 | HR-60 | 39/57/2/2 | 21000 | 1.35 |
| HR-20 | 30/70 | 36500 | 1.50 | HR-61 | 35/65 | 81000 | 1.95 |
| HR-21 | 50/50 | 26000 | 1.62 | HR-62 | 6/12/82 | 276000 | 2.20 |
| HR-22 | 50/50 | 3000 | 1.21 | HR-63 | 50/50 | 51000 | 1.45 |
| HR-23 | 50/50 | 25000 | 1.25 | HR-64 | 100 | 51000 | 1.42 |
| HR-24 | 30/70 | 34000 | 1.68 | HR-65 | 100 | 62000 | 1.45 |
| HR-25 | 30/70 | 15000 | 1.43 | HR-66 | 100 | 41500 | 1.43 |
| HR-26 | 80/20 | 15000 | 1.62 | HR-67 | 100 | 21000 | 1.67 |
| HR-27 | 50/50 | 23500 | 1.34 | HR-68 | 100 | 9000 | 1.55 |
| HR-28 | 50/50 | 16200 | 1.47 | HR-69 | 100 | 15000 | 1.82 |
| HR-29 | 50/50 | 26500 | 1.68 | HR-70 | 100 | 21000 | 1.50 |
| HR-30 | 15/85 | 30000 | 1.52 | HR-71 | 100 | 20000 | 1.62 |
| HR-31 | 10/90 | 38000 | 1.50 | HR-72 | 100 | 25000 | 1.54 |
| HR-32 | 20/70/10 | 29000 | 1.54 | HR-73 | 80/20 | 55000 | 1.45 |
| HR-33 | 10/75/15 | 18000 | 1.65 | HR-74 | 70/30 | 28000 | 1.56 |
| HR-34 | 10/80/10 | 11000 | 1.43 | HR-75 | 55/45 | 169000 | 2.56 |
| HR-35 | 5/80/15 | 26000 | 1.39 | HR-76 | 50/50 | 42000 | 1.87 |
| HR-36 | 15/75/10 | 23000 | 1.44 | HR-77 | 30/70 | 28000 | 1.65 |
| HR-37 | 10/80/10 | 20000 | 1.42 | HR-78 | 80/20 | 19000 | 1.56 |
| HR-38 | 50/50 | 38000 | 1.56 | HR-79 | 80/20 | 120000 | 1.30 |
| HR-39 | 20/80 | 27000 | 1.52 | HR-80 | 70/30 | 130000 | 1.28 |
| HR-40 | 15/80/5 | 25000 | 1.55 | HR-81 | 70/30 | 125000 | 1.38 |
| HR-41 | 50/50 | 26500 | 1.61 | HR-82 | 70/30 | 180000 | 1.45 |
| HR-42 | 50/50 | 25200 | 1.60 | HR-83 | 50/50 | 60000 | 1.54 |

In addition to the resin (C) used in the present invention, it is preferable to use the resin (D) other than the above. Examples of the resin (D) include an insulating polymer such as polystyrene, poly $\alpha$-methyl styrene, polycarbonate, polyarylate, polyester, polyamide, polyimide, polyurethane, polysiloxane, polysilsesquioxane, polysulfone, polymethacrylate represented by polymethyl methacrylate, polyacrylate represented by polymethyl acrylate, cellulose represented by triacetyl cellulose, polyethylene, polypropylene, polyvinyl phenol, polyvinyl alcohol, polyvinyl butyral, and a copolymer obtained by copolymerizing two or more of these constituents.

In a case where the resin (D) is used, a mass ratio of the resin (C) is preferably 10 to < 100 mass% and more preferably 20 to < 100 mass% with respect to a total amount of the resin (C) and the resin (D).

In a case where the resin (C) and the resin (D) are included in the organic semiconductor layer, a total content of the resin (C) and the resin (D) is preferably 1-80 mass%, more preferably 5-60 mass%, and even more preferably 10-50 mass% with respect to a total mass of the organic semiconductor layer. In a case where the content of the resin (C) is in the above range, it is easy to unevenly distribute the resin (C) on a surface side and the specific organic semiconductor compound on a substrate side in the organic semiconductor layer, a maintenance rate (durability) of carrier mobility increases, a conductive path of the specific organic semiconductor compound can be ensured, and the carrier mobility can be further improved.

In the organic semiconductor layer, it is preferable that a content of the organic semiconductor compound

described below is the same as the content of a coating solution (or a mixed solution) in a total solid content.

<Substrate>

The substrate may be a substrate that can support the OTFT and a display panel manufactured thereon. The substrate has insulating properties on the surface and the substrate is not particularly limited, as long as the substrate has a sheet shape and the surface thereof is flat.

As the material of the substrate, an inorganic material may be used. Examples of the substrate including the inorganic material include various glass substrates such as quartz glass or soda-lime glass, various glass substrates having an insulating film formed on the surface thereof, a quartz substrate having an insulating film formed on the surface thereof, a silicon substrate having an insulating film formed on the surface thereof, a sapphire substrate, a metal substrate or a metal foil formed of various alloys such as stainless steel, aluminum, and nickel or various metals, and paper.

In a case where the substrate is formed of a conductive or semiconductive material such as a stainless sheet, an aluminum foil, a copper foil, or a silicon wafer, an insulating polymer material or metal oxide is generally applied or laminated on the surface and used.

As the material of the substrate, an organic material may be used. Examples thereof include a flexible plastic substrate (also referred to as a plastic film or a plastic sheet) including an organic polymer exemplified by polymethyl methacrylate (PMMA), polyvinyl alcohol (PVA), polyvinyl phenol (PVP), polyethersulfone (PES), polyimide, polyamide, polyacetal, polycarbonate (PC), polyethylene terephthalate (PET), polyethylene naphthalate (PEN), polyethylether ketone, polyolefin, and polycycloolefin. Examples thereof also include a substrate formed of mica.

In a case where e.g. a flexible plastic substrate is used, it is possible to combine or integrate the OTFT, for example, with a display device or an electronic device having a curved shape.

Since the organic material forming the substrate is hardly softened in a case where other layers are laminated and heated, the glass transition point is preferably high and the glass transition point is preferably ≥ 40°C. Since dimensions are hardly changed by the heat treatment in a case of manufacturing and the stability of the transistor performance is excellent, the coefficient of linear expansion is preferably small. A material having a linear expansion coefficient of $25\times10^{-5}$ cm/cm•°C or less is preferable, and a material having a linear expansion coefficient of $10\times10^{-5}$ cm/cm•°C or less is more preferable.

The organic material forming the substrate is preferably a material having resistance to the solvent used in a case of manufacturing the OTFT and preferably is a material having excellent adhesiveness to the gate insulating layer and the electrode.

It is preferable to use a plastic substrate including an organic polymer having high gas barrier properties.

It is also preferable to provide a dense silicon oxide film on at least one side of the substrate or vapor-deposit or laminate an inorganic material.

In addition to the above, examples of the substrate include a conductive substrate (a substrate formed of metal such as gold or aluminum, a substrate formed of highly oriented graphite, a stainless steel substrate).

A buffer layer for improving adhesiveness and flatness, a functional film such as a barrier film for improving the gas barrier properties, and a surface treatment layer such as an easy adhesion layer on the surface may be formed on the substrate, and the substrate may be subjected to a surface treatment such as a corona treatment, a plasma treatment, or a UV/ozone treatment.

The thickness of the substrate is preferably ≤ 10 mm, more preferably ≤ 2 mm, and particularly preferably ≤ 1 mm or less. Meanwhile, the thickness is preferably 0.01 mm or greater and more preferably ≥ 0.05 mm. Particularly, in a case of the plastic substrate, the thickness is preferably 0.05-0.1 mm. In a case of the substrate including an inorganic material, the thickness is preferably 0.1-10 mm.

<Gate electrode>

As the gate electrode, an electrode well-known in the related art can be used as the gate electrode of the OTFT. The conductive material (also referred to as an electrode material) forming the gate electrode is not particularly limited. Examples thereof include metal such as platinum, gold, silver, aluminum, chromium, nickel, copper, molybdenum, titanium, magnesium, calcium, barium, sodium, palladium, iron, and manganese; conductive metal oxide such as $InO_2$, $SnO_2$, indium-tin oxide (ITO, tin-doped indium oxide), fluorine doped tin oxide (FTO, F-doped Tin Oxide), aluminum doped zinc oxide (azo, Al doped ZnO), and gallium doped zinc oxide (GZO, Ga doped ZnO); a conductive polymer such as polyaniline, polypyrrole, polythiophene, polyacetylene, poly(3,4-ethylenedioxythiophene)/polystyrenesulfonic acid (PEDOT/PSS); an acid such as hydrochloric acid, sulfuric acid, and sulfonic acid; the conductive polymer to which a dopant such as a lewis acid such as $PF_6$, $AsF_5$, and $FeCl_3$, a halogen atom such as iodine, a metal atom such as sodium and potassium are added, and a conductive composite material in which carbon black, graphite powder, or metal fine particles are dispersed. These materials may be used singly or two or more kinds thereof may be used together in an

arbitrary combination and ratio.

The gate electrode may be a single layer formed of the conductive material, and two or more layers may be laminated.

The method of forming the gate electrode is not limited. Examples thereof include a method of patterning a film formed by a physical vapor deposition method (PVD) such as a vacuum deposition method, a chemical vapor deposition method (CVD method), a sputtering method, a printing method (coating method), a transfer method, a sol gel method or a plating method, to a desired shape, if necessary.

In the coating method, a solution, a paste, or a dispersion liquid of the above material can be prepared and applied, and an electrode can be formed directly or by forming a film by drying, baking, photocuring, or aging.

Ink jet printing, screen printing, (reverse) offset printing, letterpress printing, intaglio printing, planographic printing, thermal transfer printing and micro contact printing method are preferable, since patterning can be performed as desired, the process is simple, the cost is reduced, and the speed is high.

Even in a case where a spin coating method, a die coating method, a micro gravure coating method, or a dip coating method is employed, patterning can be performed in combination with the e.g. following photolithography method.

Examples of the photolithography method include a method combining patterning of a photoresist, etching such as wet etching with an etchant or dry etching with reactive plasma, and a lift-off method.

Examples of another patterning method include a method of irradiating the above material with an energy beam such as a laser or an electron beam, polishing the material, or changing the conductivity of the material.

Examples of another method include a method of transferring a composition for a gate electrode printed on a support other than the substrate to a base material layer such as a substrate.

The thickness of the gate electrode is arbitrary, but is preferably ≥ 1 nm and more preferably ≥ 10 nm. The thickness is preferably ≤ 500 nm and more preferably ≤ 200 nm.

<Gate insulating layer>

The gate insulating layer is not particularly limited, as long as the gate insulating layer is a layer having insulating properties, and may be a single layer or multiple layers.

The gate insulating layer is preferably formed of insulating materials. Examples of the insulating materials preferably include an organic polymer and inorganic oxide.

The organic polymer and the inorganic oxide are not particularly limited, as long as the organic polymer and the inorganic oxide have insulating properties. It is preferable to form a thin film, for example, a thin film having a thickness of ≤ 1 μm.

The organic polymer and the inorganic oxide may be used singly, two or more kinds thereof may be used in combination, or an organic polymer and inorganic oxide may be used in combination.

The organic polymer is not particularly limited. Examples thereof include poly(meth)acrylate represented by polyvinyl phenol, polystyrene (PS), and polymethyl methacrylate, a cyclic fluoroalkyl polymer represented by polyvinyl alcohol, polyvinyl chloride (PVC), polyvinylidene fluoride (PVDF), polytetrafluoroethylene (PTFE), and CYTOP (manufactured by Asahi Glass Co., Ltd.), polyorganosiloxane represented by polycycloolefin, polyester, polyethersulfone, polyether ketone, polyimide, an epoxy resin, and polydimethylsiloxane (PDMS), polysilsesquioxane, and butadiene rubber. In addition to the above, examples thereof include a thermosetting resin such as a phenol resin, a novolak resin, a cinnamate resin, an acrylic resin, and a polyparaxylylene resin.

The organic polymer may be used in combination with a compound having a reactive substituent such as an alkoxysilyl group, a vinyl group, an acryloyloxy group, an epoxy group, and a methylol group.

In a case where the gate insulating layer is formed of an organic polymer, e.g. for the purpose of increasing solvent resistance and insulation resistance of the gate insulating layer, it is preferable that an organic polymer is crosslinked and cured. The crosslinking is preferably performed by using light, heat, or both, so as to generate acid or radical.

In a case where crosslinking is performed with a radical, as a radical generating agent that generates radicals by light or heat, for example, thermal polymerization initiators (H1) and photopolymerization initiators (H2) disclosed in paragraphs [0182]-[0186] of JP-A-2013-214649, photoradical generating agents disclosed in paragraphs [0046]-[0051] of JP-A-2011-186069, photoradical polymerization initiators disclosed in paragraphs [0042]-[0056] of JP-A-2010-285518 can be suitably used.

The "compound (G) having number-average molecular weight (Mn) of 140-5,000, having crosslinking functional groups, and not having a fluorine atom" disclosed in paragraphs [0167]-[0177] of JP-A-2013-214649 is preferably used.

In a case where crosslinking is performed with acid, as a photoacid generator that generates acid by light, for example, photocationic polymerization initiators disclosed in paragraphs [0033]-[0034] of JP-A-2010-285518, acid generators disclosed in paragraphs [0120]-[0136] of JP-A-2012-163946 can be used, particularly, sulfonium salt and iodonium salt can be preferably used.

As a thermal acid generator (catalyst) that generates acid by heat, for example, thermal cation polymerization initiators and particularly onium salts disclosed in paragraphs [0035]-[0038] of JP-A-2010-285518, catalysts disclosed in paragraphs [0034]-[0035] of JP-A-2005-354012, particularly, sulfonic acids and sulfonic acid amine salts preferably can be used.

Crosslinking agents, particularly difunctional or higher epoxy compounds and oxetane compounds disclosed in paragraphs [0032]-[0033] of JP-A-2005-354012, crosslinking agents, particularly compounds, each of which has two or more crosslinking groups and in which at least one of these crosslinkable groups is a methylol group or a NH group, disclosed in paragraphs [0046]-[0062] of JP-A-2006-303465, and compounds, each of which has two or more of hydroxymethyl groups or alkoxymethyl groups in a molecule, disclosed in paragraphs [0137]-[0145] of JP-A-2012-163946, are preferably used.

Examples of the method forming a gate insulating layer with an organic polymer include a step of coating and curing the organic polymer. The coating method is not particularly limited, and examples thereof include the above printing methods. Among these, a wet coating method such as a micro gravure coating method, a dip coating method, a screen coating printing, a die coating method, or a spin coating method is preferable.

The inorganic oxide is not particularly limited, and examples thereof include oxide such as silicon oxide, silicon nitride ($SiN_Y$), hafnium oxide, titanium oxide, tantalum oxide, aluminum oxide, niobium oxide, zirconium oxide, copper oxide, and nickel oxide, perovskite such as $SrTiO_3$, $CaTiO_3$, $BaTiO_3$, $MgTiO_3$, and $SrNb_2O_6$, and composite oxide or mixture of these. Here, examples of silicon oxide include boron phosphorus silicon glass (BPSG), phosphorus silicon glass (PSG), borosilicate glass (BSG), arsenic silicate glass (AsSG), lead silicate glass (PbSG), silicon oxynitride (SiON), spin-on-glass (SOG), low dielectric constant $SiO_2$-based materials (for example, polyaryl ether, cycloperfluorocarbon polymer and benzocyclobutene, cyclic fluororesin, polytetrafluoroethylene, fluoroaryl ether, fluorinated polyimide, amorphous carbon, and organic SOG), in addition to silicon oxide (SiOx).

As the method of forming a gate insulating layer with inorganic oxide, for example, a vacuum film forming method such as a vacuum deposition method, a sputtering method, ion plating, or a chemical vapor deposition (CVD) method can be used, and it is possible to perform assistance from e.g. plasma, an ion gun and a radical gun, by using arbitrary gas at the time of forming a film.

A film may be performed by causing a precursor corresponding to each of the metal oxide, specifically, metal halides such as chlorides or bromides, metal alkoxide, or metal hydroxide, to react with an acid such as hydrochloric acid, sulfuric acid, or nitric acid or a base such as sodium hydroxide or potassium hydroxide in alcohol or water so as to perform hydrolysis. In a case where such a solution-based process is used, a wet-coating method can be used.

In addition to the above method, the gate insulating layer can be prepared by combining any one of a lift-off method, a sol-gel method, an electrodeposition method, and shadow mask method, with a patterning method, if necessary.

The gate insulating layer may be subjected to a surface treatment such as a corona treatment, a plasma treatment, and an ultraviolet (UV)/ozone treatment. However, in this case, it is preferable that surface roughness does not become coarse due to the treatment. The arithmetic average roughness Ra or the root mean square roughness $R_{MS}$ of the gate insulating layer surface is preferably $\leq 0.5$ nm.

In a case where the mixed solution (organic semiconductor composition) containing the specific organic semiconductor compound and the resin (C) is applied to the gate insulating layer, it is preferable that the surface energy of the gate insulating layer is preferably 50-75 $mNm^{-1}$, more preferably 60-75 $mNm^{-1}$, even more preferably 65-75 $mNm^{-1}$, and particularly preferably 70-75 $mNm^{-1}$. This is because the carrier mobility is improved accordingly. It is assumed that this is because of the following reasons.

In a case where the mixed solution is applied to the gate insulating layer, it is considered that, while a domain of the specific organic semiconductor compound and a domain of the resin (C) are formed, a speed in a case of forming the domain and a degree of phase separation are influenced by the gate insulating layer which is the base material. At this point, in a case where the surface energy of the gate insulating layer is in the above range, it is considered that the speed in a case of forming the domain and the degree of phase separation work in the direction of improving the carrier mobility.

As the method of adjusting surface energy of the gate insulating layer, an ultraviolet (UV)/ozone treatment is effective, and it is possible to hydrophilize a gate insulating layer surface by appropriately selecting the treatment time. According to the present invention, the surface energy of the gate insulating film can be measured by the above method of measuring the surface energy.

<Self-assembled monolayer (SAM)>

A self-assembled monolayer may be formed on the gate insulating layer.

The compound for forming the self-assembled monolayer is not particularly limited, as long as the compound is a compound that self-assembles, and for example, as a self-assembling compound, compounds of one or more types

of Formula 1S may be used.

Formula 1S: $R^{1S}$-$X^S$

In Formula 1S, $R^{1S}$ is any one of alkyl, alkenyl, alkynyl, aryl, alkoxy, aryloxy or a heterocyclic group (such as thienyl, pyrrolyl, pyridyl and fluorenyl).

$X^S$ is an adsorptive or reactive substituent and specifically is -$SiX^4X^5X^6$ ($X^4$ is a halide group or alkoxy, $X^5$ and $X^6$ each independently are any one of a halide group, alkoxy, alkyl or aryl. $X^4$, $X^5$, and $X^6$ preferably are identical to each other, more preferably Cl, methoxy and ethoxy), phosphonic acid (-$PO_3H_2$), phosphinic acid (-$PRO_2H$, R is alkyl), phosphoric acid, phosphorous acid, amino, halide, carboxy, sulfonic acid, boric acid (-$B(OH)_2$)), OH, thiol, ethynyl, vinyl, nitro and cyano.

It is preferable that $R^{1S}$ is not branched, and for example, linear normal alkyl (n-alkyl), tert-phenyl in which three phenyl groups are arranged in series, a structure in which n-alkyl groups are arranged on both sides of a para position of a phenyl group are preferable. The alkyl chain may have an ether bond and may have a carbon-carbon double bond or a triple bond.

An adsorptive or reactive substituent $X^S$ forms a bond by interaction, adsorption or reaction with a reactive region (for example, an -OH group) on the surface of the corresponding gate insulating layer so as to form the self-assembled monolayer on the gate insulating layer. Since the surface of the self-assembled monolayer is smoother and gives a surface with lower surface energy by filling the molecule more densely, the compound of Formula 1S has a linear main skeleton and uniform molecular lengths.

Specifically, particularly preferable examples of the compound of Formula 1S include an alkyltrichlorosilane compound such as methyltrichlorosilane, ethyl trichlorosilane, butyl trichlorosilane, octyltrichlorosilane, decyltrichlorosilane, octadecyltrichlorosilane, and phenethyltrichlorosilane, an alkyltrialkoxysilane compound such as methyltrimethoxysilane, ethyl trimethoxysilane, butyl trimethoxysilane, octyltrimethoxysilane, decyltrimethoxysilane, and octadecyltrimethoxysilane, alkylphosphonic acid, aryl phosphonic acid, alkyl carboxylic acid, aryl phosphonic acid, an alkyl boric acid group, an aryl boric acid group, an alkyl thiol group, and an arylthiol group.

The self-assembled monolayer can be formed by using e.g. a method of vapor-depositing the compound to a gate insulating layer under vacuum, a method of immersing a gate insulating layer in a solution of the compound and a Langmuir-Blodgett method. The self-assembled monolayer can be formed, for example, by treating the gate insulating layer with an alkylchlorosilane compound or a solution obtained by dissolving an alkylalkoxysilane compound in an organic solvent in an amount of 1-10 mass%. In the present invention, a method of forming the self-assembled monolayer is not limited to these methods.

The preferable method of obtaining a denser self-assembled monolayer include methods disclosed in Langmuir 19, 1159 (2003), J. Phys.Chem. B, 110, 21101 (2006).

Specifically, a self-assembled monolayer can be formed by immersing a gate insulating layer in a highly volatile dehydrating solvent in which the above compound is dispersed so as to form a film, extracting the gate insulating layer, performing a reaction step of e.g. the compound and the gate insulating layer such as annealing, if necessary, performing rinsing with a dehydrated solvent, and drying.

The dehydrated solvent is not particularly limited, but, for example, chloroform, trichlorethylene, anisole, diethyl ether, hexa, or toluene may be used singly or in a mixture.

It is preferable to dry the film in a dry atmosphere or by blowing dry gas. It is preferable to use an inert gas such as nitrogen for the drying gas. Since the self-assembled monolayer which is dense and which does not have cohesion and defects is formed by using such a method of manufacturing the self-assembled monolayer, the surface roughness of the self-assembled monolayer can be suppressed to ≤ 0.3 nm.

<Organic semiconductor layer>

The organic semiconductor layer is a layer containing the specific organic semiconductor compound and is a layer that can accumulate the carrier. As described above, the specific organic semiconductor compound is an organic semiconductor compound which has a molecular weight of ≥ 2,000 and has a repeating unit of Formula -(D-A)-(1).

The organic semiconductor layer included in the OTFT contains at least the specific organic semiconductor compound. However, in a case where the OTFT does not have the resin (C) layer, the OTFT necessarily contains the resin (C), together with the specific organic semiconductor compound.

In Formula (1), A is an electron acceptor unit including a partial structure having at least one of a sp2 nitrogen atom, carbonyl or thiocarbonyl in a ring structure.

D is an electron donor unit including a divalent aromatic heterocyclic group having at least one of N, O, S or Se in a ring structure or a divalent aromatic hydrocarbon group consisting of a fused ring structure having two or more rings, as a partial structure.

(Electron acceptor unit ("A" of Formula (1)))

In Formula (1), A is an electron acceptor unit including a partial structure having at least one of a sp2 nitrogen atom, carbonyl or thiocarbonyl in a ring structure.

A preferably has at least one structure selected from structures of Formulae (A-1) to (A-12) as a partial structure, and A has more preferably a structure of at least one of Formulae (A-1) to (A-12).

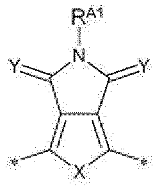
(A-1)

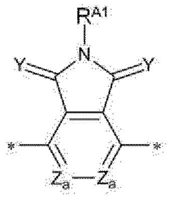
(A-2)

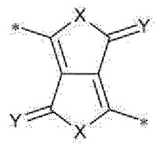
(A-3)

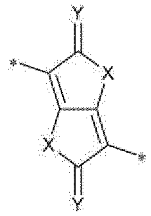
(A-4)

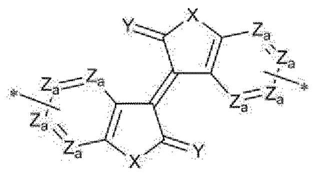
(A-5)

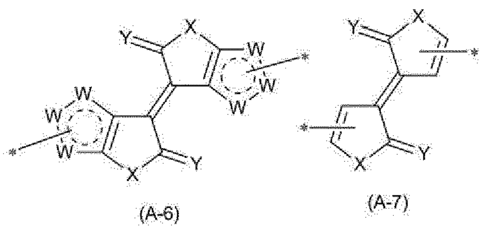
(A-6) (A-7)

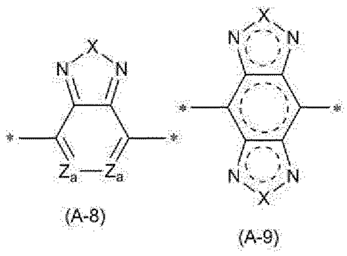
(A-8) (A-9)

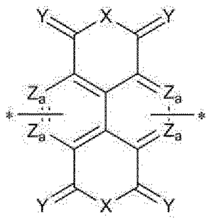
(A-10)

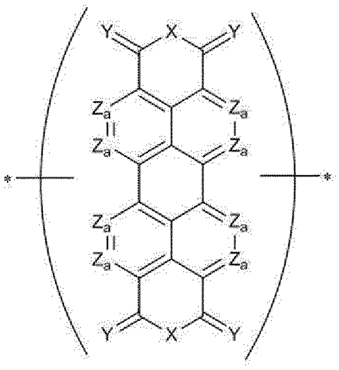
(A-11)

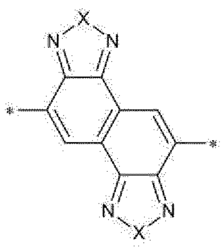
(A-12)

In Formulae (A-1) to (A-12), X's each independently are O, S, Se or $NR^{A1}$. Y's each independently are O or S. $Z_a$'s each independently is $CR^{A2}$ or N. W's each independently are $C(R^{A2})_2$, $NR^{A1}$, N, $CR^{A2}$, O, S or Se. $R^{A1}$'s each independently are a bonding site to an alkyl group that may include at least one of -O-, -S-, or $-NR^{A3}-$, a monovalent group of Formula (1-1), or another structure. $R^{A2}$'s each independently are a bonding site to an alkyl group that may include at least one of H, halogen, -O-, -S-, or $-NR^{A3}-$, a monovalent group of Formula (1-1), or another structure. $R^{A3}$'s each independently are H or a substituent. *'s each independently are a bonding site to another structure.

In Formulae (A-5) and (A-10), in each of the two ring structures including Za, one of Za's is $CR^{A2}$, and $R^{A2}$ is a bonding site to another structure. This bonding site to another structure corresponds to * in the formula. Specifically, a bond (hereinafter, simply referred to as a "bond") in which * that is a bonding site to another structure is positioned at a terminal stretching from any one of $Z_a$'s in each formula, and $Z_a$ to which this bond stretches is $CR^{A2}$ and corresponds to a form in which $R^{A2}$ is a bonding site to another structure.

In Formula (A-11), two Za's are $CR^{A2}$, and $R^{A2}$ is a bonding site to another structure. This bonding site to another structure corresponds to * in the formula.

In Formula (A-6), in each of the two ring structures including W's, one of W's is at least one of the three following forms.

Form 1: W is $CR^{A2}$, and $R^{A2}$ is a bonding site to another structure.

Form 2: W is $NR^{A1}$, and $R^{A1}$ is a bonding site to another structure.

Form 3: W is $C(R^{A2})_2$ and any one of $R^{A2}$'s is a bonding site to another structure.

$$* —— L_a —— Ar —(L_b)_l \qquad (1\text{-}1)$$

In Formula (1-1), Ar is an aromatic Cs-is-heterocyclic group or an aromatic $C_{5\text{-}18}$-hydrocarbon group. $L_a$ is an $C_{1\text{-}20}$-alkylene that may include at least one of -O-, -S-, or $-NR^{1S}-$. $L_b$ is $C_{1\text{-}100}$-alkyl that may include at least one of -O-, -S-, or $-NR^{2S}-$. $R^{1S}$ and $R^{2S}$ each independently are H or a substituent. l represents an integer of 1-5. In a case where l is ≥ 2, a plurality of $L_b$'s may be identical to or different from each other. * is a bonding site to another structure.

In Formulae (A-1) to (A-12), X's each independently are O, S, Se, or $NR^{A1}$, and S or $NR^{A1}$ is preferable.

Y's each independently are O or S, and O is preferable.

$Z_a$'s each independently are $CR^{A2}$ or N, and $CR^{A2}$ is preferable.

W's each independently are $C(R^{A2})_2$, $NR^{A1}$, N, $CR^{A2}$, O, S or Se, and $C(R^{A1})_2$, $CR^{A2}$ or aS is preferable.

$R^{A1}$'s each independently are alkyl that may contain at least one of -O-, -S-, or $-NR^{A3}-$, a monovalent group of Formula (1-1), or a bonding site to another structure, and alkyl that may contain at least one of -O-, -S-, or $-NR^{A3}-$ and a monovalent group of Formula (1-1) are preferable.

In a case where $R^{A1}$ is alkyl that may contain at least one of -O-, -S-, or $-NR^{A3}-$, $C_{2\text{-}30}$-alkyl is preferable, and $C_{8\text{-}25}$-alkyl is more preferable. The alkyl may be linear or branched.

A bonding site to another structure in $R^{A1}$ is a bonding site to another structure represented by * in Formulae (A-1) to (A-12).

$R^{A2}$ each independently are alkyl that may contain at least one of -O-, -S-, or $-NR^{A3}-$, H, halogen, a monovalent group of Formula (1-1), or a bonding site to another structure, and H or a bonding site to another structure is preferable.

In a case where $R^{A2}$ is an alkyl that may contain at least one of -O-, -S-, or $-NR^{A3}-$, $C_{2\text{-}30}$-alkyl is preferable, and $C_{8\text{-}25}$-alkyl is more preferable. The alkyl group may be linear or branched.

In a case where $R^{A2}$ is halogen, F, Cl, Br or I is preferable, and F is more preferable.

A bonding site to another structure in $R^{A2}$ is a bonding site to another structure represented by * in Formulae (A-1) to (A-12).

$R^{A3}$'s each independently are H or a substituent. The substituent in $R^{A3}$ has the same meaning as the substituents in $R^{1S}$ and $R^{2S}$ described below.

In Formula (1-1), Ar is an aromatic heterocyclic group or an aromatic hydrocarbon group having 5-18 carbon atoms.

Examples of the aromatic Cs-is-hydrocarbon group in Ar include a benzene ring group, biphenyl, naphthalene ring group, and a group obtained by removing two or more H from aromatic hydrocarbon (for example, a fluorene ring) in which three rings are fused. Among these, in view of the excellent carrier mobility, a benzene ring group, a biphenyl group, or a naphthalene ring group is preferable, and a benzene ring group is preferable.

The aromatic heterocyclic group in Ar may be a single ring or may have a fused ring structure of two or more rings. However, in view of the excellent carrier mobility, the aromatic heterocyclic group is preferably a single ring. The aromatic heterocyclic group in Ar is preferably a 5-membered to 7-membered ring. The hetero atom included in the aromatic heterocyclic group is preferably N, O, S or Se and more preferably S.

$L_a$ is $C_{1\text{-}20}$-alkylene that may include at least one of -O-, -S-, or $-NR^{1S}-$. Here, the expression that the alkylene group includes -O-, for example, means the case where -O- is introduced in the middle of the carbon-carbon bond of the alkylene group and the case where -O- is introduced at one terminal or both terminals of the alkylene group. The same meaning also applies in a case where the alkylene group includes -S- or $-N^{1S}-$.

An alkylene group $L_a$ may be any one of linear, branched or cyclic, but is preferably linear or branched alkylene.

The number of carbon atoms in the alkylene group represented by $L_a$ is 1-20. However, in view of the excellent carrier mobility, the number of carbon atoms is preferably 1-15 and more preferably 1-10.

In the case where the alkylene $L_a$ has a branched shape, the number of carbon atoms in the branched portion is included in the number of carbon atoms of the alkylene group represented by $L_a$. However, in a case where $L_a$ contains $-NR^{1S}-$ and this $R^{1S}$ includes a carbon atom, the number of carbon atoms in $R^{1S}$ is not included in the number of carbon atoms in the alkylene group represented by $L_a$.

$L_b$ $C_{1\text{-}100}$-alkyl that may include at least one of -O-, -S-, or $-NR^{2S}-$. Here, the expression that the alkyl group includes -O- means the case where -O- is introduced in the middle of the carbon-carbon bond of the alkyl group and the case where -O- is introduced to one terminal (that is, a portion connected to "Ar" above) of the alkyl group. The same meaning also applies in a case where the alkyl group includes -S- or $-N^{2S}-$.

An alkyl group that is represented by $L_b$ may be any one of linear, branched or cyclic. However, in view of

further excellent carrier mobility and temporal stability under high temperature and high humidity, linear or branched alkyl is preferably, and branched alkyl is more preferable. The alkyl group $L_b$ may be halogenated alkyl having a halogen atom (preferably a F, Cl, Br or I, and more preferably F) as a substituent.

The number of carbon atoms in the alkyl group represented by $L_b$ is 1-100 and preferably 9-100.

Since carrier mobility become excellent, the number of carbon atoms of at least one $L_b$ in $-(L_b)_1$ in Formula (1-1) is preferably 9-100, more preferably 20-100, and even more preferably 20-40.

In the case where the alkyl group represented by $L_b$ has a branched shape, the number of carbon atoms in the branched portion is included in the number of carbon atoms of the alkyl group represented by $L_b$. However, in a case where $L_b$ contains $-NR^{2S}-$ and this $R^{2S}$ includes a carbon atom, the number of carbon atoms in $R^{2S}$ is not included in the number of carbon atoms in the alkylene group represented by $L_b$.

$R^{1S}$ and $R^{2S}$ each independently are H or a substituent. The substituent is alkyl (a linear or branched $C_{1-10}$-alkyl), halogen (preferably F, Cl, Br or I) or aryl (preferably $C_{6-20}$-aryl). Among these, $R^{1S}$ to $R^{2S}$ each independently and preferably are H or alkyl, and are more preferably alkyl.

l is an integer of 1-5 and is preferably 1 or 2. In a case where l is ≥ 2, a plurality of $L_b$'s may be identical to or different from each other.

* represents a bonding site to another structure.

With respect to the specific organic semiconductor compound, A in Formula (1) preferably has at least one structure selected from structures of Formulae (A-1) to (A-12) as a partial structure, more preferably has at least one structure selected structures of Formulae (A-1), (A-3), (A-4), (A-5), (A-6), (A-8), (A-10), and (A-12), and (A-12), as a partial structure, even more preferably has at least one structure selected from structures of Formulae (A-1), (A-3), (A-5), (A-6), (A-8), and (A-12), as a partial structure, particularly preferably has at least one structure selected from structures of Formulae (A-3) and (A-6), as a partial structure, and most preferably has at least one structure selected from structures of Formula (A-3), as a partial structure.

The specific organic semiconductor compound is preferably a form in which A in Formula (1) has a structure of each formula to a form in which A in Formula (1) has a structure of each formula, as a partial structure.

An example of a structure of Formulae (A-1) to (A-12) is provided below. In the following structural formulae, $R^{A1}$ has the same meaning as $R^{A1}$ in Formulae (A-1) to (A-12), preferable forms thereof are also the same.

* represents a bonding site to another structure.

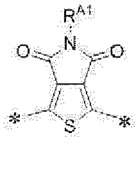 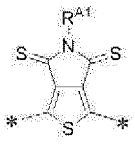 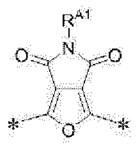 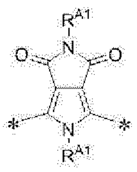 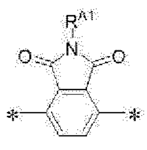 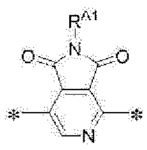 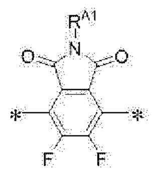

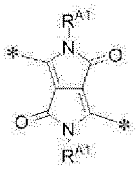 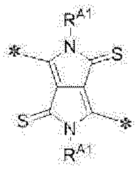 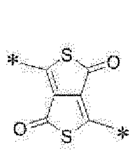 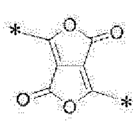 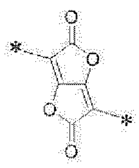 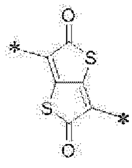 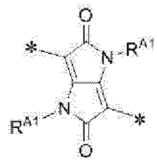

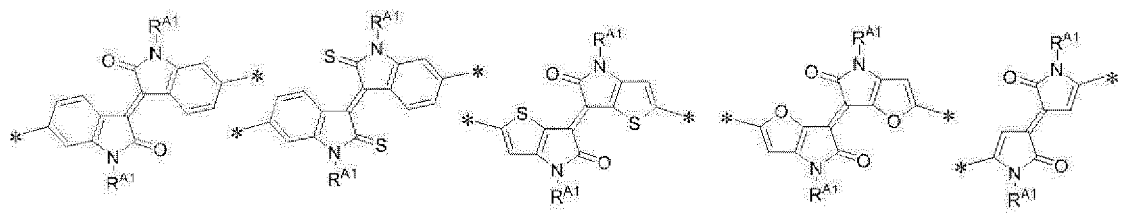

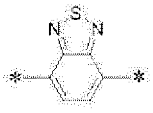 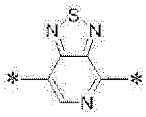 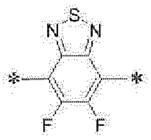 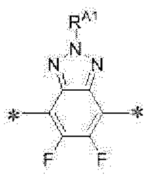 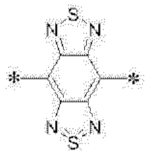 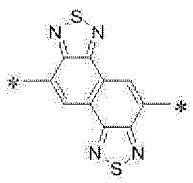

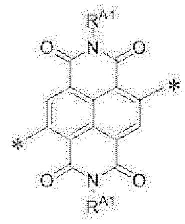
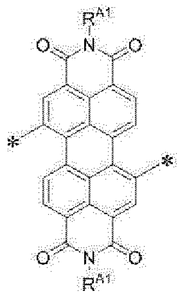

(Electron donor unit ("D" of Formula (1)))

D represents an electron donor unit including a divalent aromatic heterocyclic group having at least one of N, O, S or Se in a ring structure or a divalent aromatic hydrocarbon group consisting of a fused ring structure having two or more rings, as a partial structure.

The divalent aromatic heterocyclic group having at least one of N, O, S or Se in a ring structure is preferably a divalent aromatic heterocyclic group having at least one S atom in a ring structure.

The divalent aromatic heterocyclic group may have a single ring or a fused ring structure having two or more rings, and preferably has a structure obtained by combining two or more divalent aromatic heterocyclic groups having single rings or a structure obtained by combining a divalent aromatic heterocyclic group having two or more single rings and a divalent aromatic heterocyclic group having one or more fused ring structures having two or more rings.

The divalent aromatic heterocyclic group may further have a substituent, and preferred examples of the substituents include an alkyl group that may include at least one of -O-, -S-, or -$NR^{D3}$- (for example, $C_{1-30}$-alkyl or $C_{1-30}$-alkoxy is preferable, and $C_{1-20}$-alkyl is more preferable), alkenyl (preferably having 2-30 carbon atoms), alkynyl (preferably having 2-30 carbon atoms), an aromatic hydrocarbon group (preferably having 6-30 carbon atoms), an aromatic heterocyclic group (preferably a 5- to 7-membered ring, and preferably O, N, S or Se as a hetero atom), halogen (F, Cl, Br or I is preferable, F or Cl is more preferable, and F is particularly preferable), and a monovalent group of Formula (1-1).

$R^{D3}$ has the same meaning as $R^{D3}$ in Formula (D-1), and preferable forms thereof are also the same.

Examples of the divalent aromatic heterocyclic group are provided below, but the present invention is not limited thereto. In the structural formula, the hydrogen atom may be substituted with alkyl that may include at least one of -O-, -S-, or -$NR^{D3}$-, alkenyl, alkynyl, an aromatic hydrocarbon group, an aromatic heterocyclic group, halogen, or a group of Formula (1-1), $R^{D1}$ has the same meaning as $R^{D1}$ in Formula (D-1) described below, the preferable form thereof is also the same, and * is a bonding site to another structure. An alkyl group that may contain at least one of -O-, -S-, or -$NR^{D3}$- is preferably $C_{1-30}$-alkyl and more preferably $C_{1-20}$-alkyl. $R^{D3}$ has the same meaning as $R^{D3}$ in Formula (D-1), and preferable forms thereof are also the same.

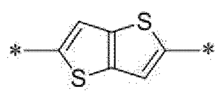
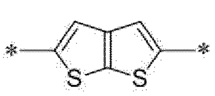
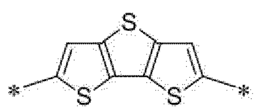
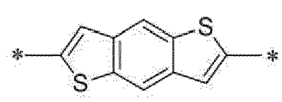

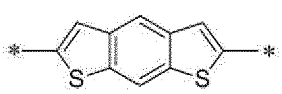
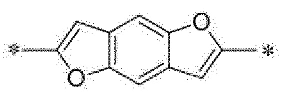
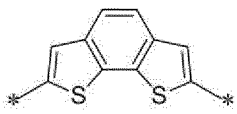
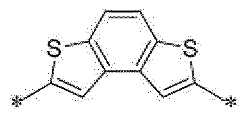

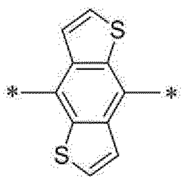
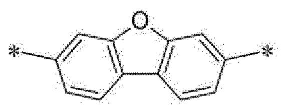
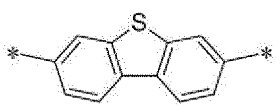

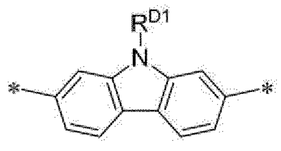 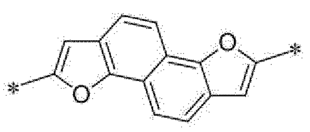 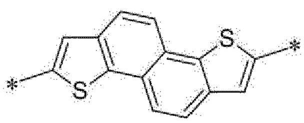

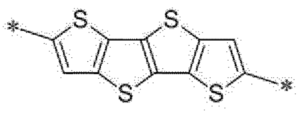 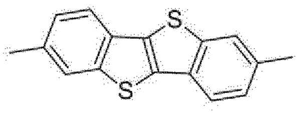 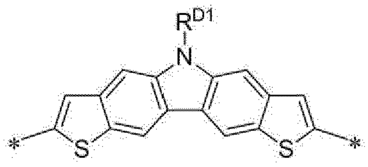

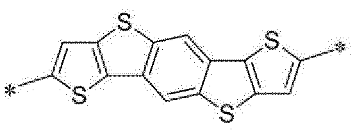 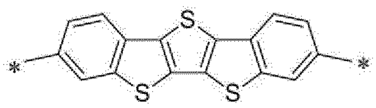 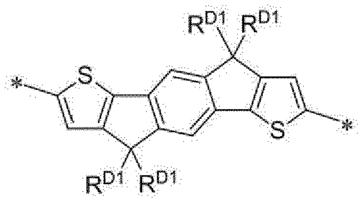

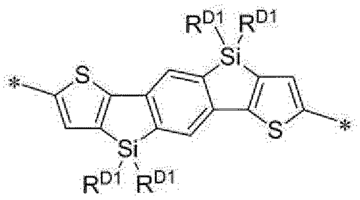 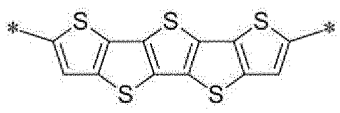 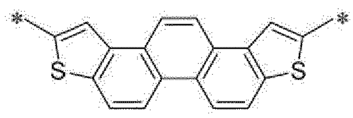

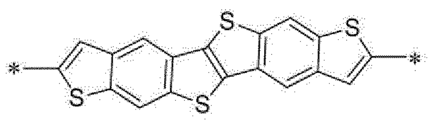 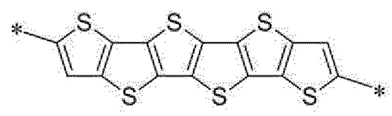

The aromatic hydrocarbon group consisting of a fused ring structure having two or more rings is preferably an aromatic $C_{1-20}$-hydrocarbon group, more preferably fluorene, naphthylene or a group obtained by removing two H from the aromatic hydrocarbon group in which three or four rings are fused, and even more preferably fluorene, naphthylene or a group obtained by removing two H from an anthracene, phenanthrene, chrysene or pyrene ring.

The aromatic hydrocarbon group may further have a substituent, and preferable examples of the substituent include an alkyl group that may contain at least one of -O-, -S-, or -$NR^{D3}$-, a halogen atom, or a monovalent group of Formula (1-1). Preferable examples of the alkyl group that may contain at least one of -O-, -S-, or -$NR^{D3}$- and the halogen atom are the same as those described for the divalent aromatic heterocyclic group. $R^{D3}$ has the same meaning as $R^{D3}$ in Formula (D-1), and preferable forms thereof are also the same.

In Formula (1), D preferably has a structure of Formula (D-1).

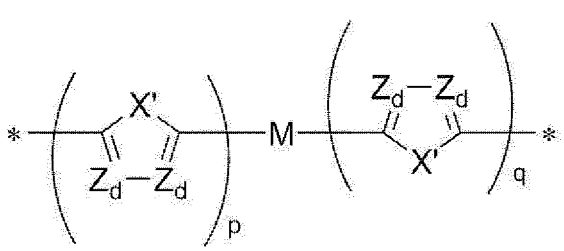 (D-1)

In Formula (D-1), X"s each independently represent an O atom, a S atom, a Se atom, or $NR^{D1}$. $R^{D1}$'s each independently represent a monovalent organic group that may be a monovalent group of Formula (1-1). Za's each independently are N or $CR^{D2}$. $R^{D2}$'s each independently are H or a monovalent organic group that may be a monovalent group of Formula (1-1). M is a single bond, a divalent aromatic heterocyclic group, a divalent aromatic hydrocarbon group, an alkenylene group, an alkynylene group, or a divalent group obtained by combining these. M may be substituted with an alkyl group that may include at least one of -O-, -S-, or -$NR^{D3}$- or a monovalent group of Formula (1-1). $R^{D3}$'s each independently are H or a substituent. p and q each independently are an integer of 0-4, and *'s each independently

represent a bonding site to another structure.

In Formula (D-1), each repeating unit and M described above are bonded to each other at the bonding axis in a rotatable manner.

In Formula (D-1), X"s each independently are O, S, Se or $NR^{D1}$, preferably O, Se or S, and more preferably S.

$Z_d$'s each independently are N or $CR^{D2}$ and more preferably is $CR^{D2}$.

$R^{D1}$'s each independently are a monovalent organic group, preferably alkyl which may contain at least one of -O-, -S-, or $-NR^{D3}-$ (for example, $C_{1-30}$-alkyl or $C_{1-30}$-alkoxy g is preferable, and $C_{1-20}$-alkyl is more preferable), alkynyl (preferably having 2-30 carbon atoms), alkenyl (preferably having 2-30 carbon atoms), an aromatic hydrocarbon group (preferably having 6-30 carbon atoms), an aromatic heterocyclic group (preferably 5- to 7-membered ring, O, N, S, Se is preferable as the hetero atom), halogen (preferably F, Cl, Br or I, more preferably F or Cl, and particularly preferably F), and a monovalent group of Formula (1-1), more preferably is alkyl, halogen and a monovalent group of Formula (1-1).

$R^{D2}$'s each independently are H or a monovalent organic group, preferably are H, alkyl which may contain at least one of -O-, -S-, or $-NR^{D3}-$ (for example, $C_{1-30}$-alkyl or $C_{1-30}$-alkoxy is preferable, and $C_{1-20}$-alkyl is more preferable), alkynyl (preferably having 2-30 carbon atoms), alkenyl (preferably having 2-30 carbon atoms), an aromatic hydrocarbon group (preferably having 6-30 carbon atoms), an aromatic heterocyclic group (preferably 5- to 7-membered ring, O, N, S, Se is preferable as the hetero atom), halogen (preferably F, Cl, Br or I, more preferably F or Cl, and particularly preferably F), and a monovalent group of Formula (1-1), more preferably i sH, alkyl, halogen or a monovalent group of Formula (1-1).

M represents a single bond, a divalent aromatic heterocyclic group, a divalent aromatic hydrocarbon group, an alkenylene group, an alkynylene group, or a divalent group obtained by combining these. M may be substituted with an alkyl group that may include at least one of -O-, -S-, or $-NR^{D3}-$ or a monovalent group of Formula (1-1).

The divalent aromatic heterocyclic group in M may have a single ring or may have a fused ring structure having two or more rings. Examples of the divalent aromatic heterocyclic group preferably used in the present invention are the same as those of the above divalent aromatic heterocyclic group having a fused ring structure having two or more rings.

The divalent aromatic hydrocarbon group in M is preferably an aromatic $C_{6-20}$-hydrocarbon group, more preferably phenylene, biphenylene, fluorene, naphthylene or a group obtained by removing two H from aromatic hydrocarbon in which three or four rings are fused, and even more preferably fluorene, naphthylene, an anthracene, phenanthrene or, chrysene or a group obtained by removing two or more H from a pyrene ring.

The divalent aromatic heterocyclic group or the divalent aromatic hydrocarbon group in M may further have a substituent, and preferable examples of the substituents include alkyl that may include at least one of -O-, -S-, or $-NR^{D3}-$ (for example, $C_{1-30}$-alkyl group or $C_{1-30}$-alkoxy is preferable, and $C_{1-20}$-alkyl is more preferable), halogen (preferably F, Cl, Br or I, more preferably F or Cl, and particularly preferably F), and a monovalent group of Formula (1-1).

An alkenylene group in M is preferably $C_{2-10}$-alkenylene, more preferably $C_{2-4}$-alkenylene, and even more preferably ethenylene.

An alkynylene group in M is preferably $C_{2-10}$-alkynylene, more preferably $C_{2-4}$-alkynylene, and even more preferably ethynylene.

$R^{D3}$'s each independently are H or a substituent, The substituent in $R^{D3}$ has the same meaning as the substituents in $R^{1S}$ and $R^{2S}$ described below.

p and q each independently are an integer of 0-4, preferably an integer of 1-3, and more preferably an integer of 1-2. It is preferable that p and q have the same value. It is preferable that p+q is 2-4.

Here, in a case where p+q is 0, M is preferably includes a divalent aromatic heterocyclic group having at least one of N, O, S or Se in a ring structure or a divalent aromatic hydrocarbon group including a fused ring structure having two or more rings, as a partial structure.

Examples of the structure D are provided below, but the present invention is not limited to the following examples. In the structural formula, the hydrogen atom may be substituted with an alkyl group that may include at least one of -O-, -S-, or $-NR^{D3}-$ or the group of Formula (1-1), $R^{D1}$ has the same meaning as $R^{D1}$ in Formula (D-1) described above, the preferable form thereof is also the same, and * is a bonding site to another structure. The alkyl group that may contain at least one of -O-, -S-, or $-NR^{D3}-$, is preferably $C_{1-30}$-alkyl or $C_{1-30}$-alkoxy and more preferably $C_{8-30}$-alkyl. $R^{D3}$ has the same meaning as $R^{D3}$ in Formula (D-1), and preferable forms thereof are also the same.

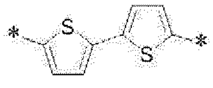
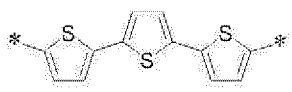
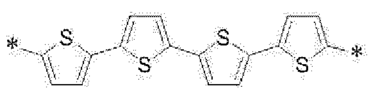

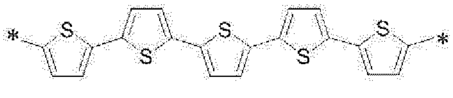
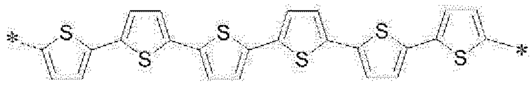

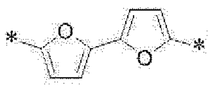
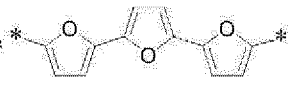
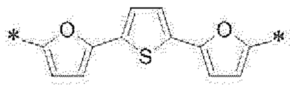
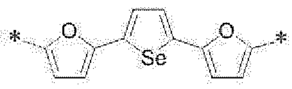

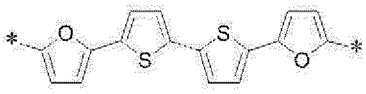
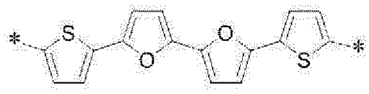

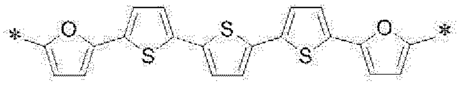
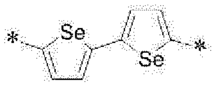
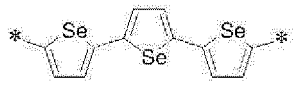

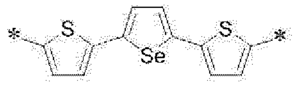
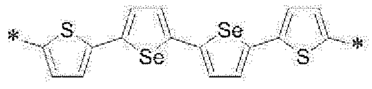
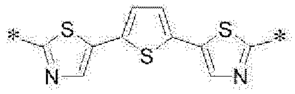

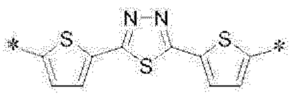
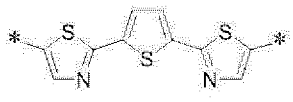
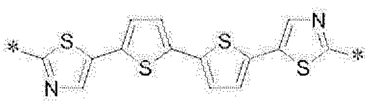

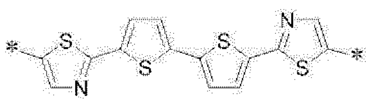
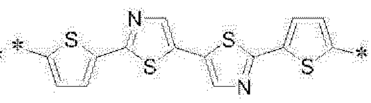
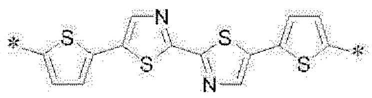

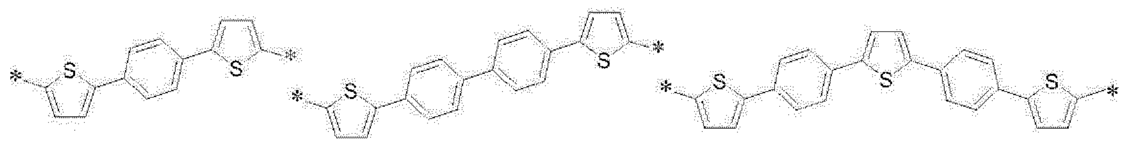

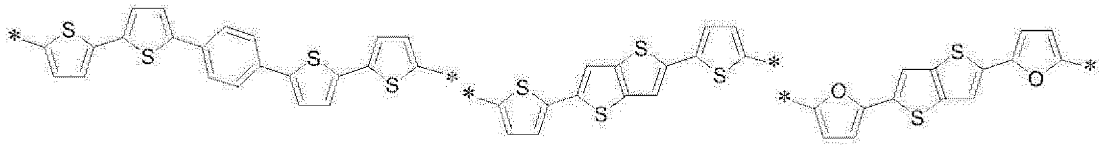

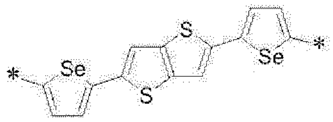
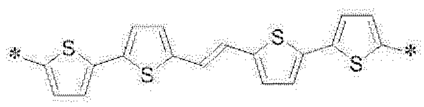

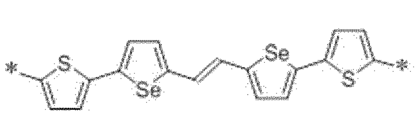
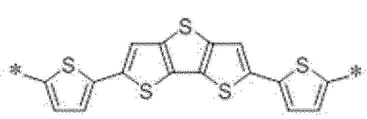

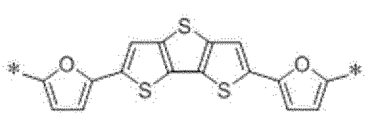
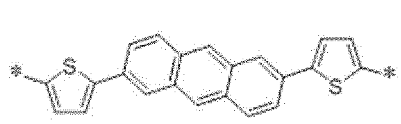

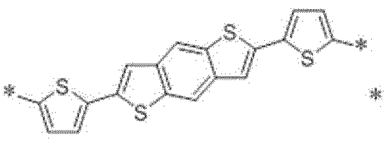
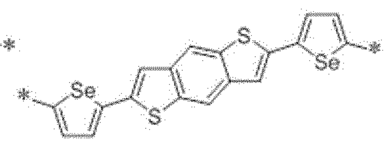
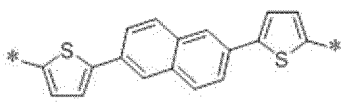

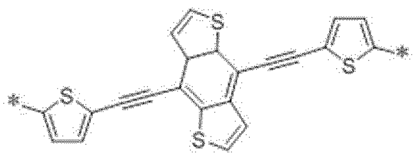
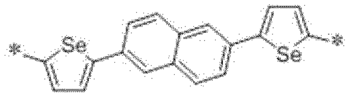

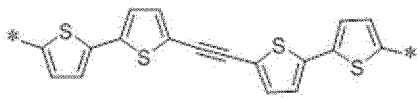
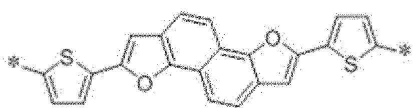

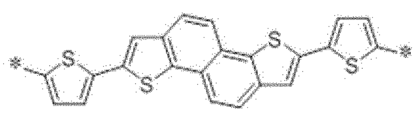
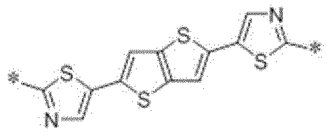

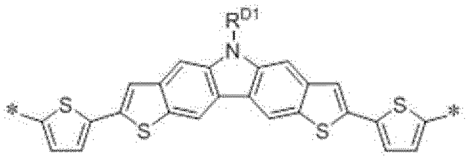
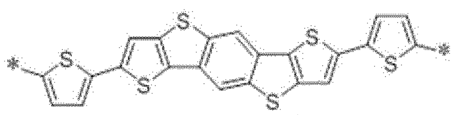

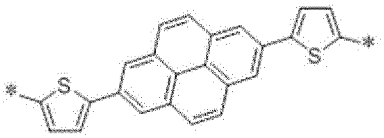
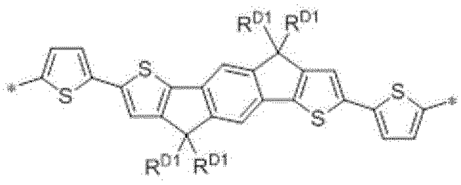

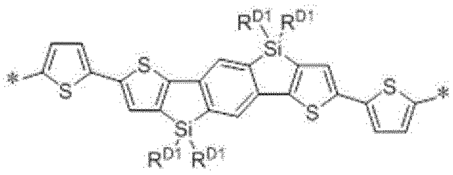
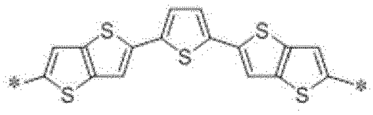

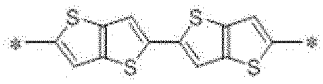
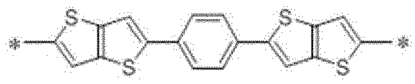

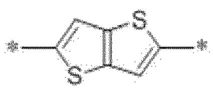
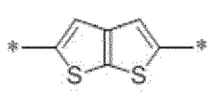
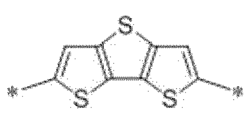
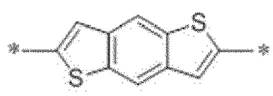

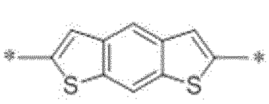
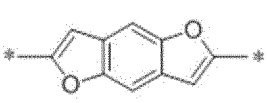
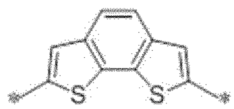
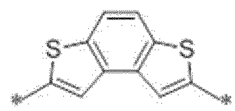

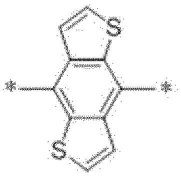
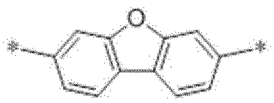
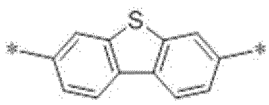
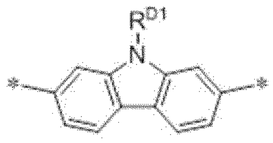
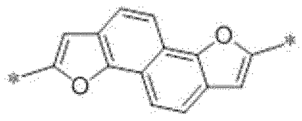
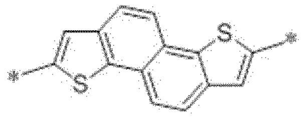
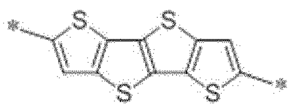
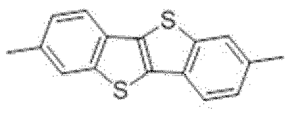
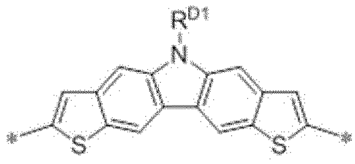
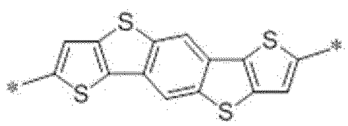
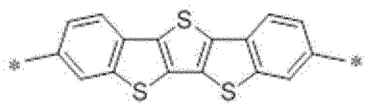
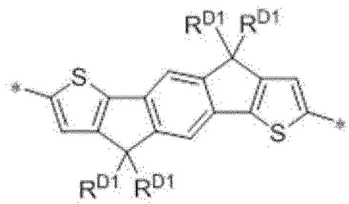
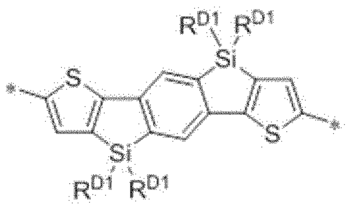
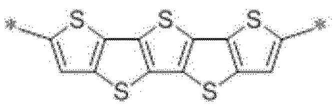
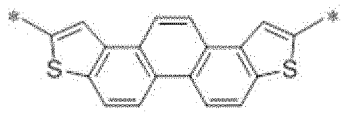
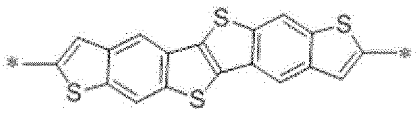
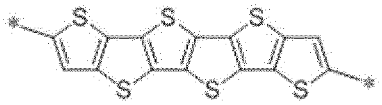
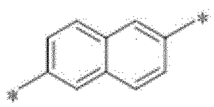
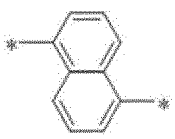
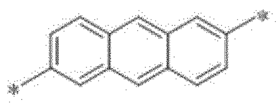
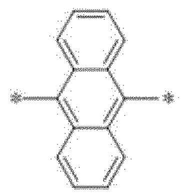
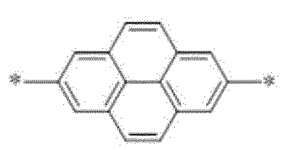
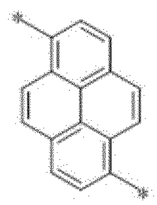

(Repeating unit of Formulae (2)-(5))

The repeating unit of Formula (1) is preferably a repeating unit of any one of Formulae (2)-(5), more preferably a repeating unit of Formula (2), (3), or (4), even more preferably a repeating unit of any one of Formula (2) or (3), and particularly preferably a repeating unit of Formula (3).

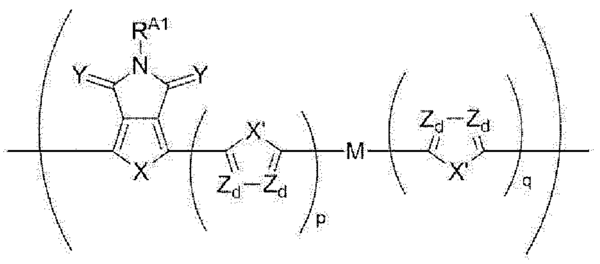
(2)

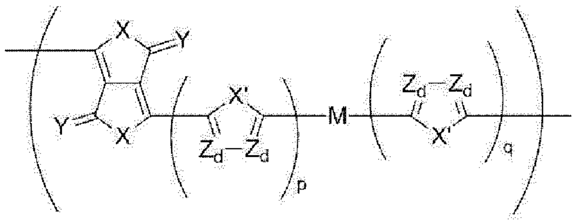
(3)

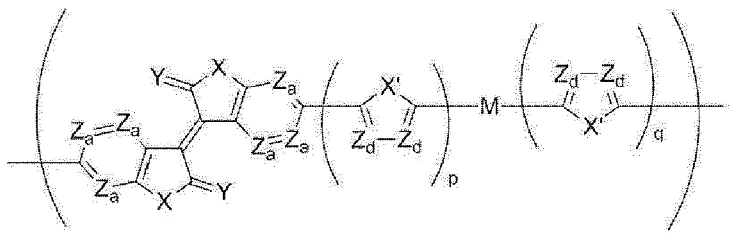
(4)

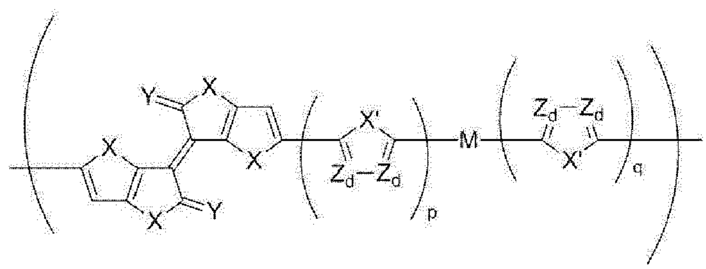
(5)

In Formulae (2) to (5), X's each independently is O, S, Se or $NR^{A1}$.

$R^{A1}$'s each independently are a bonding site to an alkyl group that may include at least one of -O-, -S-, or $-NR^{A3}-$, a monovalent group of Formula (1-1), or another structure.

Y's each independently are O or S.

$Z_a$'s each independently are $CR^{A2}$ or N. $R^{A2}$'s each independently are a bonding site to an alkyl group that may include at least one of H, halogen, -O-, -S-, or $-NR^{A3}-$, or another structure. $R^{A3}$'s each independently are H or a substituent. X"s each independently are O, S, Se or $NR^{D1}$. $R^{D1}$'s each independently are a monovalent organic group that may be a monovalent group of Formula (1-1). Za's each independently are N or $CR^{D2}$. $R^{D2}$'s each independently are a hydrogen atom or a monovalent organic group that may be a monovalent group of Formula (1-1). M represents a single bond, a divalent aromatic heterocyclic group, a divalent aromatic hydrocarbon group, an alkenylene group, an alkynylene group, or a divalent group obtained by combining these. M may be substituted with alkyl that may include at least one of -O-, -S-, or $-NR^{D3}-$ or a monovalent group of Formula (1-1). $R^{D3}$'s each independently are H or a substituent. p and q each independently are an integer of 0-4.

X, Y, $Z_a$, $R^{A1}$, $R^{A2}$, and $R^{A3}$ in Formulae (2) to (5) are the same as X, Y, $Z_a$, $R^{A1}$, $R^{A2}$, and $R^{A3}$ in Formulae (A-1) to (A-12), and preferably forms thereof are also the same.

X', $Z_d$, $R^{D1}$, $R^{D2}$, $R^{D3}$, M, p, and q in Formula (2) to (5) are the same as X', $Z_d$, $R^{D1}$, $R^{D2}$, $R^{D3}$, M, p, and q in Formula (D-1), and preferably forms thereof are also the same.

(Preferable forms of specific organic semiconductor compound)

In the specific organic semiconductor compound, the content of the repeating unit of Formula (1)s is preferably 60-100 mass%, more preferably 80-100 mass%, and even more preferably 90-100 mass% with respect to the total mass of the specific organic semiconductor compound. It is particularly preferable that the constitutional repeating unit is substantially formed only with the repeating unit of Formula (1). The expression "the repeating unit is substantially formed only with the repeating unit of Formula (1)" means that the content of the repeating unit of Formula (1) is ≥ 95 mass%, preferably ≥ 97 mass%, and more preferably ≥ 99 mass%.

In a case where the content of the repeating unit of Formula (1) is in the range above, an organic semiconductor layer having excellent carrier mobility can be obtained.

The specific organic semiconductor compound may include a repeating unit of Formula (1) singly or two or more kinds thereof may be included.

The specific organic semiconductor compound is a compound having two or more repeating units of Formula (1) and may be an oligomer in which the number "n" of repeating units is 2-9 or may be a polymer in which the number "n" of constitutional repeating units is ≥ 10. Among these, a polymer in which the number "n" of repeating units is ≥ 10 is preferable, in view of carrier mobility and obtainable physical properties of the organic semiconductor layer.

In view of carrier mobility, the molecular weight of the compound having a repeating unit of Formula (1) is ≥ 2,000, preferably ≥ 5,000, more preferably ≥ 10,000, even more preferably ≥ 20,000, and particularly preferably ≥ 30,000. In view of solubility, the molecular weight is preferably ≤ 1,000,000, more preferably ≤ 300,000 s, even more preferably ≤ 150,000, and particularly preferably ≤ 100,000.

According to the present invention, in a case where the specific organic semiconductor compound has a molecular weight distribution, the molecular weight of this compound means a weight-average molecular weight.

According to the present invention, the weight-average molecular weight and the number-average molecular weight of the specific organic semiconductor compound can be measured by gel permeation chromatography (GPC) method, and can be obtained in terms of standard polystyrene. Specifically, for example, GPC is performed by using HLC-8121GPC (manufactured by Tosoh Corporation), using two items of TSKgel GMHHR-H (20) HT (manufactured by Tosoh Corporation, 7.8 mmID×30 cm) as columns, and using 1,2,4-trichlorobenzene as an eluant. GPC is performed by using an infrared (IR) detector under the conditions in which the sample concentration is 0.02 mass%, the flow rate is 1.0 ml/min, the sample injection amount is 300 μl, and the measurement temperature is 160°C. The calibration curve is manufactured from 12 samples of "standard sample TSK standard, polystyrene": "F-128", "F-80", "F-40", "F-20", "F-10", "F-4", "F-2", "F-1", "A-5000", "A-2500", "A-1000", and "A-500" manufactured by Tosoh Corporation.

Although only one kind of specific organic semiconductor compound may be contained or two or more kinds of specific organic semiconductor compounds may be contained in the organic semiconductor layer.

The structure of the terminal of the specific organic semiconductor compound is not particularly limited, and depends on the existence of other constitutional units, kinds of base substances used in the synthesis, and kinds of a quench agent (reaction terminator) used in the synthesis. Here, examples thereof include H, OH, halogen, an ethylenically unsaturated group, alkyl, an aromatic heterocyclic group (preferably a thiophene ring), and an aromatic hydrocarbon group (preferably a benzene ring).

A method of synthesizing a specific organic semiconductor compound is not particularly limited, and may be synthesized with reference to well-known methods. For example, with reference to JP-A-2010-527327, JP-A-2007-516315, JP-A-2014-515043, JP-A-2014-507488, JP-A-2011-501451, JP-A-2010-18790, WO 2012/174561, JP-A-2011-514399 and JP-A-2011-514913, synthesis may be performed by synthesizing a precursor of an electron acceptor unit and a precursor of an electron donor unit and performing cross-coupling reactions such as Suzuki coupling and Stille coupling of each precursor.

Hereinafter, preferable specific examples of the preferable repeating unit of Formula (1) are provided, but the present invention is not limited to the examples below.

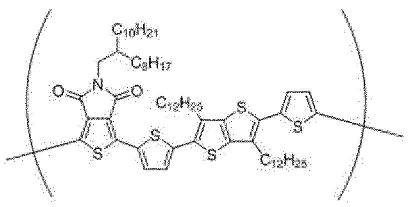

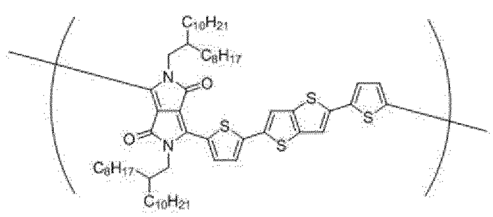

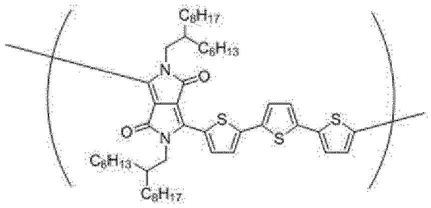

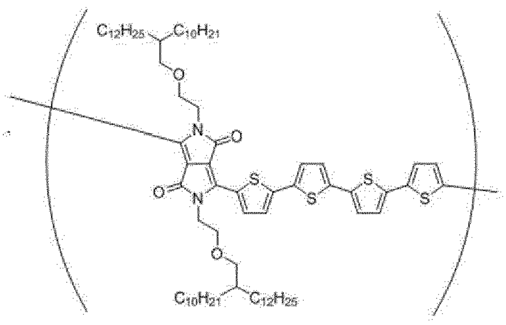

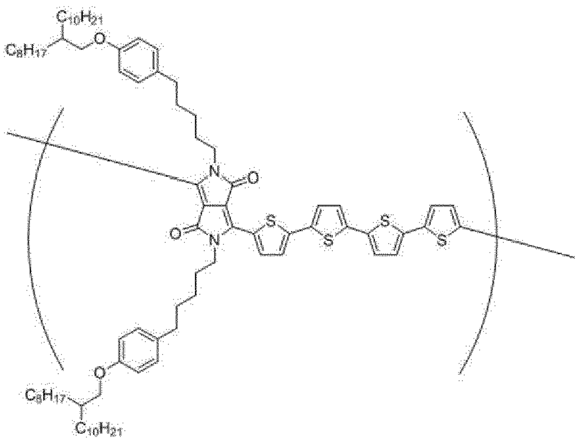

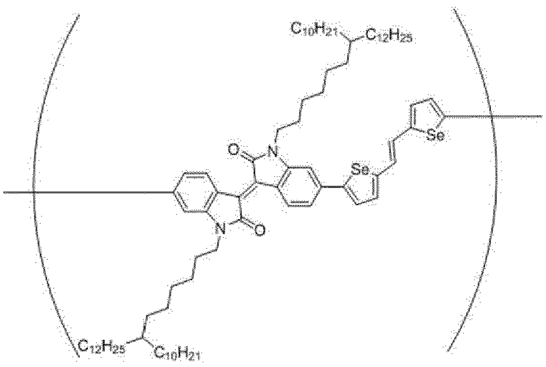

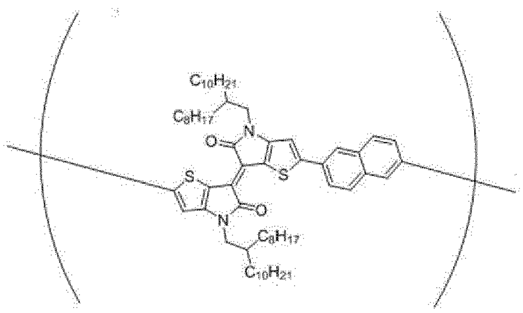

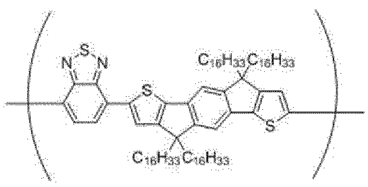

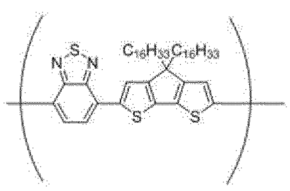

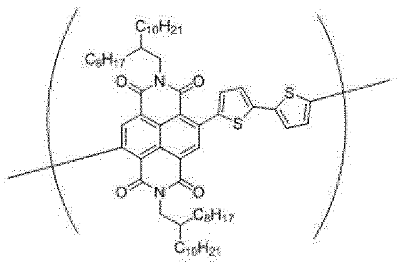

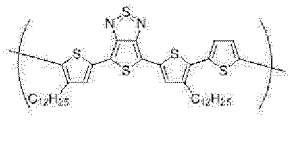

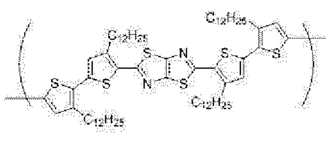

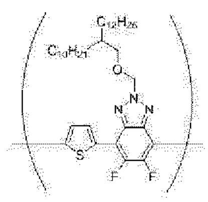

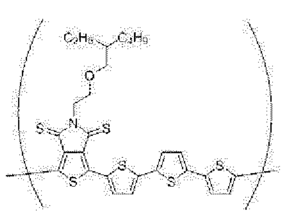
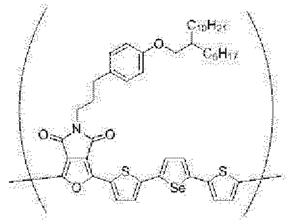
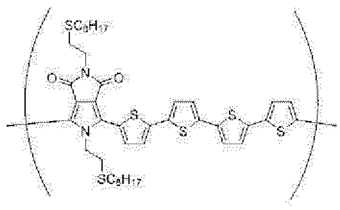

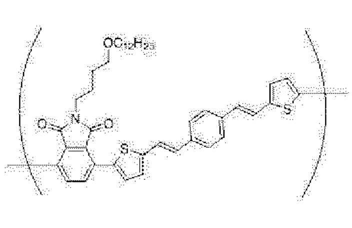
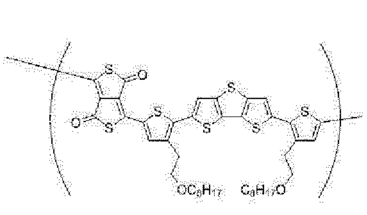
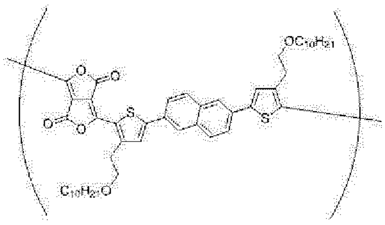

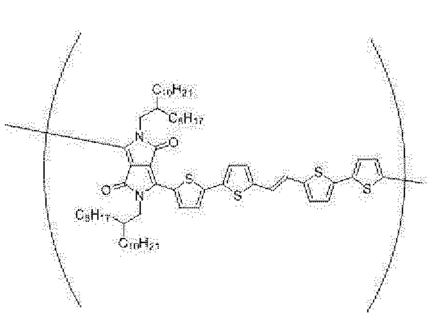
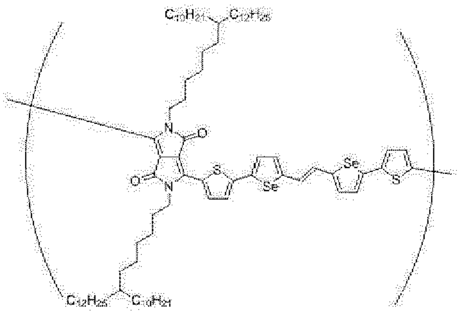

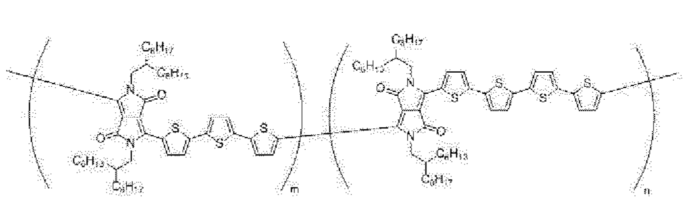

m:n=0.2/0.8
random copolymer

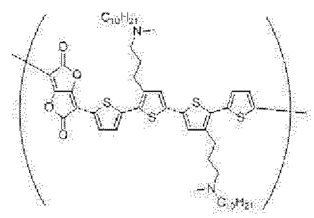

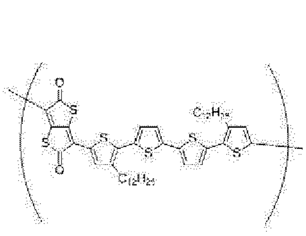
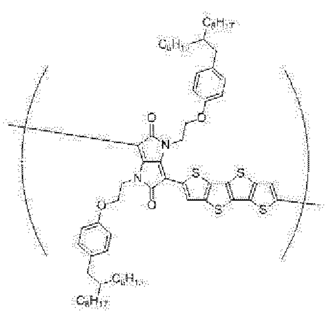
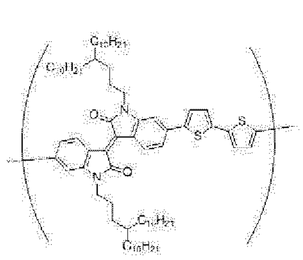

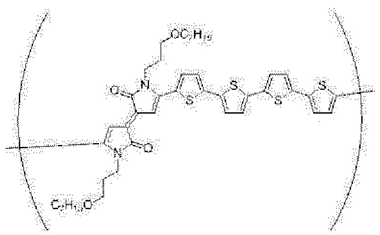

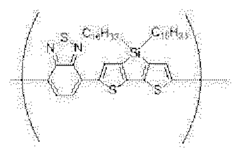

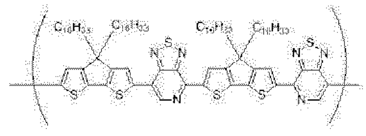

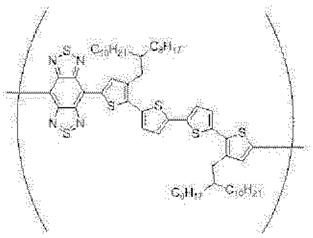

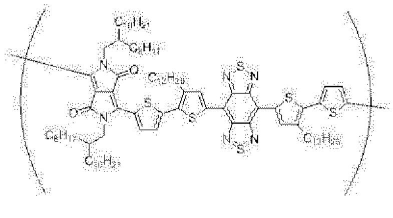

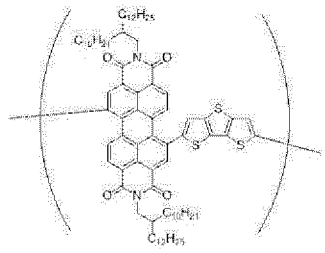

In a case where the organic semiconductor layer is formed on the gate insulating layer in a wet method (wet coating method), it is easy to obtain the OTFT with high performance at low cost in a simple way, and it is also suitable for causing the OTFT to have a large area. The method of forming the organic semiconductor layer is preferably a wet method.

The wet method is not particularly limited, and the organic semiconductor layer can be formed by applying the coating solution (mixed solution) including the organic semiconductor compound by a spin coating method, an ink jet method, nozzle printing, stamp printing, screen printing, gravure printing, and an electrospray deposition method and drying the coating solution.

In the case where the organic semiconductor layer is formed on the gate insulating layer by a wet coating method, since the OTFT tends to have high performance, it is preferable that the organic semiconductor layer is subjected to a crystallization treatment and it is particularly preferable that a crystallization treatment by heating or laser irradiation is performed.

The method of the crystallization treatment is not particularly limited, but examples thereof include heating with a hot plate or oven and laser irradiation. With respect to the heating temperature, a high temperature is preferable since crystallization easily proceeds, and, on the other hand, a low temperature is preferable since the substrate is hardly influenced by the heat. Specifically, the heating temperature is preferably ≥ 50°C, particularly preferably ≥ 100°C, and meanwhile, the heating temperature is preferably ≤ 300°C and particularly preferably ≤ 250°C.

The film thickness of the organic semiconductor layer is arbitrary, but is preferably 1 nm or greater and more preferably 10 nm or greater. The film thickness is preferably ≤ 10 μm, more preferably ≤ 1 μm, and particularly preferably ≤ 500 nm.

<Source electrode and drain electrode>

In the OTFT of the present invention, the source electrode is an electrode to which a current flows from the outside through wiring. The drain electrode is an electrode which sends a current to the outside through wiring and is generally provided to be in contact with the organic semiconductor layer.

As the material of the source electrode and the drain electrode, a conductive material that is used for the organic thin film transistor in the related art, and examples thereof include the conductive material described in the gate electrode.

The source electrode and the drain electrode each can be formed by the same method as the method of forming the gate electrode.

As the photolithography method, a lift-off method or an etching method can be employed.

Particularly, since the gate insulating layer has excellent resistance to an etchant or a peeling solution, the source electrode and the drain electrode can be suitably formed by an etching method. The etching method is a method of forming a layer with a conductive material and removing unnecessary portions by etching. In a case where patterning is performed by an etching method, a resist residue and a removed conductive material obtained by peeling of the conductive material remaining on the base material in a case of resist removal can be prevented from re-adhering to the substrate, and a shape of the electrode edge portion is excellent. In this point of view, a lift-off method is preferable.

The lift-off method is a method of applying a resist to a portion of the base material, forming a film with a conductive material on the base material, eluting or peeling off the resist with a solvent so as to remove the conductive

material on the resist, and thus form a film of the conductive material only in a portion to which the resist is not applied.

The thickness of the source electrode and the drain electrode is arbitrary, but is preferably ≥ 1 nm and particularly preferably ≥ 10 nm. The thickness is preferably ≤ 500 nm and particularly preferably ≤ 300 nm.

An interval (channel length) between the source electrode and the drain electrode is arbitrary, but is preferably ≤ 100 μm and particularly preferably ≤ 50 μm. The channel width is preferably ≤ 5,000 μm and particularly preferably ≤ 1,000 μm.

<Overcoat layer>

The OTFT of the present invention may have an overcoat layer. The overcoat layer is generally a layer formed as a protective layer on the surface of the OTFT. The overcoat layer may have a single layer structure or a multilayer structure.

The overcoat layer may be an organic overcoat layer or may be an inorganic overcoat layer.

The material for forming the organic overcoat layer is not particularly limited, but examples thereof include polystyrene, an acrylic resin, polyvinyl alcohol, polyolefin, polyimide, polyurethane, polyacetylene, an organic polymer such as an epoxy resin, and derivatives obtained by introducing a crosslinkable group or a water repellent group into these organic polymers. These organic polymers or derivatives thereof can be used in combination with e.g. a crosslinking component, a fluorine compound or a silicon compound.

The material for forming the inorganic overcoat layer is not particularly limited, but examples thereof include metal oxide such as silicon oxide and aluminum oxide and metal nitride such as silicon nitride.

These materials may be used singly or two or more kinds thereof may be used together in an arbitrary combination and ratio.

The method of forming the overcoat layer is not limited, and the overcoat layer can be formed by various well-known methods.

For example, the organic overcoat layer can be formed, for example, by a method of applying a solution including a material to be the overcoat layer to a layer to be a base material thereof and drying the solution, and a method of applying a solution including a material to be the overcoat layer, drying the solution, and performing patterning by exposure and development. The patterning of the overcoat layer can be directly formed by a printing method or an ink jet method. After the patterning of the overcoat layer, the overcoat layer may be crosslinked by exposure or heating.

The inorganic overcoat layer can be formed by a dry method such as a sputtering method and an evaporation method and a wet method such as a sol-gel method.

<Other layers>

The OTFT of the present invention may be provided with a layer or a member, in addition to the above.

Examples of the other layers or members include a bank. The bank is used for the purpose of blocking the discharged liquid at a predetermined position in a case where e.g. a semiconductor layer or an overcoat layer is formed by e.g. an inkjet method. Therefore, the bank usually has liquid repellency. Examples of the method of forming the bank include a method of performing a liquid repellent treatment such as a fluorine plasma method after patterning by a photolithography method and a method of curing a photosensitive composition containing a liquid repellent component such as a fluorine compound.

In a case where the gate insulating layer is an organic layer in the organic thin film transistor of the present invention, the latter method of curing the photosensitive composition containing the liquid repellent component is preferable because it is less likely that the gate insulating layer is affected by the liquid repellent treatment. A technique of causing the base material to have the liquid repellency contrast and to have a function of the bank without using the bank may be used.

<Manufacturing method>

The method of the present invention (hereinafter, referred to as the present method) of manufacturing the organic thin film transistor is not particularly limited, but includes a step of applying a mixed solution containing the specific organic semiconductor compound and the resin (C).

In the present method, an organic semiconductor layer 1 containing the specific organic semiconductor compound and the resin (C) can be obtained by applying the mixed solution containing the specific organic semiconductor compound and resin (C) to a substrate 6 or a gate insulating layer 2, forming a film, and drying this film.

In the present method, it is possible to obtain an organic thin film transistor including the organic semiconductor layer 1 obtained by phase-separating or unevenly distributing the specific organic semiconductor compound and the resin (C).

The organic semiconductor layer (organic semiconductor film) including the specific organic semiconductor compound and the resin (C) can be obtained by using the mixed solution (organic semiconductor composition) containing the specific organic semiconductor compound and the resin (C).

In this manner, in a case where the specific organic semiconductor compound and the resin (C) are caused to exist together in the organic semiconductor layer, the carrier mobility of the organic thin film transistor can be effectively increased. The reason is not clear, but it is considered that one reason is that, in a case where the organic semiconductor compound and the resin (C) exist together, compared with a case where the organic semiconductor compound singly exist, array regularity of the organic semiconductor compound is enhanced. It is presumed that, carrier diffusion generated due to fluctuation of the structure in the main chain of the organic semiconductor compound is suppressed according to this increase of the array regularity, or popping of carriers between chains of the organic semiconductor compound is improved.

The reason of improving array regularity is presumed as follows. That is, it is considered that, in a state of the mixed solution (organic semiconductor composition) in which the specific organic semiconductor compound and the resin (C) exist together, both exist in state in which both are suitably compatible with each other, such that, in a case where the solvent is dried from the state and the state is changed to a film state, the phase separation is promoted, and a domain of the specific organic semiconductor compound and a domain of the resin (C) are separately formed. It is considered that the speed in a case of forming these domains and the degree of phase separation are related to the control of the array regularity, and it is considered that the combination of the specific organic semiconductor compound and the resin (C) is suitable and thus the mobility is improved.

The mixed solution may contain other components in addition to the specific organic semiconductor compound and the resin (C). Examples thereof include the resin including the copolymer, a self-assembled compound such as a silane coupling agent, and a surfactant, in addition to the resin (C).

The mixed solution preferably contains a solvent. This solvent is not particularly limited, as long as the specific organic semiconductor compound and the resin (C) can be dissolved or dispersed in the solvent. Examples thereof include an organic solvent, water, and a mixed solvent thereof.

Examples of the organic solvent include a hydrocarbon-based solvent such as hexane, octane, decane, toluene, xylene, mesitylene, ethylbenzene, tetralin, decalin, and 1-methylnaphthalene, a ketone-based solvent such as acetone, methyl ethyl ketone, methyl isobutyl ketone, and cyclohexanone, a halogenated hydrocarbon-based solvent such as dichloromethane, chloroform, tetrachloromethane, dichloroethane, trichloroethane, tetrachloroethane, chlorobenzene, dichlorobenzene, and chlorotoluene, an ester-based solvent such as ethyl acetate, butyl acetate, and amyl acetate, an alcohol solvent such as methanol, propanol, butanol, pentanol, hexanol, cyclohexanol, methyl cellosolve, ethyl cellosolve, and ethylene glycol, an ether-based solvent such as propylene glycol monomethyl ether acetate (PGMEA), dibutyl ether, tetrahydrofuran, dioxane, and anisole, an amide-imide-based solvent such as N,N-dimethylformamide, N,N-dimethylacetamide, 1-methyl-2-pyrrolidone, and 1-methyl-2-imidazolidinone, a sulfoxide-based solvent such as dimethylsulfoxide, and a nitrile-based solvent such as acetonitrile and benzonitrile.

The organic solvent may be used singly or two or more kinds thereof may be used in combination. As the organic solvent, propylene glycol monomethyl ether acetate (PGMEA), toluene, xylene, mesitylene, tetralin, methyl ethyl ketone, cyclopentanone, dichloromethane, chloroform, chlorobenzene, dichlorobenzene, anisole, and benzonitrile are particularly preferable.

All of the total solid content concentrations in the mixed solution and the respective coating solutions are preferably 0.01-20 mass%, more preferably 0.1-10 mass%, and particularly preferably 0.2-5 mass%.

In a case where the resin (D) is contained, the total content of the resin (C) and the resin (D) in the coating solution (or mixed solution) is preferably 1-80 mass%, more preferably 5-60 mass%, and even more preferably 10-50 mass% with respect to the total solid content of the coating solution (or mixed solution).

The content of the specific organic semiconductor compound in the coating solution (or the mixed solution) is preferably 20-99 mass%, more preferably 40-95 mass%, and even more preferably 50-90 mass% with respect to the total solid content of the coating solution (or the mixed solution).

In the present method, a mixed solution is used. The mixed solution is applied to the substrate or the gate insulating layer according to the structure of the OTFT to be manufactured. That is, in a case where the OTFT in a bottom gate structure is manufactured, the gate electrode and the gate insulating layer are provided on the substrate, and the mixed solution is applied to this gate insulating layer. Meanwhile, in a case where the OTFT in the top gate structure is manufactured, the mixed solution is applied to a substrate (in the bottom contact structure, the source electrode and the drain electrode further provided on the substrate).

The method of applying the mixed solution is not particularly limited, and the above method can be employed. Among these, a printing method is preferable, and a flexo printing method or a spin coating method is more preferable.

The coating condition is not particularly limited. The coating may be performed near the room temperature, and the coating may be performed in a heated state to add solubility of the respective components to the coating solvent. The heating temperature is preferably 15-150°C, more preferably 15-100°C, even more preferably 15-50°C, and particularly preferably near room temperature (20-30°C).

In the spin coating method, it is preferable to set the rotation speed to 100-3000 rpm.

In the present method, the applied mixed solution is preferably dried. The drying condition may be a condition of volatilizing or removing the solvent, and examples thereof include methods such as room temperature standing, heat drying, blast drying, and drying under reduced pressure.

In the present method, in a case where the mixed solution is applied and dried, the resin (C) and the organic semiconductor are unevenly distributed or phase-separated from each other.

Accordingly, in the present method, a special treatment for unevenly distributing or phase-separating the resin (C) and the organic semiconductor is not necessary, but may be performed. Examples of this treatment include annealing by heating (preferably heating to a Tg of the resin or higher) and exposure to solvent vapor (solvent annealing).

The gate electrode, the gate insulating layer, the source electrode, and the drain electrode can be formed or provided by the above method.

<Application of OTFT>

The OTFT is preferably mounted on the display panel and used. Examples of the display panel include a liquid crystal panel, an organic EL panel, and an electronic paper panel.

Examples

Hereinafter, the present invention is specifically described with reference to examples. However, the present invention is not limited thereto.

<Resin (C)>

As the resin (C), resins described below were respectively used.

The weight-average molecular weight (Mw, standard polystyrene equivalent) and a dispersion degree (Pd=Mw/Mn) of each resin were measured by using gel permeation chromatography (GPC, manufactured by Tosoh Corporation; HLC-8120; Tskgel Multipore HXL-M) and using tetrahydrofuran (THF) as a solvent.

Compositional ratios of the respective resins were calculated by using a nuclear magnetic resonance (NMR) determination device (manufactured by Bruker Corporation; AVANCE III 400 type) by $^{1}H$-NMR or $^{13}C$-NMR.

The surface energy of each resin was measured as above.

The obtained results are provided below. The unit of the surface energy is $mNm^{-1}$.

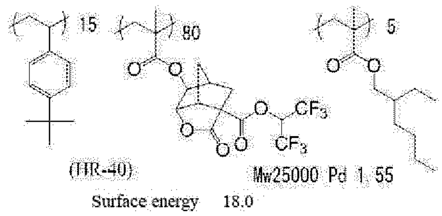

(HR-40) Mw25000 Pd 1.55
Surface energy 18.0

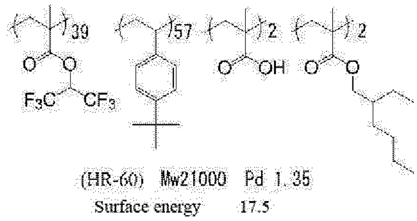

(HR-60) Mw21000 Pd 1.35
Surface energy 17.5

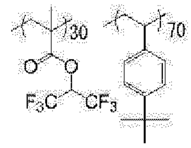

(HR-24) Mw34000 Pd 1.68
Surface energy 17.5

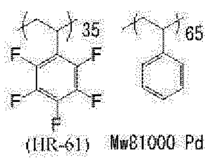

(HR-61) Mw81000 Pd 1.95
Surface energy 24.9

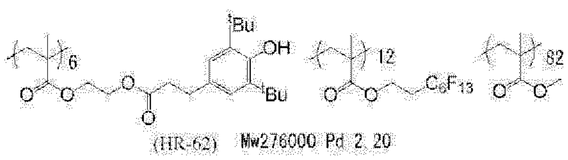

(HR-62) Mw276000 Pd 2.20
Surface energy 13.8

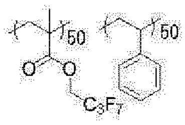

(HR-14) Mw25300 Pd1.68
Surface energy 16.5

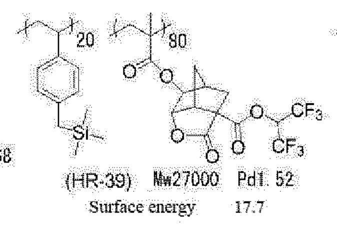

(HR-39) Mw27000 Pd1.52
Surface energy 17.7

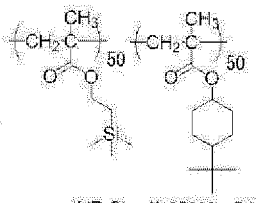

(HR-9) Mw35900 Pd1.80
Surface energy 26.8

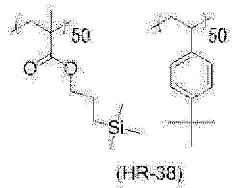

(HR-38)
Mw38000 Pd1.56
Surface energy 25.0

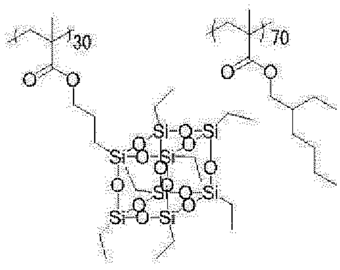

(HR-51) Mw150000 Pd2.56

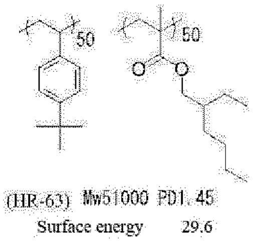

(HR-63) Mw51000 PD1.45
Surface energy 29.6

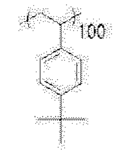

(HR-64) Mw51000 PD1.42
Surface energy 31.2

The resin (HR-40) was synthesized by the following scheme.

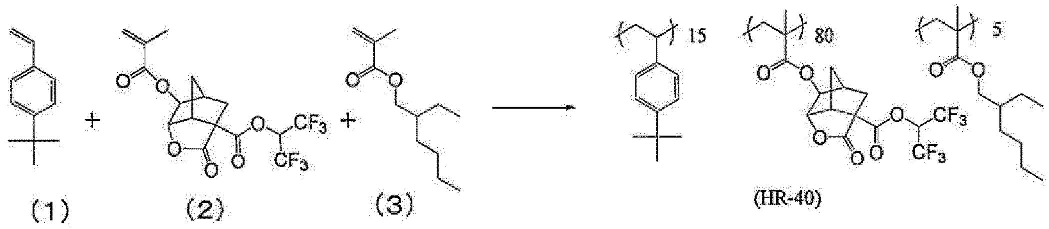

(1) (2) (3) (HR-40)

1.20 g (7.5 mmol) of a compound (1), 16.69 g (40 mmol) of a compound (2), 0.46 g (2.5 mmol) of a compound (3), and 0.69 g of a polymerization initiator V-601 (manufactured by Wako Pure Chemical Industries, Ltd.) were dissolved in 90 g of cyclohexanone. 23 g of cyclohexanone was placed in a reaction vessel and added dropwise to a system at 85°C in a nitrogen gas atmosphere over 4 h. The reaction solution was heated and stirred for 2 h and then was air-cooled to room temperature.

The above reaction solution was added dropwise to 1,350 g of heptane/ethyl acetate=8/2 (mass ratio) to precipitate the polymer and filtration was performed. The filtered solid was washed by using 400 g of heptane/ethyl acetate=8/2 (mass ratio). Thereafter, the washed solid was subjected to vacuum drying to obtain 12.85 g of the resin (HR-40).

The other resin (C) used in the respective resins was synthesized in the same manner.

As the resin for comparison, a resin was prepared as below.

Polystyrene (PS): manufactured by Sigma-Aldrich Co. LLC., weight-average molecular weight 280,000, surface energy of 38.4 $mNm^{-1}$

Poly($\alpha$-methylstyrene) (P$\alpha$PS): synthesized by a well-known method. Weight-average molecular weight 407,000, dispersion degree 1.34, surface energy 33.7 $mNm^{-1}$

Polytetrafluoroethylene: manufactured by Sigma-Aldrich Co. LLC.

Polytetrafluoroethylene: manufactured by Sigma-Aldrich Co. LLC.

<Organic semiconductor compound>

Subsequently, the organic semiconductor compounds used in the respective examples are provided below (Compounds (1)-(10) and Comparative Compounds P3HT and TIPS-PEN).

Comparative Compound P3HT represents poly(3-hexylthiophene-2,5-diyl) manufactured by Sigma-Aldrich Japan K.K. Comparative Compound TIPS-PEN represents TIPS PENTACENE (6,13-bis(triisopropylsilylethynyl) pentacene) manufactured by Sigma-Aldrich Japan K.K.

Compounds (1)-(3) and (6)-(10) were synthesized in the method of synthesizing a well-known D-Atype $\pi$ con-

jugated polymer.

The method of synthesizing Compounds (4) and (5) is provided below.

<Synthesis of Compound (4)>

Compound (4) was synthesized in the following scheme.

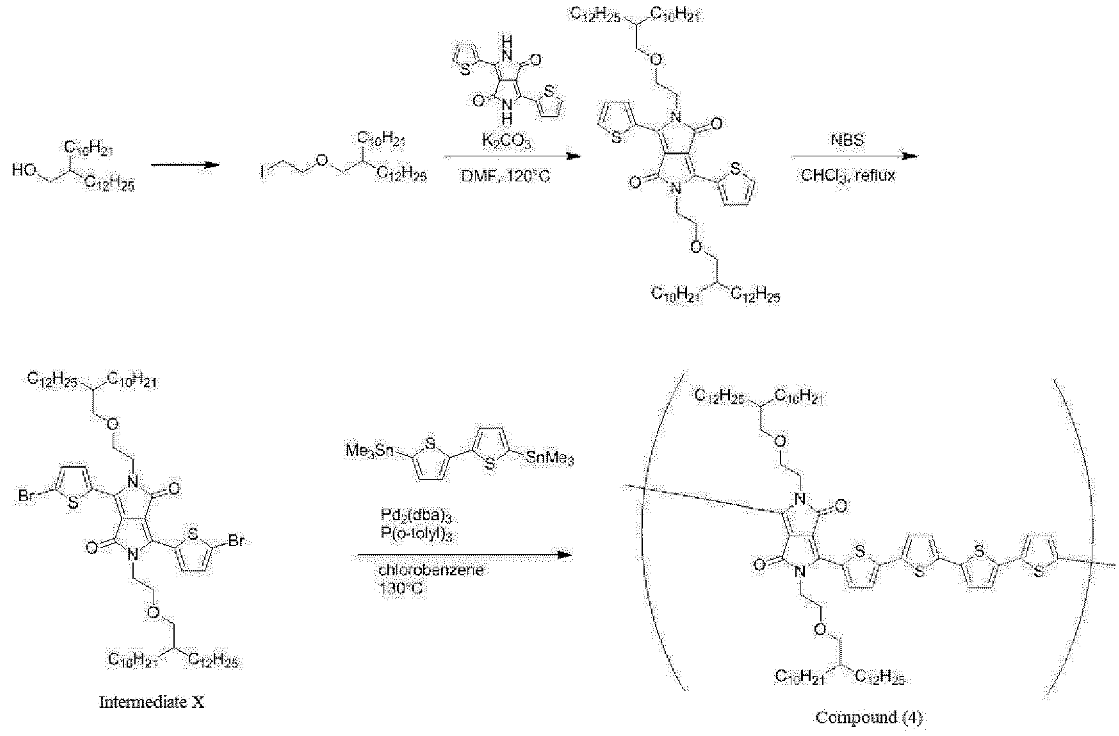


Intermediate X

Compound (4)

Intermediate X which is a monomer was synthesized with reference to Tetrahedron, 2010, 66, 3173 and Organic Electronics, 2011, 12, 993.

Synthesis Intermediate X (244 mg, 200 mmol), 5,5'-bis(trimethylstannyl)-2,2'-bithiophene (98.4 mg, 200 mmol), tri(o-tolyl) phosphine (9.8 mg, 32 mmol), tris(dibenzylideneacetone) dipalladium (3.7 mg, 4 mmol), and dehydrated chlorobenzene (17 mL) were mixed and stirred at 130°C for 24 h under nitrogen atmosphere. After the reaction liquid was cooled to room temperature, the reaction liquid was poured to a methanol (240 mL)/concentrated hydrochloric acid (10 mL) mixed solution, and stirring was performed for 2 h. After the precipitate was filtered and washed with methanol, soxhlet extraction was performed sequentially with methanol, acetone, and ethyl acetate, so as to remove soluble impurities. Subsequently, soxhlet extraction was performed with chloroform, and the obtained solution was subjected to vacuum concentration, methanol was added, the precipitated solid content was filtrated and washed with methanol, and vacuum drying was performed at 80°C for 12 h, so as to obtain 201 mg of Compound (4) (yield: 82%).

The number-average molecular weight in terms of polystyrene was $2.4\times10^4$, and the weight-average molecular weight thereof was $7.5\times10^4$.

<Synthesis of Compound (5)>

Compound (5) was synthesized in the following scheme.

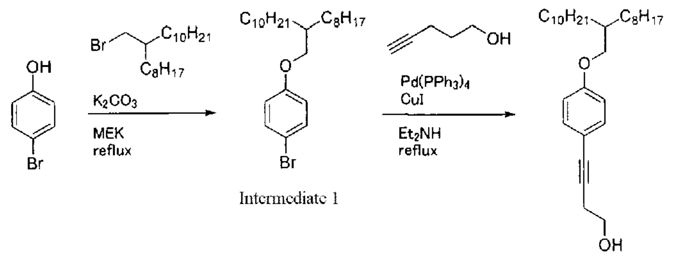


Intermediate 1

Intermediate 2

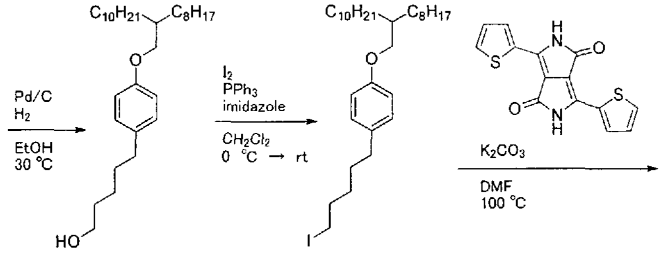


Intermediate 3

Intermediate 4

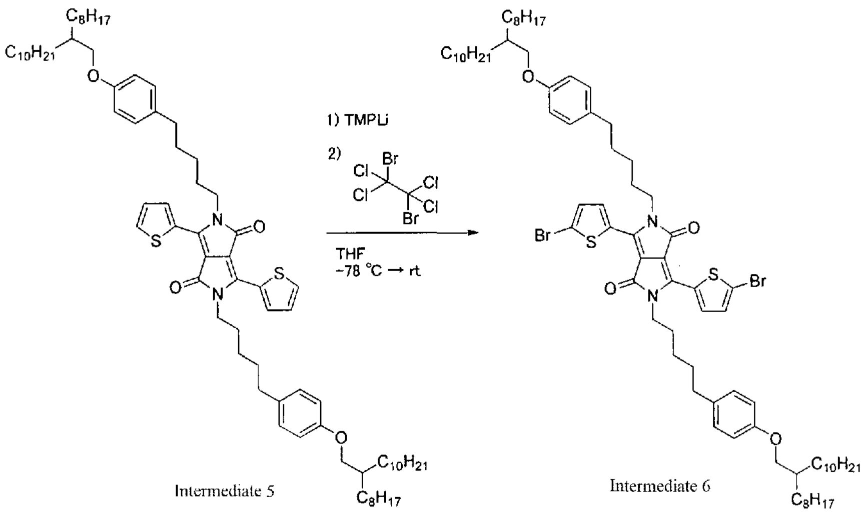


Intermediate 5

Intermediate 6

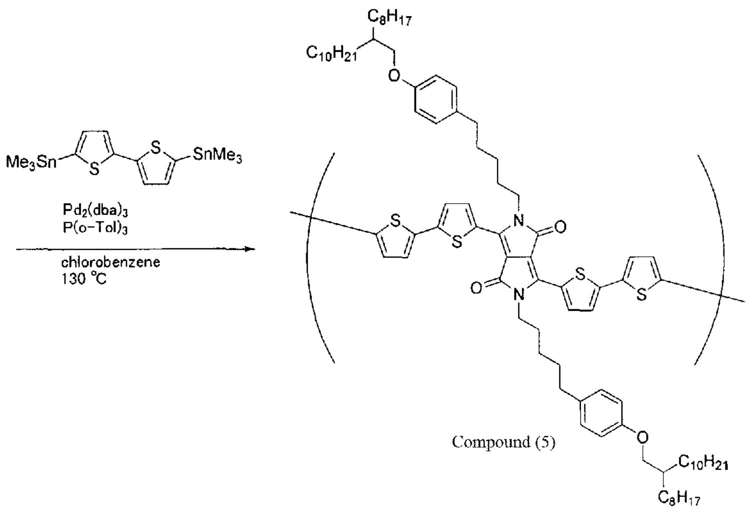


Compound (5)

(Synthesis of Intermediate 1)

4-Bromophenol (41.6 g, 240 mmol), 2-octyl-1-dodecyl bromide (174 g, 480 mmol), potassium carbonate (100 g, 720 mmol), and methyl ethyl ketone (480 mL) were mixed and were stirred at 100°C for 72 h under the nitrogen atmosphere. The reaction solution was cooled to room temperature, filtration was performed through celite, and celite was washed with hexane. The filtrate was concentrated under reduced pressure, and the obtained crude product was purified by silica gel column chromatography (eluate: hexane) to obtain Intermediate 1 (80 g).

(Synthesis of Intermediate 2)

Intermediate 1 (30 g, 66 mmol), 4-pentyn-1-ol (18.3 mL, 198 mmol), copper iodide (630 mg, 3.3 mmol), diethylamine (90 mL), tetrakistriphenylphosphine palladium (1.9 g, 1.7 mmol) were mixed and stirred at 70°C for 4 h under nitrogen atmosphere. Ethyl acetate (200 mL) was added to the reaction solution, and filtration was performed through celite, so as to remove insoluble matter. The filtrate was concentrated under reduced pressure, and the obtained crude product was purified by silica gel column chromatography (eluate: hexane/ethyl acetate=4:1 to 1:1) to obtain Intermediate 2 (17.5 g).

(Synthesis of Intermediate 3)

Intermediate 2 (5.0 g, 11 mmol), 10 wt% Pd/C (3.6 g), and ethanol (25 mL) were mixed in an autoclave container. Hydrogen was charged at 0.9 Mpa and stirring was performed at 30°C for 4 h. The reaction vessel was returned to the atmosphere, the reaction solution was filtered through celite, and celite was washed with tetrahydrofuran. The filtrate was concentrated under reduced pressure, and the obtained crude product was purified by silica gel column chromatography (eluate: hexane/ethyl acetate=4:1 to 2:1) to obtain Intermediate 3 (4.2 g).

(Synthesis of Intermediate 4)

Intermediate 3 (8.5 g, 18 mmmol), imidazole (1.5 g, 22 mol), triphenylphosphine (5.8 g, 22 mol) and dichloromethane (54 mL) were mixed and were cooled to 0°C under a nitrogen atmosphere. Iodine (5.6 g, 22 mol) was added in small portions. The reaction solution was raised to room temperature, and stirring was performed for 1 h. The reaction was stopped by adding an aqueous solution of sodium bisulfite, the solution was separated, and the aqueous layer was removed. The organic layer was dried on magnesium sulfate, filtration was performed, and vacuum concentration was performed. The obtained crude product was purified by silica gel column chromatography (eluate: hexane) to obtain Intermediate 4 (8.7 g).

(Synthesis of Intermediate 5)

3,6-di(2-thienyl)-2,5-dihydropyrrolo[3,4-c]pyrrole-1,4-dione (1.53 g, 5.1 mmol), potassium carbonate (2.1 g, 15.3 mmol), N,N-dimethylformamide (75 mL) were mixed and stirred at 100°C for 1 h under a nitrogen atmosphere. Thereafter, Intermediate 4 (8.7 g, 15 mmol) was added, and the mixture was further stirred at 100°C for 6 h. The reaction solution was cooled to room temperature, filtration was performed through celite, and celite was washed with ethyl acetate. The filtrate was concentrated under reduced pressure, and the obtained crude product was purified by silica gel column chromatography (eluate: hexane/ethyl acetate=19:1 to 9:1) to obtain Intermediate 5 (3.2 g).

(Synthesis of Intermediate 6)

Under a nitrogen atmosphere, 2,2,6,6-tetramethylpiperidine (2.4 mL, 14 mmol) and dehydrated tetrahydrofuran (13 mL) were mixed and cooled to -78°C. 2.6 M of a normal butyllithium hexane solution (5.2 mL, 13 mmol) was added dropwise, and the temperature was raised to 0°C to adjust a lithiation agent.

Under a nitrogen atmosphere, Intermediate 5 (800 mg, 0.67 mmol), and dehydrated tetrahydrofuran (3.6 mL) were mixed and cooled to -78°C. The above-adjusted lithiation agent (4.1 mL, corresponding to 4.2 mmol) was added dropwise. After stirring was performed at -78°C for 1 h, 1,2-dibromo-1,1,2,2-tetrachloroethane (439 mg, 1.3 mmol) was added. Thereafter, the temperature of the reaction solution was raised to room temperature, stirring was performed for 1 h, water was added, and the reaction was stopped. After the reaction solution was extracted with hexane, the organic layer was washed with 1 M of hydrochloric acid and saturated saline. The organic layer was dried on magnesium sulfate, filtration was performed, and vacuum concentration was performed. The obtained crude product was purified by silica gel column chromatography (eluate: hexane/ethyl acetate=19:1 to 9:1) to obtain Intermediate 6 (390 mg).

(Synthesis of Compound (5))

Synthesis Intermediate 6 (130 mg, 97 μmol), 5,5'-bis(trimethylstannyl)-2,2'-bithiophene (48 mg, 97 μmol), tri(o-tolyl)phosphine (2.4 mg, 7.7 μmol), tris(dibenzylideneacetone) dipalladium (1.8 mg, 1.9 μmol), and dehydrated chlorobenzene (3 mL) were mixed and stirred at 130°C for 24 h under nitrogen atmosphere. The reaction solution was cooled to room temperature and was introduced to a mixed solution of methanol (40 mL)/concentrated hydrochloric acid (2 mL) and stirred for 2 h, and the precipitate was filtrated and washed with methanol. The resulting crude product was sequentially subjected to soxhlet extraction with methanol, acetone, and hexane, and soluble impurities were removed. Subsequently, soxhlet extraction was performed with chlorobenzene, the obtained solution was subjected to vacuum concentration, methanol was added, the precipitated solid content was filtrated and washed with methanol, and vacuum drying was performed at 80°C for 12 h, so as to obtain Compound (5) (130 mg).

The number-average molecular weight in terms of polystyrene was $2.0 \times 10^4$, and the weight-average molecular weight thereof was $5.0 \times 10^4$.

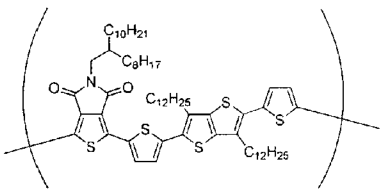

Compound (1)
Mw 32,000

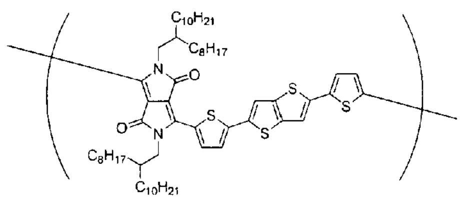

Compound (2)
Mw=89,000

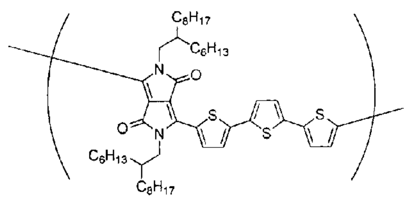

Compound (3)
Mw=78,000

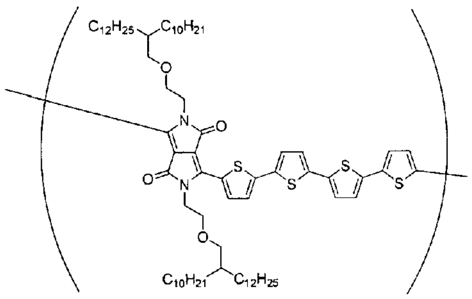

Compound (4)
Mw 75,000

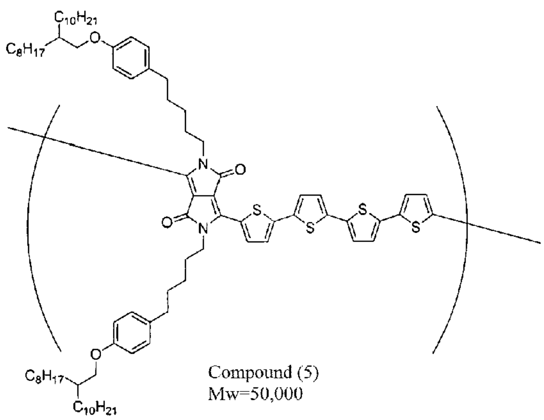

Compound (5)
Mw=50,000

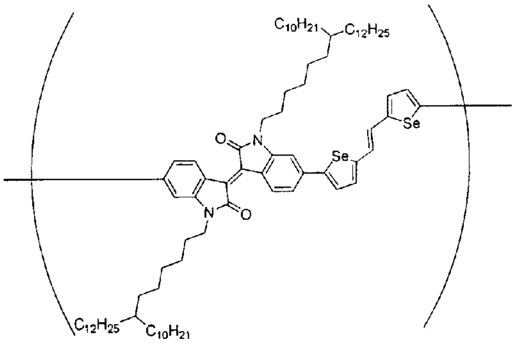

Compound (6)
Mw=98,000

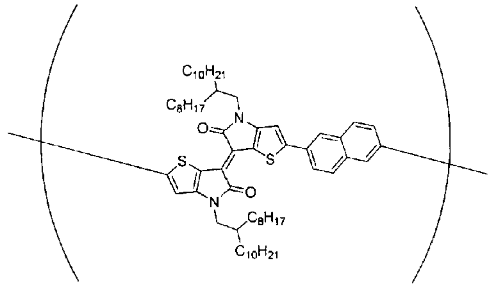

Compound (7)
Mw=70,000

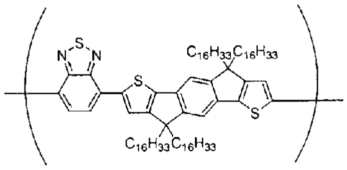

Compound (8)
Mw=71,000

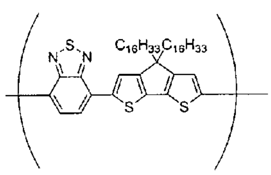

Compound (9)
Mw=28,000

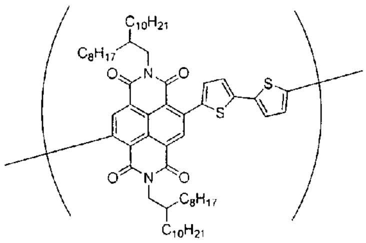

Compound (10)
Mw=88,000

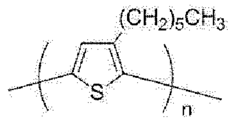

P3HT
Mw:45,000

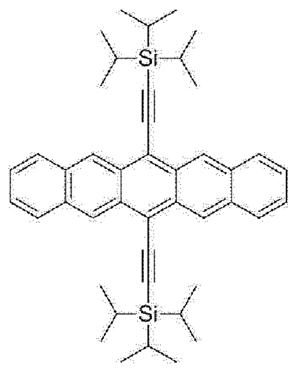

TIPS-PEN

[Manufacturing Example 1] (Reference, not according to the claimed invention) Manufacturing of bottom gate-type OTFT-1

The bottom gate-bottom contact-type OTFT illustrated in Fig. 1A was manufactured. A doped silicon substrate (also functioning as the gate electrode 5) having a thickness of 1 mm was used as the substrate 6, and the gate insulating layer 2 was formed thereon.

The gate insulating layer 2 was formed as below.

6.3 g of poly(4-vinylphenol) (manufactured by Nippon Soda Co., Ltd., trade name: VP-8000, Mn 11,000, dispersion degree 1.1) and 2.7 g of 2,2-bis(3,5-dihydroxymethyl-4-hydroxyphenyl) propane, as a crosslinking agent, were completely dissolved in 91 g of mixed solvent of 1-butanol/ethanol = 1/1 at room temperature. This solution was filtered with a membrane filter formed of PTFE with φ 0.2 μm. 0.18 g of diphenyliodonium hexafluorophosphate salt as an acid catalyst was added to the obtained solution, and applied to the substrate 6 and dried to form a film. Thereafter, the film was heated to 100°C to form a crosslinking structure, so as to form the gate insulating layer 2 having a thickness of 0.7 μm.

Then, as illustrated in Fig. 1A, electrodes formed of chromium/gold (gate width W=100 mm, gate length L=100 μm) disposed in a comb shape as the source electrode 3 and the drain electrode 4 were formed by vacuum evaporation by using a mask.

To form the base material layer (the resin (C) layer) on the gate insulating layer 2, a solution (coating solution) obtained by dissolving 10 mg of the resin (C) presented in a first table in 1 g of propylene glycol monomethyl ether acetate (PGMEA) was prepared. This coating solution was applied to the gate insulating layer 2 by spin-coating and

was dried, so as to form a film. This base material layer (the resin (C) layer) was heated for 15 minutes at 150°C under nitrogen stream. All of the thicknesses of the obtained base material layers (the resin (C) layers) were in the range of 20-50 nm.

Subsequently, a solution obtained by dissolving 4 mg of the organic semiconductor compound presented in the first table in 1 mL of chlorobenzene was applied by spin coating so as to cover the base material layer (the resin (C) layer) and the source and drain electrodes and form a film, and an annealing treatment was performed at 175°C for 1 h under the nitrogen atmosphere, so as to manufacture the OTFT in the structure presented in Fig. 1A. The thickness of the organic semiconductor layer was 20-50 nm.

<Performance evaluation of OTFT>

With respect to the OTFT obtained in Manufacturing Example 1, the performance of the OTFT was examined by evaluating carrier mobility, an on/off ratio, and an absolute value of a threshold voltage in the method below.

(Evaluation of carrier mobility)

Carrier mobility $\mu$ was calculated by applying a voltage of -40 V between the source electrode and the drain electrode, changing a gate voltage in the range of 40 V to -40 V, and using an equation below indicating a drain current Id. The greater value indicates excellent carrier mobility.

$$Id=(w/2L)\mu Ci(Vg-Vth)^2$$

(In the equation, L represents a gate length, w represents a gate width, $C_i$ represents the capacitance per unit area of the insulating layer, $V_g$ represents a gate voltage, and $V_{th}$ represents a threshold voltage)

(Evaluation standard of on/off ratio)

In a case where the voltage applied between the source electrode and the drain electrode was fixed to -40 V and Vg was swept from 40 to -40 V, (a maximum value of |Id|)/(a minimum value of |Id|) was defined as an on/off ratio. Evaluation standards were as follows, A or B was preferable, and A was more preferable.

A: $\geq 1\times10^6$
B: $1\times10^5$ to $< 1\times10^6$
C: $< 1\times10^5$

(Evaluation of threshold voltage)

A voltage applied between the source electrode and the drain electrode was fixed to -40V, and Vg was changed in the range of 40 to -40V, so as to measure a threshold voltage Vth. As the absolute value of this value was closer to 0, the threshold voltage was excellent.

<Heat resistance test>

The OTFT obtained in Manufacturing Example 1 was heated at 200°C for 1 h, under the nitrogen atmosphere, and carrier mobility, the on/off ratio, and the threshold voltage were evaluated by the above method.

(Carrier mobility (heat resistance))

A value of the carrier mobility after the heat resistance test with respect to a value of the carrier mobility before the heat resistance test [100×(carrier mobility after heat resistance test)/(carrier mobility before heat resistance test)] (%) was obtained, and the evaluation of the carrier mobility in the heat resistance test was evaluated based on this value in the following standards. In the evaluation standard below, A or B was preferable, and A was more preferable.

A: ≥ 10%
B: 1 to < 10%
C: < 1%

(On/off ratio (heat resistance))

A value of the on/off ratio after the heat resistance test with respect to a value of the on/off ratio before the heat resistance test [100×(on/off ratio after heat resistance test)/(on/off ratio before heat resistance test)](%) was obtained, and the evaluation of the on/off ratio in the heat resistance test was evaluated based on this value in the following standards. In the evaluation standard below, A was more preferable.

A: ≥ 10%

B: < 10%

(Threshold voltage (heat resistance))

A difference between a value (absolute value) of the threshold voltage after the heat resistance test with respect to a value (absolute value) of the threshold voltage before the heat resistance test [(absolute value of threshold voltage after heat resistance test)-(absolute value of threshold voltage before heat resistance test)] was obtained, and the evaluation of the threshold voltage in the heat resistance test was evaluated based on this value in the following standards. In the evaluation standard below, A was more preferable.

A:<5V

B: ≥ 5V

Results thereof are as presented in the first table.

[Table 2]

| First table | Organic semiconductor compound | | | Resin | | | | Initial characteristic result | | | Heat resistance test | | |
|---|---|---|---|---|---|---|---|---|---|---|---|---|---|
| | Type | Type of Acceptor (A) | Formulae (2) to (5) | Type | Repeating units (C-Ia) to (C-Id) | Whether group having fluorine atom or silicon atom exist in repeating units (C-Ia) to (C-Id) exists | Surface energy ($mNm^{-1}$) | Mobility ($cm^2/Vs$) | on/off ratio | Absolute value of threshold voltage (V) | Mobility ($cm^2/Vs$) | on/off ratio | Absolute value of threshold voltage (V) |
| Reference Example 1 | Compound (1) | A-1 | (2) | HR-14 | (C-Ia) | Existence | 16.5 | 0.09 | A | 17 | A | A | A |
| Reference Example 2 | Compound (2) | A-3 | (3) | HR-14 | (C-Ia) | Existence | 16.5 | 0.33 | A | 18 | A | A | A |
| Reference Example 3 | Compound (3) | A-3 | (3) | HR-14 | (C-Ia) | Existence | 16.5 | 0.19 | A | 13 | A | A | A |
| Reference Example 4 | Compound (4) | A-3 | (3) | HR-14 | (C-Ia) | Existence | 16.5 | 0.29 | A | 10 | A | A | A |
| Reference Example 5 | Compound (5) | A-3 | (3) | HR-14 | (C-Ia) | Existence | 16.5 | 0.27 | A | 11 | A | A | A |
| Reference Example 6 | Compound (6) | A-5 | (4) | HR-14 | (C-Ia) | Existence | 16.5 | 0.15 | A | 17 | A | A | A |
| Reference Example 7 | Compound (7) | A-6 | (5) | HR-14 | (C-Ia) | Existence | 16.5 | 0.20 | A | 19 | A | A | A |
| Reference Example 8 | Compound (8) | A-8 | - | HR-14 | (C-Ia) | Existence | 16.5 | 0.18 | B | 13 | A | A | A |
| Reference Example 9 | Compound (9) | A-8 | - | HR-14 | (C-Ia) | Existence | 16.5 | 0.13 | B | 18 | A | A | A |
| Reference Example 10 | Compound (10) | A-10 | - | HR-14 | (C-Ia) | Existence | 16.5 | 0.06 | A | 12 | B | A | A |
| Reference Example 11 | Compound (4) | A-3 | (3) | HR-40 | (C-Ia), (C-Ib) | Existence | 18 | 0.20 | A | 12 | A | A | A |

(continued)

| First table | Organic semiconductor compound | | | Resin | | | | Initial characteristic result | | | Heat resistance test | | |
|---|---|---|---|---|---|---|---|---|---|---|---|---|---|
| | Type | Type of Acceptor (A) | Formulae (2) to (5) | Type | Repeating units (C-Ia) to (C-Id) | Whether group having fluorine atom or silicon atom exist in repeating units (C-Ia) to (C-Id) exists | Surface energy ($mNm^{-1}$) | Mobility ($cm^2/Vs$) | on/off ratio | Absolute value of threshold voltage (V) | Mobility ($cm^2/Vs$) | on/off ratio | Absolute value of threshold voltage (V) |
| Reference Example 12 | Compound (4) | A-3 | (3) | HR-60 | (C-Ia), (C-Ib) | Existence | 17.5 | 0.25 | A | 11 | A | A | A |
| Reference Example 13 | Compound (4) | A-3 | (3) | HR-24 | (C-Ia), (C-Ib) | Existence | 17.5 | 0.27 | A | 10 | A | A | A |
| Reference Example 14 | Compound (4) | A-3 | (3) | HR-61 | (C-Ib) | Existence | 24.9 | 0.16 | A | 17 | A | A | A |
| Reference Example 15 | Compound (4) | A-3 | (3) | HR-62 | (C-Ia) | Existence | 13.8 | 0.17 | A | 17 | A | A | A |
| Reference Example 16 | Compound (4) | A-3 | (3) | HR-39 | (C-Ia), (C-Ib) | Existence | 17.7 | 0.24 | A | 13 | A | A | A |
| Reference Example 17 | Compound (4) | A-3 | (3) | HR-9 | (C-Ia) | Existence | 26.8 | 0.13 | A | 15 | A | A | A |
| Reference Example 18 | Compound (4) | A-3 | (3) | HR-38 | (C-Ia), (C-Ib) | Existence | 25 | 0.14 | A | 12 | A | A | A |
| Reference Example 19 | Compound (4) | A-3 | (3) | HR-51 | (C-Ia) | Existence | 19.5 | 0.14 | A | 15 | A | A | A |
| Reference Example 20 | Compound (4) | A-3 | (3) | HR-63 | (C-Ia), (C-Ib) | Non-existence | 29.6 | 0.11 | A | 17 | A | A | A |
| Reference Example 21 | Compound (4) | A-3 | (3) | HR-64 | (C-Ib) | Non-existence | 31.2 | 0.07 | A | 18 | A | A | A |
| Comparative Example 1 | P3HT | - | - | HR-14 | (C-Ia) | Existence | 16.5 | 0.001 | C | 13 | B | B | B |

(continued)

| First table | Organic semiconductor compound | | | Resin | | | | Initial characteristic result | | | Heat resistance test | | |
|---|---|---|---|---|---|---|---|---|---|---|---|---|---|
| | Type | Type of Acceptor (A) | Formulae (2) to (5) | Type | Repeating units (C-Ia) to (C-Id) | Whether group having fluorine atom or silicon atom exist in repeating units (C-Ia) to (C-Id) exists | Surface energy ($mNm^{-1}$) | Mobility ($cm^2/Vs$) | on/off ratio | Absolute value of threshold voltage (V) | Mobility ($cm^2/Vs$) | on/off ratio | Absolute value of threshold voltage (V) |
| Comparative Example 2 | TIPS-PEN | - | - | HR-14 | (C-Ia) | Existence | 16.5 | 0.08 | C | 15 | C | B | B |
| Comparative Example 3 | Compound (4) | A-3 | (3) | PS | - | - | 38.4 | 0.02 | A | 25 | A | B | B |
| Comparative Example 4 | Compound (4) | A-3 | (3) | PaMS | - | - | 33.7 | 0.02 | A | 22 | A | B | B |
| Comparative Example 5 | Compound (4) | A-3 | (3) | None | - | - | - | 0.05 | B | 25 | A | B | B |

<Evaluation results>

As presented in the first table, the OTFTs in the examples exhibit the high carrier mobility and the low threshold voltage, and heat resistance was excellent.
From the comparison with Reference Examples 1-9, the OTFTs (Reference Examples 8 and 9) manufactured by using the organic semiconductor compounds of which types did not correspond to Formulae (2)-(5) had a tendency that the initial on/off ratio was decreased.
From the comparison of Reference Examples 1-7 and 10, the OTFT (Reference Example 10) manufactured by using the organic semiconductor compound of which the type did not correspond to Formulae (2)-(5) had a tendency that initial carrier mobility and carrier mobility after the heat resistance test were decreased.
From the comparison of Reference Examples 4 and 11-21, in a case where a repeating unit that did not include a group having a fluorine atom or a silicon atom in the resin (C) including the repeating units (C-Ia) to (C-Id) (Reference Examples 20 and 21), there was a tendency of decreasing initial carrier mobility of the OTFT.
Meanwhile, the OTFTs of the comparative examples did not manufactured by using the resin (C) or the specific organic semiconductor compound, and it was exhibited that thus the desired performances were not able to be obtained.
Though not shown in the first table, it was attempted to prepare a base material layer by using polytetrafluoroethylene and polychlorotrifluoroethylene as a resin, but these compounds were not dissolved in chlorobenzene, a coating solution was not able to be prepared, and thus the above test was not able to be performed.

[Manufacturing Example 2] Manufacturing of bottom gate-type OTFT-2

In the same manner as in Manufacturing Example 1, after the source electrode 3 and the drain electrode 4 were formed, a solution (mixed solution) obtained by dissolving 4 mg of the resin (C) (HR-14) and 4 mg of the specific organic semiconductor compound (Compound (4)) in 2 mL of chlorobenzene was prepared. This mixed solution was applied to the gate insulating layer 2 by spin coating, a film was formed, an annealing treatment was performed at 175°C for 1 h under the nitrogen atmosphere, so as to manufacture the OTFT. The thickness of the obtained organic semiconductor layer is in the range of 30-100 nm.
With respect to the organic semiconductor layer of the obtained OTFT, whether the resin (C) was unevenly distributed or phase-separated was able to be checked by performing element mapping measurement by time-of-flight secondary ion analysis (TOF-SIMS) together with the use of an etching ion beam. As a result, in the organic semiconductor layer, the resin (C) was unevenly distributed on the surface of the organic semiconductor layer in the same manner as in Figs. 2E and 2F.
With respect to the respective obtained OTFTs, carrier mobility, on/off ratios, and absolute values of threshold voltages of the OTFTs were evaluated in the same method as the evaluation of Manufacturing Example 1. As a result, the results were the same as in Reference Example 4. The heat resistance test in the same method as in Manufacturing Example 1 were performed, and the same tendency as in Manufacturing Example 1 were exhibited.

[Manufacturing Example 3] Manufacturing of bottom gate-type OTFT-3

In the same manner as in Manufacturing Example 1, after the gate insulating layer 2 was formed, subsequently, an ultraviolet (UV)/ozone treatment (manufactured by Jelight Company Inc., UVO-CLEANER Model No. 42) was performed such that the surface energy became as presented in a second table below.
Thereafter, in the same manner as in Manufacturing Example 1, the source electrode 3 and the drain electrode 4 were formed.
Subsequently, a solution (coating solution) obtained by dissolving 2 mg of the resin (C) (HR-14) and 4 mg of the organic semiconductor compound (Compound (4)) in 2 mL of chlorobenzene was prepared. This coating solution was applied to the gate insulating layer 2 by spin coating, a film was formed, an annealing treatment was performed at 175°C for 1 h under the nitrogen atmosphere, so as to manufacture the OTFT. The thickness of the obtained organic semiconductor layer is in the range of 20-100 nm.
With respect to the obtained OTFTs, carrier mobility, on/off ratios, and absolute values of threshold voltages of the OTFTs were evaluated in the same method as the evaluation of Manufacturing Example 1, and evaluation results of the carrier mobility are presented in the second table. Results of the items other than the carrier mobility were the same as in Reference Example 4. The heat resistance test was performed, and the result was the same as in Reference Example 4.

[Table 3]

| Second table | Surface energy of gate insulating layer (mN/m) | Initial characteristic result |
|---|---|---|
| | | Mobility ($cm^2/Vs$) |
| Example 5-1 | 50 | 0.35 |
| Example 5-2 | 65 | 0.38 |
| Example 5-3 | 70 | 0.44 |
| Example 5-4 | 75 | 0.44 |

[Manufacturing Example 4] Manufacturing of bottom gate-type OTFT-4

In the same manner as in Manufacturing Example 1, a doped silicon substrate (also functioning as the gate electrode 5) having a thickness of 1 mm was used as the substrate 6, and the gate insulating layer 2 was formed thereon.

The gate insulating layer 2 was formed as below.

Spin coating was performed with a composition for forming a gate insulating layer (a propylene glycol monomethyl ether acetate (PGMEA) solution (concentration of solid content: 2 mass%) of (poly (styrene-co-methyl methacrylate)/pentaerythritol tetraacrylate/1,2-octanedione, and 1-[4-(phenylthio)-, 2-(O-benzoyloxime)]=1 parts by mass/1 parts by mass/0.01 parts by mass (w/w)), baking was performed at 110°C for five minutes, exposure (365 nm and 100 mJ/$cm^2$) was performed, and post baking was performed at 200°C for 60 minutes, so as to form a gate insulating layer having a film thickness of 400 nm. Subsequently, ultraviolet (UV)/ozone treatment (manufactured by Jelight Co., Inc., UVO-CLEANER Model No.42) was performed so as to obtain surface energy of a third table. However, in Example 6-0, a UV/ozone treatment was not performed.

In the same manner as in Manufacturing Example 1, after the source electrode 3 and the drain electrode 4 were formed, a solution (coating solution) obtained by dissolving 2 mg of the resin (C) (HR-14) and 4 mg of the organic semiconductor compound (Compound (4)) in 2 mL of chlorobenzene was prepared. This coating solution was applied to the gate insulating layer 2 by spin coating, a film was formed, an annealing treatment was performed at 175°C for 1 h under the nitrogen atmosphere, so as to manufacture the OTFT. The thickness of the obtained organic semiconductor layer is in the range of 20-100 nm.

With respect to the obtained OTFTs, carrier mobility, on/off ratios, and absolute values of threshold voltages of the OTFTs were evaluated in the same method as the evaluation of Manufacturing Example 1, and evaluation results of the carrier mobility are presented in the third table. Results of the items other than the carrier mobility were the same as in Reference Example 4. The heat resistance test was performed, and the result was the same as in Reference Example 4.

[Table 4]

| Third table | Surface energy of gate insulating layer (mN/m) | Initial characteristic result |
|---|---|---|
| | | Mobility ($cm^2/Vs$) |
| Example 6-0 | 42 | 0.26 |
| Example 6-1 | 50 | 0.40 |
| Example 6-2 | 65 | 0.46 |
| Example 6-3 | 70 | 0.53 |
| Example 6-4 | 75 | 0.53 |

From the evaluation results of the second and third tables, it was understood that the carrier mobility was prominently enhanced in a case where a mixed solution (organic semiconductor composition) containing the organic semiconductor compound and the resin (C) was applied to a gate insulating layer of which the surface energy is 50-75 mNm.

Explanation of References

1: organic semiconductor layer
1A: area having large content of resin (C)
1B: area having large content of organic semiconductor
2: gate insulating layer
3: source electrode
4: drain electrode
5: gate electrode
6: substrate

## Claims

**1.** A method of manufacturing an organic thin film transistor comprising, on a substrate:

1) a gate electrode (5);
2) an organic semiconductor layer (1) containing an organic

semiconductor compound which has a molecular weight of ≥ 2, 000 and has a repeating unit of the formula -(D-A)-(1), wherein
A is an electron acceptor unit including a partial structure having at least one of a sp2 nitrogen atom, a carbonyl group, or a thiocarbonyl group in a ring structure, and
D is an electron donor unit including a divalent aromatic heterocyclic group having at least one of a N atom, an O atom, a S atom, or a Se atom in a ring structure or a divalent aromatic hydrocarbon group consisting of a fused ring structure having two or more rings, as a partial structure,

3) a gate insulating layer (2) provided between the gate electrode and the organic semiconductor layer; and
4) a source electrode (3) and a drain electrode (4) which are provided to be in contact with the organic semiconductor layer and are linked to each other via the organic semiconductor layer,
wherein the organic semiconductor layer is in contact with a layer containing a resin (C) or further contains the resin (C), the resin (C) has at least one repeating unit of any of formulae (C-Ia) to (C-Id):

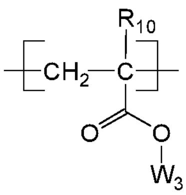
(C-Ia)

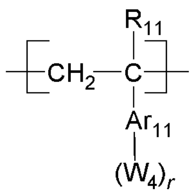
(C-Ib)

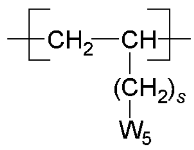
(C-Ic)

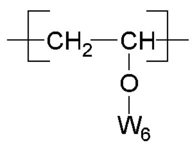
(C-Id)

wherein

$R_{10}$, $R_{11}$ each are H, F or alkyl,
$W_3$ is an organic group having one or more selected from F, a Si-containing group, $C_{\geq 2}$-alkyl, cycloalkyl, aryl and aralkyl,
$W_4$ is an organic group having one or more selected from F, a F-containing group, a Si-containing group, alkyl and cycloalkyl,
$W_5$, $W_6$ each are an organic group having one or more selected from a F-containing group, a Si-containing group, alkyl, cycloalkyl, aryl and aralkyl,
$Ar_{11}$ is a (r+1)-valent aromatic ring group,
r is an integer of 1-10, and
s is 0 or 1;

**characterised in that** the method comprises a step of applying a mixed solution containing the organic semiconductor compound and the resin (C) .

**2.** The method of claim 1, wherein the surface energy of the resin (C) is ≤ 30 $mNm^{-1}$.

**3.** The method of claim 1 or 2, wherein the resin (C) has at least one of a F-containing group and a Si-containing group.

**4.** The method of any of claims 1-3, wherein A in Formula (1) has at least one structure of any of the formulae (A-1) to (A-12) as a partial structure:

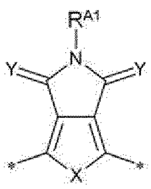
(A-1)

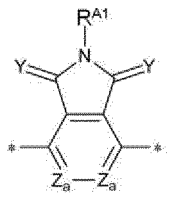
(A-2)

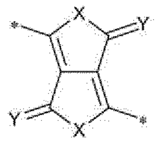
(A-3)

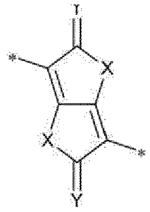
(A-4)

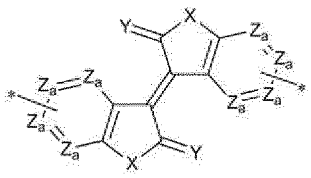
(A-5)

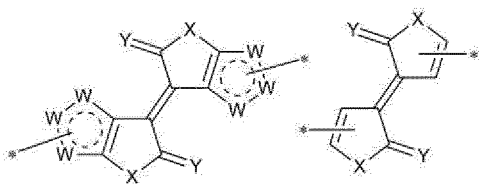
(A-6) (A-7)

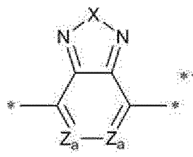
(A-8)

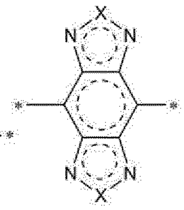
(A-9)

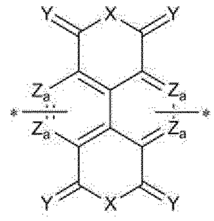
(A-10)

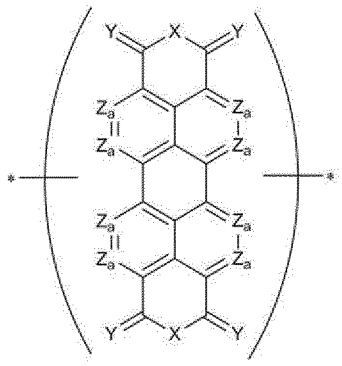
(A-11)

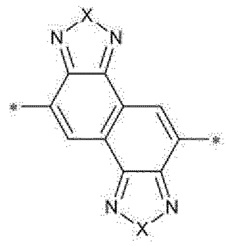
(A-12)

wherein

X each independently is O, S, Se or $NR^{A1}$,
Y each independently is O or S,
$Z_a$ each independently is $CR^{A2}$ or N,
W each independently is $C(R^{A2})_2$, $NR^{A1}$, N, $CR^{A2}$, O, S, or Se,
$R^{A1}$ each independently is a bonding site to an alkyl group that may include at least one of -O-, -S-, or $-NR^{A3}-$, $R^{A3}$ is H or a substituent, a monovalent group of the formula $*-L_a-Ar-(L_b)_l$ (1-1), or another structure, wherein in formula (1-1)
Ar is an aromatic $C_{5-18}$-heterocyclic group or an aromatic $C_{5-18}$-hydrocarbon group,
$L_a$ is $C_{1-20}$-alkylene that may include at least one of -O-, -S-, or $-NR^{1S}-$, $R^{1S}$ is H or a substituent,
$L_b$ each independently is $C_{1-100}$-alkyl that may include at least one of -O-, -S-, or $-NR^{2S}-$, $R^{2S}$ is H or a substituent,
$l$ is an integer of 1-5, and
* is a bonding site to another structure,
$R^{A2}$ each independently is a bonding site to an alkyl group that may include at least one of H, halogen, -O-, -S-, or $-NR^{A3}-$, $R^{A3}$ is H or a substituent, or another structure,
$R^{A3}$ each independently is H or a substituent, and
* each independently is a bonding site to another structure,

**5.** The method of any of claims 1-4, wherein D in Formula (1) is a structure of formula (D-1),

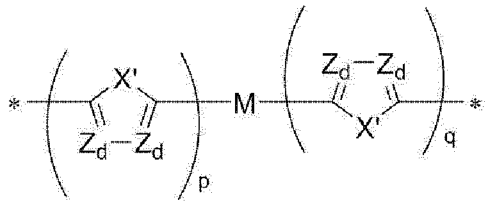

(D-1)

wherein

X' each independently is O, S, Se or $NR^{D1}$, wherein $R^{D1}$ each independently is a monovalent organic group that may be a monovalent group of formula (1-1) as defined in claim 4,
$Z_d$ each independently is N or $CR^{D2}$, wherein $R^{D2}$ each independently is H or a monovalent organic group that may be a monovalent group of formula (1-1) as defined in claim 4,
M is a single bond, a divalent aromatic heterocyclic group, a divalent aromatic hydrocarbon group, alkenylene, alkynylene, or a divalent group obtained by combining these, M may be substituted with alkyl that may include at least one of -O-, -S-, or $-NR^{D3}-$, $R^{D3}$ each independently is H or a substituent, or a monovalent group of formula (1-1) as defined in claim 4,
p, q each independently are an integer of 0-4, and
* each independently are a bonding site to another structure.

**6.** The method of any of claims 1-5, wherein the repeating unit of formula (1) is a repeating unit of any of the formulae (2)-(5):

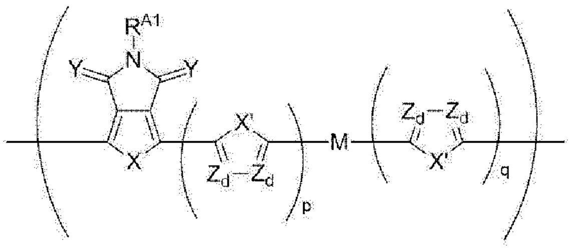

(2)

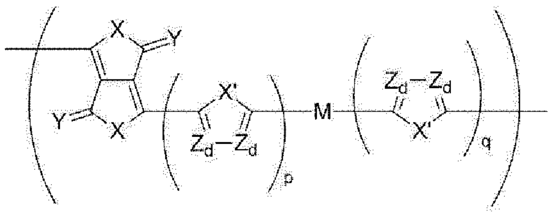

(3)

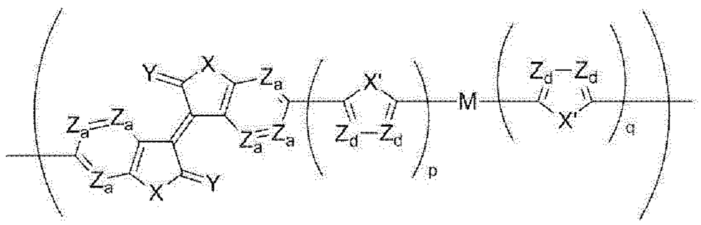

(4)

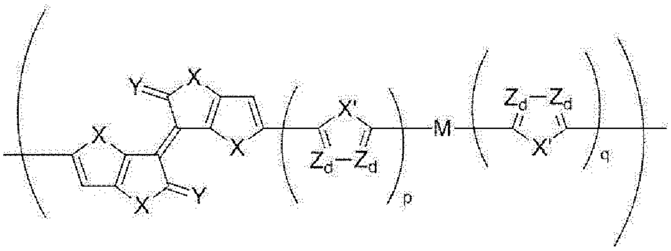

(5)

wherein

X each independently is O, S, Se or $NR^{A1}$, wherein $R^{A1}$ each independently is a bonding site to an alkyl group that may include at least one of -O-, -S-, or $-NR^{A3}-$, a monovalent group of formula (1-1), or another structure,
Y each independently is O or S,
$Z_a$ each independently is N or $CR^{A2}$ , wherein $R^{A2}$ each independently is a bonding site to an alkyl group that may include at least one of H, halogen, -O-, -S-, or $-NR^{A3}-$, or another structure,
$R^{A3}$ each independently is H or a substituent,
X' each independently is O, S, Se or $NR^{D1}$, wherein $R^{D1}$ each independently is a monovalent organic group that may be a monovalent group of the formula $*\text{-}L_a\text{-}Ar\text{-}(L_b)_l$ (1-1), wherein
Ar is an aromatic $C_{5-18}$-heterocyclic group or an aromatic $C_{5-18}$-hydrocarbon group,
$L_a$ is $C_{1-20}$-alkylene that may include at least one of -O-, -S-, or $-NR^{1S}-$, $R^{1S}$ is H or a substituent, $L_b$ each independently is $C_{1-100}$-alkyl that may include at least one of -O-, -S-, or $-NR^{2S}-$, $R^{2S}$ is H or a substituent, *l* is an integer of 1-5, and * is a bonding site to another structure,
$Z_d$ each independently are N or $CR^{D2}$, wherein $R^{D2}$ each independently is H or a monovalent organic group that may be a monovalent group of formula (1-1) as defined above,
M is a single bond, a divalent aromatic heterocyclic group, a divalent aromatic hydrocarbon group, alkenylene, alkynylene, or a divalent group obtained by combining these, M may be substituted with alkyl that may include at least one of -O-, -S-, or $-NR^{D3}-$, $R^{D3}$ each independently is H or a substituent, or a monovalent group of formula (1-1) as defined above, and
p, q each independently are an integer of 0-4.

**7.** The method of any of claims 1-6, wherein the organic thin film transistor has a bottom gate structure.

**8.** The method of claim 7, wherein the organic thin film transistor has a bottom contact structure.

**9.** The method of any of claims 1-8, wherein the mixed solution is applied to the gate insulating layer having a surface energy of 50-75 $mNm^{-1}$.

**10.** An organic semiconductor composition, comprising:

- an organic semiconductor compound which has a molecular weight of ≥ 2, 000 and has a repeating unit of the formula -(D-A)- (1), wherein

A is an electron acceptor unit including a partial structure having at least one of a sp2 nitrogen atom, a carbonyl group, or a thiocarbonyl group in a ring structure, and
D is an electron donor unit including a divalent aromatic heterocyclic group having at least one of a N atom, an O atom, a S atom, or a Se atom in a ring structure or a divalent aromatic hydrocarbon group consisting of a fused ring structure having two or more rings, as a partial structure; and

- a resin (C) having at least one repeating unit of any of formulae (C-Ia) to (C-Id):

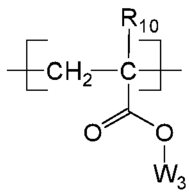
(C-Ia)

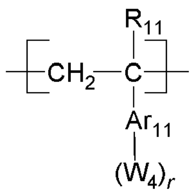
(C-Ib)

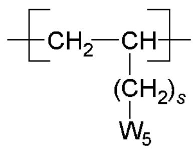
(C-Ic)

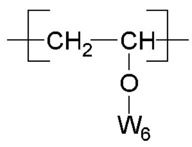
(C-Id)

wherein

$R_{10}$, $R_{11}$ each are H, F or alkyl,
$W_3$ is an organic group having one or more selected from F, a Si-containing group, $C_{\geq 2}$-alkyl, cycloalkyl, aryl and aralkyl,
$W_4$ is an organic group having one or more selected from F, a F-containing group, a Si-containing group, alkyl and cycloalkyl,
$W_5$, $W_6$ each are an organic group having one or more selected from a F-containing group, a Si-containing group, alkyl, cycloalkyl, aryl and aralkyl,
$Ar_{11}$ is a (r+1)-valent aromatic ring group,
r is an integer of 1-10, and
s is 0 or 1.

**11.** The organic semiconductor composition of claim 10, which is a film.

**12.** A method of manufacturing the organic semiconductor film of claim 11, comprising a step of applying a mixture containing the organic semiconductor compound and the resin (C) on a gate insulating layer having a surface energy of 50-75 $mNm^{-1}$, so as to obtain the organic semiconductor film.

## Patentansprüche

**1.** Verfahren zur Herstellung eines organischen Dünnschichttransistors, der auf einem Substrat Folgendes umfasst:

1) eine Gate-Elektrode (5);
2) eine organische Halbleiterschicht (1), die eine organische Halbleiterverbindung enthält, die ein Molekulargewicht von ≥ 2.000 aufweist und eine Wiederholungseinheit der Formel -(D-A)- (1) aufweist, wobei

A eine Elektronenakzeptoreinheit ist, die eine Teilstruktur mit mindestens einem von einem sp2-Stickstoffatom, einer Carbonylgruppe oder einer Thiocarbonylgruppe in einer Ringstruktur enthält, und
D eine Elektronendonoreinheit ist, die eine zweiwertige aromatische heterozyklische Gruppe mit mindestens einem von einem N-Atom, einem O-Atom, einem S-Atom oder einem Se-Atom in einer Ringstruktur oder eine zweiwertige aromatische Kohlenwasserstoffgruppe, die aus einer kondensierten Ringstruktur mit zwei oder mehr Ringen besteht, als Teilstruktur enthält,

3) eine Gate-Isolierschicht (2), die zwischen der Gate-Elektrode und der organischen Halbleiterschicht bereitgestellt ist; und
4) eine Source-Elektrode (3) und eine Drain-Elektrode (4), die so bereitgestellt sind, dass sie mit der organischen Halbleiterschicht in Kontakt stehen und die über die organische Halbleiterschicht miteinander verbunden sind,

wobei die organische Halbleiterschicht in Kontakt mit einer Schicht steht, die ein Harz (C) enthält oder ferner das Harz (C) enthält, wobei das Harz (C) mindestens eine Wiederholungseinheit einer der Formeln (C-Ia) bis (C-Id)

aufweist:

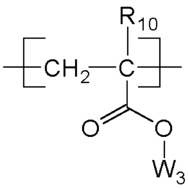
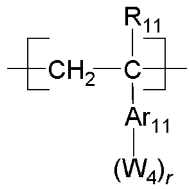
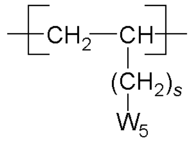
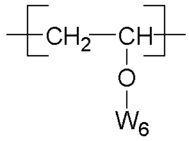

(C-Ia) (C-Ib) (C-Ic) (C-Id)

worin

$R_{10}$, $R_{11}$ jeweils H, F oder Alkyl sind,
$W_3$ eine organische Gruppe mit einem oder mehreren, ausgewählt aus F, einer Si-haltigen Gruppe, $C_{\geq 2}$-Alkyl, Cycloalkyl, Aryl und Aralkyl, ist,
$W_4$ eine organische Gruppe mit einem oder mehreren, ausgewählt aus F, einer F-haltigen Gruppe, einer Si-haltigen Gruppe, Alkyl und Cycloalkyl, ist,
$W_5$, $W_6$ jeweils eine organische Gruppe mit einem oder mehreren, ausgewählt aus einer F-haltigen Gruppe, einer Si-haltigen Gruppe, Alkyl, Cycloalkyl, Aryl und Aralkyl, sind,
$Ar_{11}$ eine (r+1)-wertige aromatische Ringgruppe ist,
r eine ganze Zahl von 1-10 ist und
s 0 oder 1 ist;

**dadurch gekennzeichnet, dass**
das Verfahren einen Schritt des Auftragens einer gemischten Lösung, die die organische Halbleiterverbindung und das Harz (C) enthält, umfasst.

2. Verfahren gemäß Anspruch 1, worin die Oberflächenenergie von Harz (C) $\leq$ 30 $mNm^{-1}$ beträgt.

3. Verfahren gemäß Anspruch 1 oder 2, worin das Harz (C) mindestens eines aus einer F-haltigen Gruppe und einer Si-haltigen Gruppe aufweist.

4. Verfahren gemäß einem der Ansprüche 1-3, worin A in Formel (1) mindestens eine Struktur aus einer der Formeln (A-1) bis (A-12) als Teilstruktur aufweist:

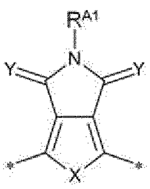
(A-1)
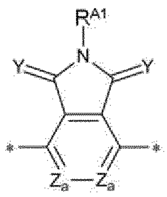
(A-2)
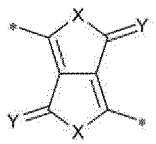
(A-3)
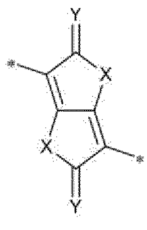
(A-4)
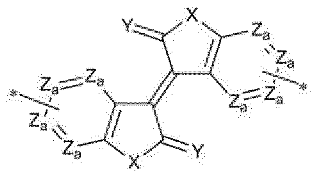
(A-5)

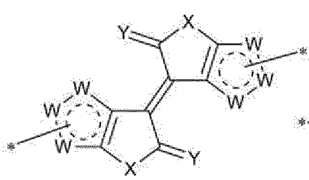
(A-6)
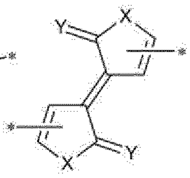
(A-7)
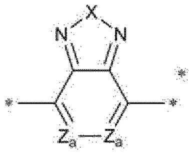
(A-8)
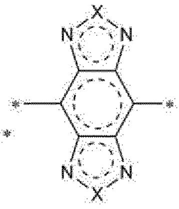
(A-9)
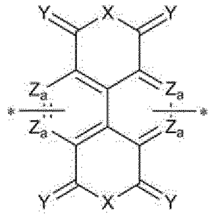
(A-10)

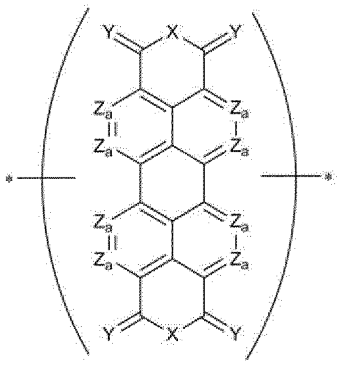

(A-11)

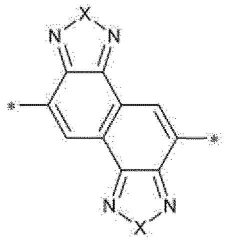

(A-12)

worin

X jeweils unabhängig O, S, Se oder $NR^{A1}$ ist,
Y jeweils unabhängig O oder S ist,
$Z_a$ jeweils unabhängig $CR^{A2}$ oder N ist,
W jeweils unabhängig $C(R^{A2})_2$, $NR^{A1}$, N, $CR^{A2}$, O, S oder Se ist,
$R^{A1}$ jeweils unabhängig eine Bindungsstelle an eine Alkylgruppe, die mindestens eines von -O-, -S-, oder -$NR^{A3}$- enthalten kann, wobei $R^{A3}$ H oder ein Substituent ist, eine einwertige Gruppe der Formel *-$L_a$-Ar-$(L_b)_l$ (1-1) oder eine andere Struktur ist, worin, in der Formel (1-1),
Ar eine aromatische $C_{5-18}$-heterozyklische Gruppe oder eine aromatische $C_{5-18}$-Kohlenwasserstoffgruppe ist,
$L_a$ $C_{1-20}$-Alkylen ist, das mindestens eines von -O-,-S- oder -$NR^{1S}$- enthalten kann, wobei $R^{1S}$ H oder ein Substituent ist,
$L_b$ jeweils unabhängig $C_{1-100}$-Alkyl ist, das mindestens eines von -O-, -S- oder -$NR^{2S}$-enthalten kann, wobei $R^{2S}$ H oder ein Substituent ist,
*l* eine ganze Zahl von 1-5 ist und
* eine Bindungsstelle zu einer anderen Struktur ist,
$R^{A2}$ jeweils unabhängig eine Bindungsstelle an eine Alkylgruppe ist, die mindestens eines von H, Halogen, -O-, -S- oder -$NR^{A3}$- enthalten kann, wobei $R^{A3}$ H oder ein Substituent ist, oder eine andere Struktur ist,
$R^{A3}$ jeweils unabhängig H oder ein Substituent ist und
* jeweils unabhängig eine Bindungsstelle zu einer anderen Struktur ist.

**5.** Verfahren gemäß einem der Ansprüche 1-4, worin D in Formel (1) eine Struktur der Formel (D-1) ist,

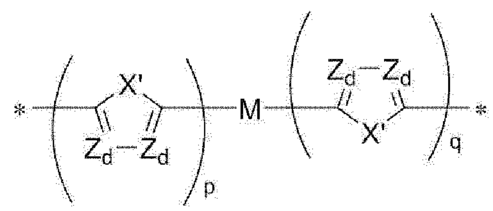

(D-1)

worin

X' jeweils unabhängig O, S, Se oder $NR^{D1}$ ist, worin $R^{D1}$ jeweils unabhängig eine einwertige organische Gruppe ist, die eine wie in Anspruch 4 definierte einwertige Gruppe der Formel (1-1) sein kann,
$Z_d$ jeweils unabhängig N oder $CR^{D2}$ ist, worin $R^{D2}$ jeweils unabhängig H oder eine einwertige organische Gruppe ist, die eine wie in Anspruch 4 definierte einwertige Gruppe der Formel (1-1) sein kann,
M eine Einfachbindung, eine zweiwertige aromatische hetereozyklische Gruppe, eine zweiwertige aromatische Kohlenwasserstoffgruppe, Alkenylen, Alkinylen oder eine zweiwertige Gruppe ist, die durch Kombinieren dieser erhalten ist, M mit Alkyl, das mindestens eines von -O-, -S- oder -$NR^{D3}$-enthalten kann, wobei $R^{D3}$ jeweils unabhängig H oder ein Substituent ist, oder einer wie in Anspruch 4 definierten einwertigen Gruppe der Formel (1-1) substituiert sein kann,
p, q jeweils unabhängig eine ganze Zahl von 0-4 sind und

* jeweils unabhängig eine Bindungsstelle zu einer anderen Struktur sind.

**6.** Verfahren gemäß einem der Ansprüche 1-5, worin die Wiederholungseinheit der Formel (1) eine Wiederholungseinheit einer der Formeln (2)-(5) ist:

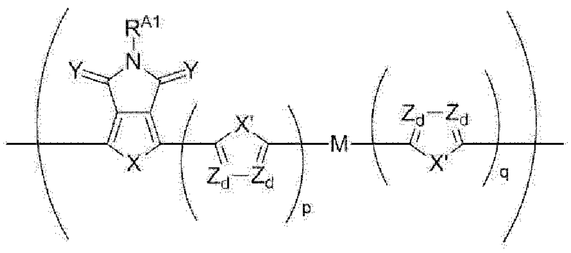

(2)

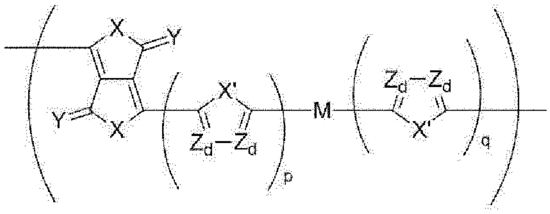

(3)

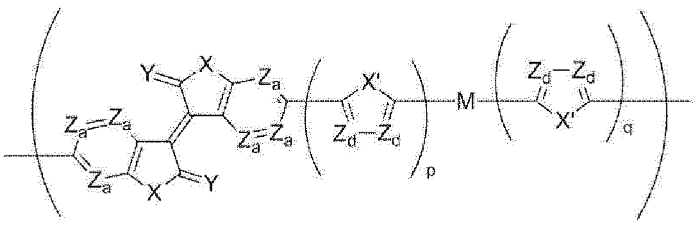

(4)

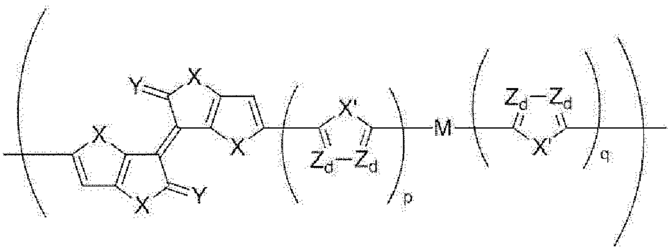

(5)

worin

X jeweils unabhängig O, S, Se oder $NR^{A1}$ ist, worin $R^{A1}$ jeweils unabhängig eine Bindungsstelle zu einer Alkylgruppe, die mindestens eines von -O-, -S- oder $-NR^{A3}-$ enthalten kann, eine einwertige Gruppe der Formel (1-1) oder eine andere Struktur ist,
Y jeweils unabhängig O oder S ist,
$Z_a$ jeweils unabhängig N oder $CR^{A2}$ ist, worin $R^{A2}$ jeweils unabhängig eine Bindungsstelle zu einer Alkylgruppe, die mindestens eines von H, Halogen, -O-, -S- oder $-NR^{A3}-$ enthalten kann, oder eine andere Struktur ist,
$R^{A3}$ jeweils unabhängig H oder ein Substituent ist,
X' jeweils unabhängig O, S, Se oder $NR^{D1}$ ist, worin $R^{D1}$ jeweils unabhängig eine einwertige organische Gruppe ist, die eine einwertige Gruppe der Formel $*-L_a-Ar-(L_b)_l$ (1-1) sein kann, worin
Ar eine aromatische $C_{5-18}$-heterozyklische Gruppe oder eine aromatische $C_{5-18}$-Kohlenwasserstoffgruppe ist,
$L_a$ $C_{1-20}$-Alkylen ist, das mindestens eines von -O-, -S- oder $-NR^{1S}-$ enthalten kann, wobei $R^{1S}$ H oder ein Substituent ist,
$L_b$ jeweils unabhängig $C_{1-100}$-Alkyl ist, das mindestens eines von -O-, -S- oder $-NR^{2S}-$enthalten kann, wobei $R^{2S}$ H oder ein Substituent ist,
*l* eine ganze Zahl von 1-5 ist und
* eine Bindungsstelle zu einer anderen Struktur ist,

$Z_d$ jeweils unabhängig N oder $CR^{D2}$ ist, worin $R^{D2}$ jeweils unabhängig H oder eine einwertige organische Gruppe ist, die eine einwertige Gruppe der wie oben definierten Formel (1-1) sein kann,
M eine Einfachbindung, eine zweiwertige aromatische heterozyklische Gruppe, eine zweiwertige aromatische Kohlenwasserstoffgrupe, Alkenylen, Alkinylen oder eine zweiwertige Gruppe ist, die durch Kombinieren dieser erhalten ist, M mit Alkyl, das mindestens eines von -O-, -S- oder -$NR^{D3}$-enthalten kann, wobei $R^{D3}$ jeweils unabhängig H oder ein Substituent, oder einer wie oben definierte einwertige Gruppe der Formel (1-1) substituiert sein kann und
p, q jeweils unabhängig eine ganze Zahl von 0-4 sind.

**7.** Verfahren gemäß einem der Ansprüche 1-6, worin der organische Dünnschichttransistor eine Boden-Gate-Struktur aufweist.

**8.** Verfahren gemäß Anspruch 7, worin der organische Dünnschichttransistor eine Boden-Kontakt-Struktur aufweist.

**9.** Verfahren gemäß einem der Ansprüche 1-8, worin die gemischte Lösung auf die Gate-Isolierschicht, die eine Oberflächenenergie von 50-75 $mNm^{-1}$ aufweist, aufgetragen wird.

**10.** Organische Halbleiterzusammensetzung, umfassend:

- eine organische Halbleiterverbindung, die ein Molekulargewicht von ≥ 2.000 aufweist und eine Wiederholungseinheit der Formel -(D-A)- (1) aufweist, worin

  A eine Elektronenakzeptoreinheit ist, die eine Teilstruktur mit mindestens einem von einem sp2-Stickstoffatom, einer Carbonylgruppe oder einer Thiocarbonylgruppe in einer Ringstruktur enthält, und
  D eine Elektronendonoreinheit ist, die eine zweiwertige aromatische heterozyklische Gruppe mit mindestens einem von einem N-Atom, einem O-Atom, einem S-Atom oder einem Se-Atom in einer Ringstruktur oder eine zweiwertige aromatische Kohlenwasserstoffgruppe, die aus einer kondensierten Ringstruktur mit zwei oder mehr Ringen besteht, als Teilstruktur enthält, und

- ein Harz (C), das mindestens eine Wiederholungseinheit einer der Formeln (C-Ia) bis (C-Id) aufweist:

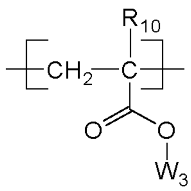
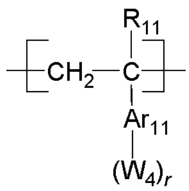
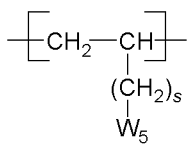
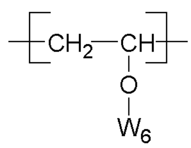

(C-Ia) (C-Ib) (C-Ic) (C-Id)

worin

$R_{10}$, $R_{11}$ jeweils H, F oder Alkyl sind,
$W_3$ eine organische Gruppe mit einem oder mehreren, ausgewählt aus F, einer Si-haltigen Gruppe, $C_{\geq 2}$-Alkyl, Cycloalkyl, Aryl und Aralkyl, ist,
$W_4$ eine organische Gruppe mit einem oder mehreren, ausgewählt aus F, einer F-haltigen Gruppe, einer Si-haltigen Gruppe, Alkyl und Cycloalkyl, ist,
$W_5$, $W_6$ jeweils eine organische Gruppe mit einem oder mehreren, ausgewählt aus einer F-haltigen Gruppe, einer Si-haltigen Gruppe, Alkyl, Cycloalkyl, Aryl und Aralkyl, sind,
$Ar_{11}$ eine (r+1)-wertige aromatische Ringgruppe ist,
r eine ganze Zahl von 1-10 ist und
s 0 oder 1 ist.

**11.** Organische Halbleiterzusammensetzung gemäß Anspruch 10, die eine Schicht ist.

**12.** Verfahren zur Herstellung der organischen Halbleiterschicht gemäß Anspruch 11, umfassend einen Schritt des Auftragens eines Gemischs, das die organische Halbleiterverbindung und das Harz (C) enthält, auf eine Gate-Isolierschicht, die eine Oberflächenenergie von 50-75 $mNm^{-1}$ aufweist, so dass die organische Halbleiterschicht

erhalten wird.

**Revendications**

1. Procédé de fabrication d'un transistor à film mince organique comprenant, sur un substrat :

1) une électrode (5) de grille ;
2) une couche (1) de semi-conducteur organique contenant un composé semi-conducteur organique qui présente un poids moléculaire de > 2 000 et présente une unité de répétition de la formule -(D-A)- (1), dans lequel

A est une unité d'accepteur d'électrons incluant une structure partielle comportant au moins un parmi un atome d'azote sp2, un groupe carbonyle ou un groupe thiocarbonyle selon une structure cyclique, et
D est une unité de donneur d'électrons incluant un groupe hétérocyclique aromatique divalent comportant au moins l'un parmi un atome N, un atome O, un atome S ou un atome Se selon une structure cyclique ou un groupe hydrocarbure aromatique divalent consistant en une structure cyclique fusionnée comportant deux cycles ou plus, en tant que structure partielle,

3) une couche (2) d'isolation de grille disposée entre l'électrode de grille et la couche de semi-conducteur organique ; et
4) une électrode (3) de source et une électrode (4) de drain qui sont disposées pour être en contact avec la couche de semi-conducteur organique et sont liées entre elles par le biais de la couche de semi-conducteur organique, dans lequel la couche de semi-conducteur organique est en contact avec une couche contenant une résine (C) ou contient en outre la résine (C), la résine (C) possède au moins une unité de répétition de l'une quelconque des formules (C-Ia) à (C-Id) :

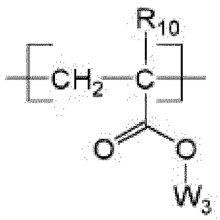
(C-Ia)

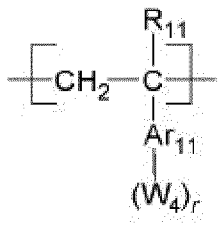
(C-Ib)

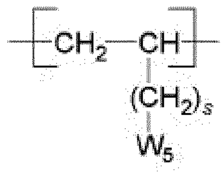
(C-Ic)

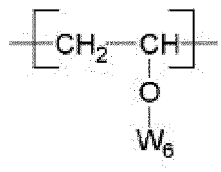
(C-Id)

dans lequel

$R_{10}$, $R_{11}$ sont chacun H, F ou un alkyle,
$W_3$ est un groupe organique comportant un ou plusieurs éléments sélectionnés parmi F, un groupe contenant du Si, un alkyle en $C_{\geq 2}$, un cycloalkyle, un aryle et un aralkyle,
$W_4$ est un groupe organique comportant un ou plusieurs éléments sélectionnés parmi F, un groupe contenant du F, un groupe contenant du Si, un alkyle et un cycloalkyle,
$W_5$, $W_6$ sont chacun un groupe organique comportant un ou plusieurs éléments sélectionnés parmi un groupe contenant du F, un groupe contenant du Si, un alkyle, un cycloalkyle, un aryle et un aralkyle,
$Ar_{11}$ est un groupe cyclique aromatique (r+1)-valent,
r est un entier de 1 à 10, et
s vaut 0 ou 1 ; **caractérisé en ce que** le procédé comprend une étape d'application d'une solution mélangée contenant le composé semi-conducteur organique et la résine (C).

2. Procédé selon la revendication 1, dans lequel l'énergie de surface de la résine (C) est ≤ 30 $mNm^{-1}$.

3. Procédé selon la revendication 1 ou la revendication 2, dans lequel la résine (C) comporte au moins l'un parmi un groupe contenant du F et un groupe contenant du Si.

4. Procédé selon l'une quelconque des revendications 1 à 3, dans lequel A dans la Formule (1) présente au moins une structure de l'une quelconque des formules (A-1) à (A-12) en tant que structure partielle :

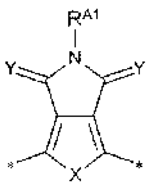
(A-1)

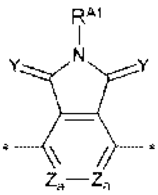
(A-2)

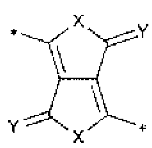
(A-3)

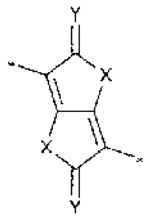
(A-4)

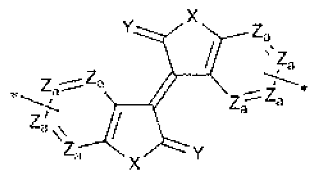
(A-5)

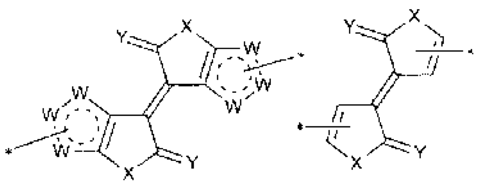
(A-6) (A-7)

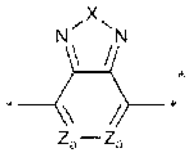
(A-8)

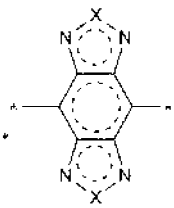
(A-9)

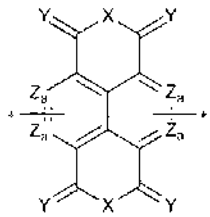
(A-10)

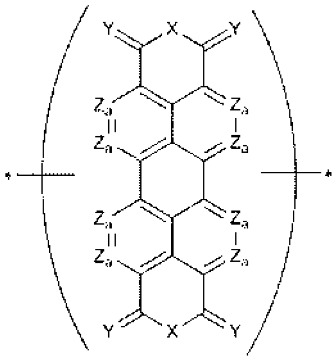
(A-11)

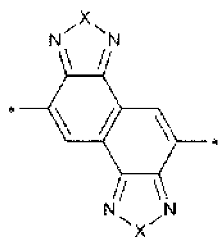
(A-12)

dans lequel

X est chacun indépendamment O, S, Se ou $NR^{A1}$,
Y est chacun indépendamment O ou S,
$Z_a$ est chacun indépendamment $CR^{A2}$ ou N,
W est chacun indépendamment $C(R^{A2})_2$, $NR^{A1}$, N, $CR^{A2}$, O, S, ou Se,
$R^{A1}$ est chacun indépendamment un site de liaison à un groupe alkyle qui peut inclure au moins un élément parmi -O-, -S-, ou $-NR^{A3}-$,
$R^{A3}$ est H ou un substituant, un groupe monovalent de la formule $*-L_a-Ar-(L_b)_l$ (1-1), ou une autre structure, dans lequel dans la formule (1-1)
Ar est un groupe hétérocyclique en $C_{5-18}$ aromatique ou un groupe hydrocarbure en $C_{5-18}$ aromatique,
$L_a$ est de l'alkylène en $C_{1-20}$ qui peut inclure au moins un élément parmi -O-, -S-, ou $-NR^{1S}-$, $R^{1S}$ est H ou un substituant,
$L_b$ est chacun indépendamment un alkyle en $C_{1-100}$ qui peut inclure au moins un élément parmi -O-, -S-, ou $-NR^{2S}-$, $R^{2S}$ est H ou un substituant,
l est un entier de 1 à 5, et
* est un site de liaison à une autre structure,
$R^{A2}$ est chacun indépendamment un site de liaison à un groupe alkyle qui peut inclure au moins un élément parmi H, un halogène, -O-, -S-, ou $-NR^{A3}-$, $R^{A3}$ est H ou un substituant, ou une autre structure,
$R^{A3}$ est chacun indépendamment H ou un substituant, et
* est chacun indépendamment un site de liaison à une autre structure,

**5.** Procédé selon l'une quelconque des revendications 1 à 4, dans lequel D dans la Formule (1) est une structure de la formule (D-1),

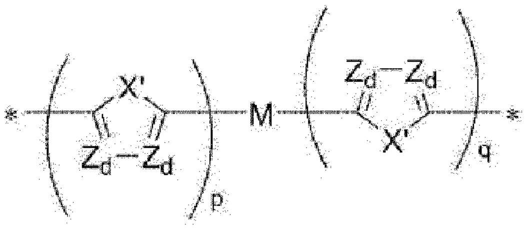

(D-1)

dans lequel

X' est chacun indépendamment O, S, Se ou $NR^{D1}$, dans lequel $R^{D1}$ est chacun indépendamment un groupe organique monovalent qui peut être un groupe monovalent de formule (1-1) tel que défini dans la revendication 4,
$Z_d$ est chacun indépendamment N ou $CR^{D2}$, dans lequel $R^{D2}$ est chacun indépendamment H ou un groupe organique monovalent qui peut être un groupe monovalent de formule (1-1) tel que défini dans la revendication 4,
M est une liaison simple, un groupe hétérocyclique aromatique divalent, un groupe hydrocarbure aromatique divalent, de l'alkénylène, de l'alkynylène, ou un groupe divalent obtenu en combinant ceux-ci, M peut être remplacé par un alkyle qui peut inclure au moins un élément parmi -O-, -S-, ou $-NR^{D3}-$, $R^{D3}$ est chacun indépendamment H ou un substituant, ou un groupe monovalent de formule (1-1) tel que défini dans la revendication 4,
p, q sont chacun indépendamment un entier de 0 à 4, et
* sont chacun indépendamment un site de liaison à une autre structure.

6. Procédé selon l'une quelconque des revendications 1 à 5, dans lequel l'unité de répétition de formule (1) est une unité de répétition selon l'une quelconque des formules (2)-(5) :

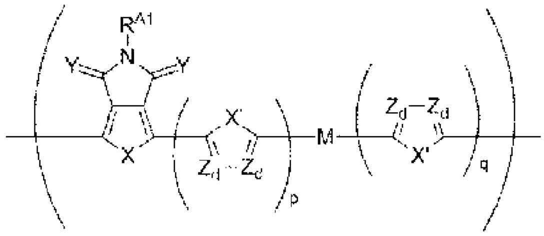

(2)

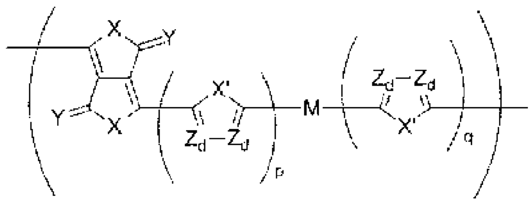

(3)

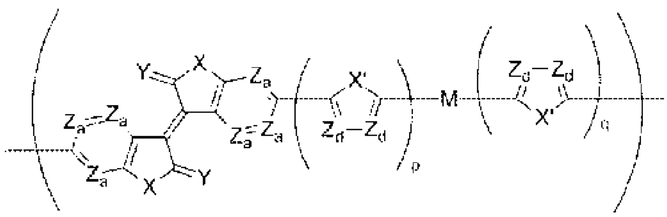

(4)

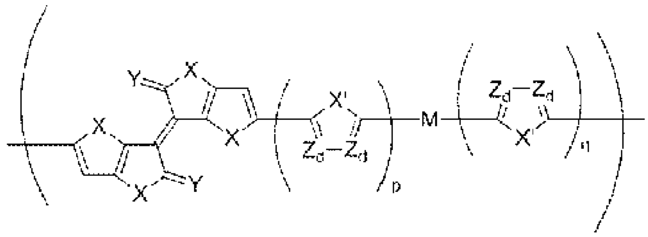
(5)

dans lequel

X est chacun indépendamment O, S, Se ou $NR^{A1}$, dans lequel $R^{A1}$ est chacun indépendamment un site de liaison à un groupe alkyle qui peut inclure au moins un élément parmi -O-, -S-, ou $-NR^{A3}-$, un groupe monovalent de formule (1-1), ou une autre structure,
Y est chacun indépendamment O ou S,
$Z_a$ est chacun indépendamment N ou $CR^{A2}$, dans lequel $R^{A2}$ est chacun indépendamment un site de liaison à un groupe alkyle qui peut inclure au moins un élément parmi H, un halogène, -O-, -S-, ou $-NR^{A3}-$, ou une autre structure,
$R^{A3}$ est chacun indépendamment H ou un substituant,
X' est chacun indépendamment O, S, Se ou $NR^{D1}$, dans lequel $R^{D1}$ est chacun indépendamment un groupe organique monovalent qui peut être un groupe monovalent de la $*-L_a-Ar-(L_b)_l$ (1-1), dans lequel
Ar est un groupe hétérocyclique en $C_{5-18}$ aromatique ou un groupe hydrocarbure en $C_{5-18}$ aromatique,
$L_a$ est de l'alkylène en $C_{1-20}$ qui peut inclure au moins un élément parmi -O-, -S-, ou $-NR^{1S}-$, $R^{1S}$ est H ou un substituant,
$L_b$ est chacun indépendamment un alkyle en $C_{1-100}$ qui peut inclure au moins un élément parmi -O-, -S-, ou $-NR^{2S}-$, $R^{2S}$ est H ou un substituant,
l est un entier de 1 à 5, et
* est un site de liaison à une autre structure,
$Z_d$ sont chacun indépendamment N ou $CR^{D2}$, dans lequel $R^{D2}$ est chacun indépendamment H ou un groupe organique monovalent qui peut être un groupe monovalent de formule (1-1) tel que défini ci-dessus,
M est une liaison simple, un groupe hétérocyclique aromatique divalent, un groupe hydrocarbure aromatique divalent, de l'alkénylène, de l'alkynylène, ou un groupe divalent obtenu en combinant ceux-ci, M peut être remplacé par un alkyle qui peut inclure au moins un élément parmi -O-, -S-, ou $-NR^{D3}-$, $R^{D3}$ est chacun indépendamment H ou un substituant, ou un groupe monovalent de formule (1-1) tel que défini ci-dessus, et
p, q sont chacun indépendamment un entier de 0 à 4.

7. Procédé selon l'une quelconque des revendications 1 à 6, dans lequel le transistor à film mince organique possède une structure de grille de fond.

8. Procédé selon la revendication 7, dans lequel le transistor à film mince organique possède une structure de contact de fond.

9. Procédé selon l'une quelconque des revendications 1 à 8, dans lequel la solution mélangée est appliquée à la couche d'isolation de grille présenta tune énergie de surface de 50 à 75 $mNm^{-1}$.

10. Composition de semi-conducteur organique, comprenant :

- un composé semi-conducteur organique qui présente un poids moléculaire de > 2 000 et présente une unité de répétition de la formule -(D-A)- (1), dans lequel

  A est une unité d'accepteur d'électrons incluant une structure partielle comportant au moins un parmi un atome d'azote sp2, un groupe carbonyle ou un groupe thiocarbonyle selon une structure cyclique, et
  D est une unité de donneur d'électrons incluant un groupe hétérocyclique aromatique divalent comportant au moins un parmi un atome N, un atome O, un atome S et un atome Se selon une structure cyclique ou un groupe hydrocarbure aromatique divalent consistant en une structure cyclique fusionnée comportant deux cycles ou plus, en tant que structure partielle ; et

- une résine (C) possédant au moins une unité de répétition de l'une quelconque des formules (C-Ia) à (C-Id) :

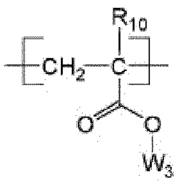 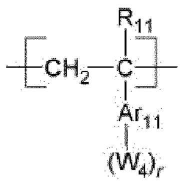 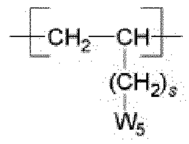 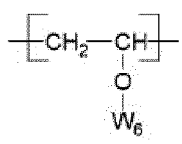

(C-Ia) (C-Ib) (C-Ic) (C-Id)

dans lequel

$R_{10}$, $R_{11}$ sont chacun H, F ou un alkyle,
$W_3$ est un groupe organique comportant un ou plusieurs éléments sélectionnés parmi F, un groupe contenant du Si, un alkyle en $C_{\geq 2}$, un cycloalkyle, un aryle et un aralkyle,
$W_4$ est un groupe organique comportant un ou plusieurs éléments sélectionnés parmi F, un groupe contenant du F, un groupe contenant du Si, un alkyle et un cycloalkyle,
Ws, $W_6$ sont chacun un groupe organique comportant un ou plusieurs éléments sélectionnés parmi un groupe contenant du F, un groupe contenant du Si, un alkyle, un cycloalkyle, un aryle et un aralkyle,
$Ar_{11}$ est un groupe cyclique aromatique (r+1)-valent,
r est un entier de 1 à 10, et
s vaut 0 ou 1.

**11.** Composition de semi-conducteur organique selon la revendication 10, qui est un film.

**12.** Procédé de fabrication du film à semi-conducteur organique selon la revendication 11, comprenant une étape d'application d'un mélange contenant le composé semi-conducteur organique et la résine (C) sur une couche d'isolation de grille présentant une énergie de surface de 50 à 75 $mNm^{-1}$, de manière à obtenir le film à semi-conducteur organique.

FIG. 1A

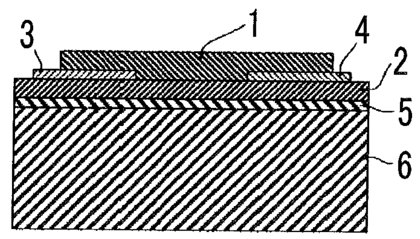


FIG. 1B

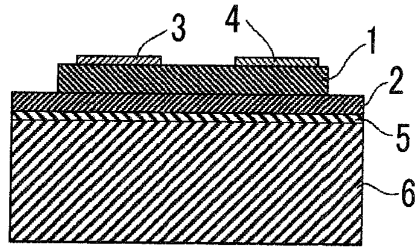


FIG. 1C

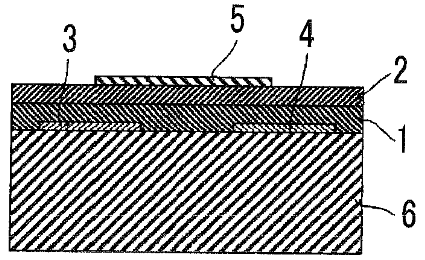


FIG. 1D

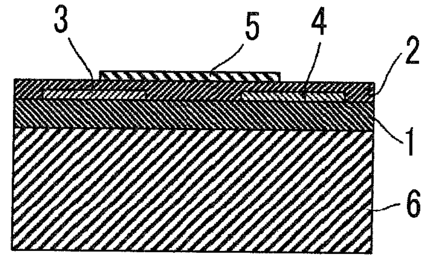

FIG. 2E

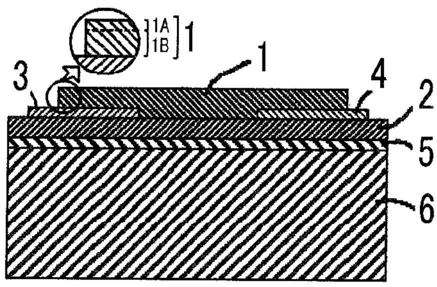


FIG. 2F

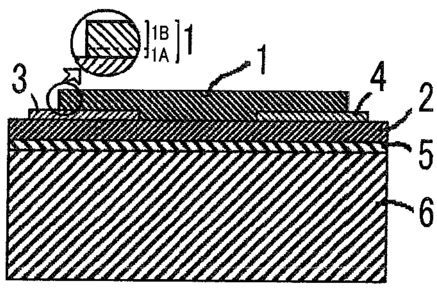

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2014237733 A
- JP 2012164806 B
- JP 2012208447 A
- JP 2013214649 A
- JP 2011186069 A
- JP 2010285518 A
- JP 2012163946 A
- JP 2005354012 A
- JP 2006303465 A
- JP 2010527327 A
- JP 2007516315 A
- JP 2014515043 A
- JP 2014507488 A
- JP 2011501451 A
- JP 2010018790 A
- WO 2012174561 A
- JP 2011514399 A
- JP 2011514913 A


### Non-patent literature cited in the description


- **BEN B.Y. HSU et al.** *Adv. Mater.,* 2010, vol. 22, 4649
- *Langmuir,* 2003, vol. 19, 1159
- *J. Phys.Chem. B,* 2006, vol. 110, 21101
- *Intermediate X which is a monomer was synthesized with reference to Tetrahedron,* 2010, vol. 66, 3173
- *Organic Electronics,* 2011, vol. 12, 993